(19) Europäisches Patentamt
European Patent Office
Office européen des brevets

(11) EP 1 701 213 A2

(12) EUROPEAN PATENT APPLICATION

(43) Date of publication:
13.09.2006 Bulletin 2006/37

(51) Int Cl.:
*G03F 7/031* (2006.01) *G03F 7/029* (2006.01)
*B41C 1/10* (2006.01)

(21) Application number: 06004463.3

(22) Date of filing: 06.03.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 08.03.2005 JP 2005063582
18.03.2005 JP 2005079941

(71) Applicant: FUJI PHOTO FILM CO., LTD.
Minami-Ashigara-shi, Kanagawa (JP)

(72) Inventors:
- Shibuya, Akinori
c/oFUJI PHOTO FILM CO., LTD.
Haibara-gun
Shizuoka (JP)
- Ishiji, Yohei
c/oFUJI PHOTO FILM CO., LTD.
Haibara-gun
Shizuoka (JP)

(74) Representative: HOFFMANN EITLE
Patent- und Rechtsanwälte
Arabellastrasse 4
81925 München (DE)

# (54) Photosensitive composition

(57) A photosensitive composition comprising (A) a sensitizing dye having a specific structure, (B) a initiating compound capable of generating a radical, an acid or a base, and (C) a polymerizable compound capable of reaction by at least one of a radical, an acid and a base.

EP 1 701 213 A2

## Description

## Background of the Invention

1. Field of the Invention

The present invention relates to a photosensitive composition containing a novel photoinitiation system, in particular a photoinitiation system that is high sensitive and excellent in stability. The invention also relates to a photosensitive composition applicable to three-dimensional optical fabrication, holography, lithographic printing plate materials, image forming materials, e.g., color proofs, photoresists and color filters, and photo-curable resin materials, e.g., inks, coatings and adhesives. In particular, the present invention relates to a photosensitive composition suitably used as a so-called direct plate-making lithographic printing plate precursor capable of directly making a printing plate from digital signals of computers and the like with various kinds of lasers.

2. Description of the Related Art

As lithographic printing plate precursors, PS plates comprising a hydrophilic support having provided thereon a lipophilic photosensitive resin layer have so far been widely used. As the plate-making methods, methods of obtaining desired printing plates by mask exposure (areal exposure) via a lith film and then dissolving and removing the non-image area are generally used.

Digitized techniques of electronically processing, accumulating and outputting image data using a computer have prevailed in recent years, and various image output systems corresponding to these digitized techniques have been put to practical use. As a result, a computer-to-plate (CTP) technique of directly making a printing plate by scanning digitized image data with high convergent light such as a laser beam without using a lith film is eagerly desired. With such a tendency, it has become an important technical subject to obtain a printing plate precursor well adapted to this purpose.

As one method of obtaining such a lithographic printing plate precursor capable of scanning exposure, a method of forming an ink receptive resin layer area on a support having a hydrophilic surface is adopted. This is a material comprising a support having provided thereon a negative photosensitive layer capable of forming an ink receptive area by curing upon scanning exposure, and constitutions using a photopolymerizable composition excellent in photosensitive speed are proposed, and some of such materials have been put to practical use. A lithographic printing plate precursor having such constitution is easy in development process and, further, has desired properties as a printing plate and printing properties, e.g., excellent in resolution, adhesion of ink, press life, and soiling resistance.

However, since a visible light source of relatively long wavelength, e.g., an Ar laser (488 nm) and an FD-YAG laser (532 nm), is used as a light source in conventional CTP systems, it has been a problem to use a photosensitive material that is high sensitive around 500 nm. That is, as a result, all the works such as taking out a printing plate from a corrugated board package, mounting a plate setter on a cassette, and inserting the plate to the plate setter must be performed under a dark red safelight, so that workability is conspicuously inferior. Accordingly, it has been strongly desired to construct a CTP system capable of handling under a bright yellow or white safelight. In addition, the structures of a gas laser such as an Ar ion laser and a solid state laser such as an FD-YAG laser themselves are complicated and expensive, so that the CTP system using these light sources are not economically preferred in the points of the price of exposure apparatus (plate setter) and the expense of laser exchange.

On the other hand, the advancement of laser technology in recent years is remarkable, for example, semiconductor lasers capable of continuous oscillation in the region of from 350 to 450 nm with InGaN materials have been put to practical use. If a CTP system using these short wave light sources can be constructed, it becomes possible to use photosensitive materials having a shorter wave photosensitive region capable of handling under a brighter safelight. Semiconductor lasers can be manufactured inexpensively from their structural point of view, so that they are very preferred as the light sources for CTP system.

From these facts, it has been urgently desired in the field of the industry to obtain a lithographic printing plate precursor suitable for a CTP system using semiconductor lasers of relatively short wavelengths of from 350 to 450 nm.

A photopolymerizable composition used in a lithographic printing plate precursor fundamentally comprises an ethylenic unsaturated compound, a photopolymerization initiation system and a binder resin. An image is formed in a manner that a photo- initiation system absorbs light to thereby generate active radicals, which causes the addition polymerization of an ethylenic unsaturated compound, whereby a photosensitive layer is insolubilized.

Almost all the conventional proposals as to lithographic printing plate capable of scanning exposure using these photopolymerizable photosensitive layers are those which describe the use of specific photoinitiation systems excellent in photosensitivity, and many of these high sensitivity initiation systems are described, e.g., in Bruce M. Monroe et al., Chemical Revue, Vol. 93, p. 435 (1993), and R.S. Davidson, Journal of Photochemistry and Biology A: Chemistry,

Vol. 73, p. 81 (1993).

As relatively high sensitivity initiation systems, initiation systems comprising a specific dye in combination with a titanocene compound are known. A combination of a styryl dye with a titanocene compound is disclosed in JP- A-9-80750 (the term "JP-A" as used herein refers to an "unexamined published Japanese patent application"), and a combination of a dye having a 5-membered heterocyclic acid nucleus with a titanocene compound is disclosed in JP-A-10-101719. These initiation systems are certainly high sensitivity but not sufficient, and practicably sufficient sensitivity cannot be obtained when laser beams having wavelengths of 450 nm or less are used, so that these initiation systems are not suitable for short wave light sources. Further, suggestions concerning safelight aptitude are not disclosed at all in these patents.

Further, as described, for example, in J.P. Faussier, Photoinitiated Polymerization - Theory and Applications, Rapra Review, Vol. 9, Report, Rapra Technology (1998) and M. Tsunooka et al., Prog. Polym. Sci., 21, 1 (1996), the technology of obtaining photoinitiation systems high in sensitivity is still demanded widely in the field of imaging. Photoinitiation systems comprising a sensitizing dye and an initiating compound can generate an acid and a base other than an active radical according to the selection of initiating compounds, and they can be utilized, for example, for image formation, e.g., optical fabrication, holography and color hard copying, the manufacturing field of electronic materials, e.g., photo- resists, and photo-curable resin materials, e.g., inks, coatings and adhesives. In these industrial fields, it is eagerly desired to find out sensitizing dyes excellent in light absorption properties and sensitizing performances for the purpose of efficiently causing the decomposition of initiating compounds.

Under these circumstances, the present inventors have proposed photosensitive compositions containing high sensitivity sensitizing dyes in a short wavelength region (JP-A-2000-258910 and JP-A-2002-202598), however, higher sensitization of photoinitiation systems including the sensitizing dyes is desired.

Further, as a common problem to all the image-forming materials containing these photosensitive compositions, there is a problem of how to expand ON-OFF of an image in the irradiated area and the non-irradiated area with a laser, that is, a problem of the compatibility of high sensitivity and preservation stability of image-forming materials. In general, a photo-radical polymerization system is high sensitivity but the sensitivity greatly reduces by the polymerization hindrance due to oxygen in the air. Therefore, a means of providing a layer for shielding oxygen on an image-forming layer is taken. However, when an oxygen- shielding layer is provided, fogging occurs conversely due to dark polymerization and the like and preservation stability is deteriorated. Further, a case where the photoinitiating compound in a photosensitive layer is decomposed and diminished under the preservation conditions also decreases the generating amount of active radicals by light irradiation, which is one factor of the deterioration of preservation stability. Accordingly, the compatibility of high sensitivity and preservation stability is a difficult problem and a sufficiently satisfactory result cannot be obtained with the conventional art, so that a novel technique is demanded.

**Summary of the Invention**

Taking these problems into consideration, an object of the invention is to provide a photosensitive composition using a novel photoinitiator that is high sensitive to oscillating wavelengths of from 350 to 450 nm of an inexpensive short wave semiconductor laser, excellent in workability, economics, press life, soiling resistance and preservation stability, and useful as a photosensitive layer of a lithographic printing plate precursor for scanning exposure suitable, e.g., to a CTP system.

As a result of eager investigation to achieve the above object, the present inventors have found that a novel photo- initiator comprising a combination of a sensitizing dye having a specific structure and an appropriate initiating compound exhibits high sensitivity, in particular exhibits high sensitivity in the vicinity of from 350 to 450 nm, and excellent in work environment (yellow safelight aptitude), thus the present invention has been achieved.

That is, the present invention is as follows.

(1) A photosensitive composition comprising:

(A) a sensitizing dye;
(B) an initiating compound capable of generating a radical, an acid or a base; and
(C) a polymerizable compound capable of reaction by at least one of a radical, an acid and a base,

wherein the sensitizing dye is a compound selected from a compound having a partial structure represented by formula (1) and a compound represented by formula (I):

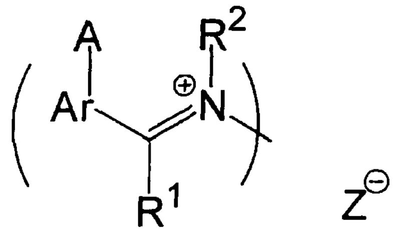

(1)

wherein Ar represents an aromatic ring;
A represents $NR^3R^4$, $-SR^5$ or $-OR^6$;
$R^1$, $R^2$ and $R^3$ to $R^6$ each independently represents a hydrogen atom or a monovalent nonmetallic atomic group; and
$Z^-$ represents a counter ion necessary for neutralizing electric charge;

Formula (I)

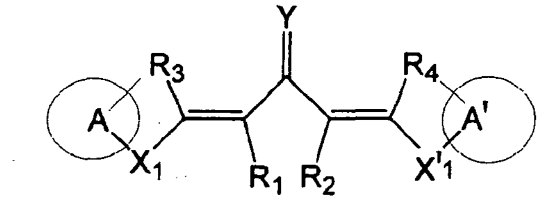

wherein $X_1$ and $X_1$' each independently represents an oxygen atom, a sulfur atom, $-CR_5R_6$ or $-NR_7-$, and at least one of $X_1$ and $X_1$' represents an oxygen atom, a sulfur atom or $-NR_7-$;
$R_1$, $R_2$, $R_3$, $R_4$, $R_5$, $R_6$ and $R_7$ each independently represents a hydrogen atom or a monovalent nonmetallic atomic group;
Y represents an oxygen atom, a sulfur atom or $NR_8$;
A and A' each independently represents an aromatic ring or a heterocyclic ring, which may have a substituent;
$R_3$ and $R_4$ each represents a nonmetallic atom or a nonmetallic atomic group that is bonded to any moiety of A and A' to form a cyclic structure; and
$R_1$ to $R_8$ may be bonded to each other to form an aliphatic or aromatic ring.

(2) The photosensitive composition as described in (1) above,

wherein the sensitizing dye is a compound having a partial structure represented by formula (1).

(3) The photosensitive composition as described in (1) above,

wherein the sensitizing dye is a compound represented by formula (I).

(4) The photosensitive composition as described in (1) or (2) above,

wherein the sensitizing dye is a compound represented by formula (2):

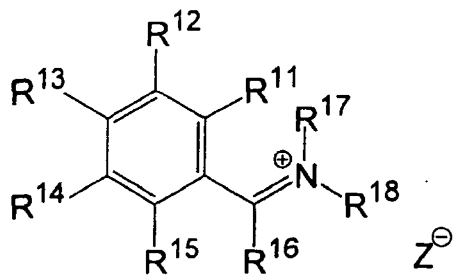 (2)

wherein $R^{11}$, $R^{12}$, $R^{13}$, $R^{14}$, $R^{15}$, $R^{16}$, $R^{17}$ and $R^{18}$ each independently represents a hydrogen atom or a monovalent nonmetallic atomic group, or may be bonded to each other to form a ring, provided that at least one of $R^{11}$, $R^{13}$ and $R^{15}$ represents $-NR^{19}R^{20}$, $-SR^{21}$ or $-OR^{22}$;
$R^{19}$, $R^{20}$, $R^{21}$ and $R^{22}$ each independently represents a hydrogen atom or a monovalent nonmetallic atomic group.

(5) The photosensitive composition as described in any of (1) to (4) above,

wherein the initiating compound capable of generating a radical, an acid or a base is a hexaarylbiimidazole compound.

(6) The photosensitive composition as described in any of (1) to (5) above,

wherein the polymerizable compound capable of reaction by at least one of a radical, an acid and a base is an addition polymerizable compound having an ethylenic unsaturated double bond.

(7) A lithographic printing plate precursor comprising a photosensitive layer that comprises a photosensitive composition as described in any of (1) to (6) above.

"Initiating compound capable of generating a radical, an acid or a base" in the invention means a compound capable of generating, by given energy, a radical, an acid or a base that is an initiating species to initiate and advance the polymerization reaction (crosslinking reaction) of the coexisting polymerizable compound.

Although the mechanism of the function of the invention is not clear, a sensitizing dye having a specific structure is high sensitivity to wavelengths of from 350 to 400 nm and becomes high sensitivity and electronic excitation state by the irradiation (exposure) with the oscillation wavelength of an inexpensive short wave semiconductor laser, as a result, the electron transfer, energy transfer and heat generation concerning the electronic excitation state by the light absorption act on the coexisting initiating compound to cause chemical change of the initiating compound to thereby generate a radical, an acid or a base. Further, any one of the generated radical, acid or base causes irreversible change, such as coloration, discoloration or polyerization, of the reacting polymerizable compound. By using an addition polymerizable compound having an ethylenic unsaturated double bond among such compounds, curing reaction is initiated and advanced to cure the exposed area. Therefore, it is advantageous to use the photosensitive composition of the invention having sufficient sensitivity in scanning exposure by a short wave semiconductor laser, excellent in stability under a yellow light, and capable of handling under bright safelight. Accordingly, it is thought that a lithographic printing plate precursor using a photo-sensitive layer containing an addition polymerizable compound is capable of recording at high sensitivity and shows printing performance excellent in safelight stability.

It has also been found that the photosensitive composition containing a sensitizing dye having a specific structure of the invention is excellent in preservation stability. The main factor is not clear, but it is thought that dye aggregation under natural aging conditions and the reduction of sensitizing efficiency by dark reaction with other component in the photosensitive layer are little due to relatively bulky substituent in the vicinity of the sensitizing dye structure, which fact influences the preservation stability of the photosensitive composition.

**Detailed Description of the Invention**

The present invention is described in detail below.

The photosensitive composition in the invention comprises (A) a sensitizing dye having a partial structure represented by formula (1) or a sensitizing dye represented by formula (I), (B) an initiating compound capable of generation of a radical, an acid or a base, and (C) a polymerizable compound capable of reaction by at least any of a radical, an acid and a base. The photoinitiation system of the photosensitive composition is composed of (A) a sensitizing dye

having a partial structure represented by formula (1) or a sensitizing dye represented by formula (I) and (B) an initiating compound capable of generating a radical, an acid or a base. In the system, the initiating compound causes chemical change by the actions of the electron transfer, energy transfer and heat generation by the electronic excitation state occurring by the light absorption of (A) a sensitizing dye having a partial structure represented by formula (1) or a sensitizing dye represented by formula (I), whereby a radical, an acid or a base is generated.

The photoinitiation systems are explained in the first place.

Sensitizing dye having a specific structure (A) useful in the photoinitiation system in the invention is characterized in that it has especially excellent absorption characteristics in the region of from 350 to 450 nm. Further, sensitizing dye having a specific structure (A) efficiently causes the decomposition of various kinds of initiating compounds (B) and shows very high sensitivity. In general, as the sensitizing mechanisms of photoinitiation systems comprising a sensitizing dye/an initiating compound, the processes of (a) the reduction decomposition of the initiating compound on the basis of the electron transfer reaction from the electronic excitation state of the sensitizing dye to the initiating compound, (b) the oxidation decomposition of the initiating compound on the basis of the electron transfer from the initiating compound to the electronic excitation state of the sensitizing dye, and (c) the decomposition from the electronic excitation state of the initiating compound on the basis of the energy transfer from the electronic excitation state of the sensitizing dye to the initiating compound are known. It was found that the sensitizing dye in the invention excellently and efficiently causes any of these sensitizing reactions.

The present inventors achieved the present invention by finding that the above characteristics are obtained by a sensitizing dye having a partial structure represented by formula (1) or a sensitizing dye represented by formula (I). Although the main factor of the sensitizing dye in the invention being high sensitivity is not clear, since the sensitizing dye shows emission spectrum of high intensity (fluorescence and/or phosphorescence), as one possibility, a sensitizing dye having a partial structure represented by formula (1) or a sensitizing dye represented by formula (I) of the invention has relatively long life of excitation state, which might efficiently function in the reaction with the initiating compound. In addition to the above fact, there is the possibility that a partial structure represented by formula (1) or a structure represented by formula (I) might efficiently contribute to the initial stage of sensitizing reaction (electron transfer and the like) and, further, succeeding reactions until the decomposition of the initiating compound.

The structural polar effect of a sensitizing dye relates to the crystal precipitation property after formation of composition, and it is thought that crystallization is restrained when a structure having smaller polarity is taken, so that the preservation stability increases.

(A) Sensitizing dye:

A sensitizing dye for use in the invention includes a sensitizing dye having a partial structure represented by formula (1) (hereinafter sometimes referred to as sensitizing dye (Al)) and a sensitizing dye represented by formula (I) (hereinafter sometimes referred to as sensitizing dye (A2)). In the first place, sensitizing dye (A1) is described in detail.

Sensitizing dye (A1) for use in the invention has at least one $-CR=N^{+}-$ on an aromatic ring, specifically very high sensitivity and excellent absorption characteristics can be obtained when a dye has a structure represented by formula (1). In particular, the effect is conspicuous when a substituent beginning with a nitrogen atom, a sulfur atom or an oxygen atom is substituted on at least one of the ortho position and para position of the aromatic ring.

Of these dyes, compounds having main absorption around 400 nm are insensitive to long wavelengths and can be handled under a relatively bright yellow lamp, so that especially preferred.

Sensitizing dye (A1) in the invention has a partial structure represented by formula (1), preferably a structure represented by formula (2), more preferably a structure represented by formula (3), and still more preferably a structure represented by formula (4). Of the structures represented by formula (4), the case where X represents $NR^9$ (where $R^9$ represents a monovalent nonmetallic atomic group) is especially preferred.

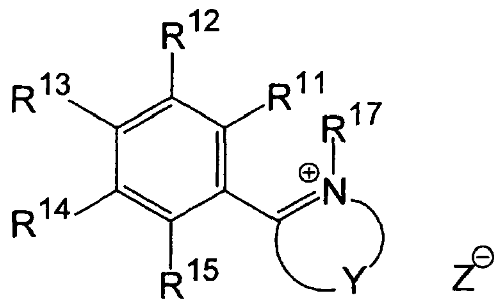

(3)

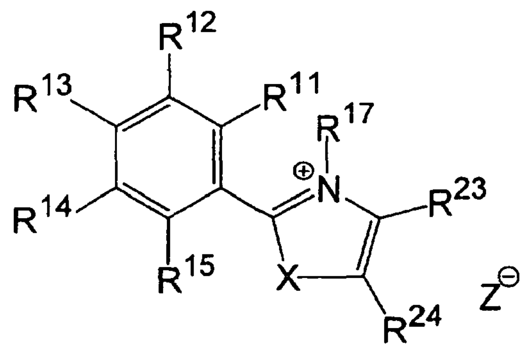

(4)

In formulae (3) and (4), $R^{11}$ to $R^{15}$, $R^{17}$ and Z- have the same meanings as described in formula (2). In formula (3), Y represents a nonmetallic atomic group to form a substituted or unsubstituted 5- or 6-membered ring together with $-C=N^+(R^{17})-$. In formula (4), X represents $NR^9$, O, S or Se. $R^{23}$ and $R^{24}$ have the same meanings as $R^{11}$ to $R^{18}$ described in formula (2).

Formulae (2) to (4) are explained in detail. $R^{11}$ to $R^{18}$ each independently represents a hydrogen atom or a monovalent nonmetallic atomic group. The preferred specific examples of the substituents represented by $R^{11}$ to $R^{18}$ include a hydrogen atom, an alkyl group, a halogen atom (-F, -Br, -Cl, -I), a hydroxyl group, an alkoxyl group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyl- oxy group, an N,N-diarylcarbamoyloxy group, an N-alkyl-N-arylcarbamoyloxy group, an alkylsulfoxy group, an arylsulfoxy group, an acylthio group, an acylamino group, an N-alkyl- acylamino group, an N-arylacylamino group, a ureido group, an N'-alkylureido group, an N',N'-dialkylureido group, an N'-arylureido group, an N',N'-diarylureido group, an N'-alkyl- N'-arylureido group, an N-alkylureido group, an N-arylureido group, an N'-alkyl-N-alkylureido group, an N'-alkyl-N-aryl- ureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'- aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N- aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-aryl- carbamoyl group, an alkylsulfinyl group, an arylsulfinyl group, an alkylsulfonyl group, an arylsulfonyl group, a sulfo group ($-SO_3H$) and a conjugate base group thereof (hereinafter referred to as a sulfonato group), an alkoxysulfonyl group, an aryloxysulfonyl group, a sulfinamoyl group, an N-alkyl-sulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and a conjugate base group thereof (hereinafter referred to as a phosphonato group), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and a conjugate base group thereof (hereinafter referred to as an alkylphosphonato group), a monoarylphosphono group ($-PO_3H(aryl)$) and a conjugate base group thereof (hereinafter referred to as an .arylphosphonato group), a phosphonooxy group ($-OPO_3H_2$) and a

conjugate base group thereof (hereinafter referred to as a phosphonatooxy group), a dialkylphosphonooxy group (-$OPO_3(alkyl)_2$), a diarylphosphono- oxy group (-$OPO_3(aryl)_2$), an alkylarylphosphonooxy group (-$OPO_3$(alkyl)(aryl)), a monoalkylphosphonooxy group (-$OPO_3$H(alkyl)) and a conjugate base group thereof (hereinafter referred to as an alkylphosphonatooxy group), a monoarylphosphonooxy group (-$OPO_3$H(aryl)) and a conjugate base group thereof (hereinafter referred to as an arylphosphonato- oxy group), a cyano group, a nitro group, an aryl group, a heteroaryl group, an alkenyl group, and an alkynyl group. These substituents may further be substituted.

The preferred examples of the alkyl groups in these substituents are straight chain, branched, or cyclic alkyl groups having from 1 to 20 carbon atoms, and as the specific examples, e.g., a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group can be exemplified. Of these groups, straight chain alkyl groups having from 1 to 12 carbon atoms, branched alkyl groups having from 3 to 12 carbon atoms, and cyclic alkyl groups having from 5 to 10 carbon atoms are more preferred.

As the alkylene group in the substituted alkyl groups, divalent organic residues obtained by removing any one hydrogen atom on the above alkyl groups having from 1 to 20 carbon atoms can be exemplified, preferably a straight chain alkylene group having from 1 to 12 carbon atoms, a branched alkylene group having from 3 to 12 carbon atoms, and a cyclic alkylene group having from 5 to 10 carbon atoms are exemplified. Although the substituents of the substituted alkyl groups are arbitrary, the preferred substituted alkyl groups include a chloromethyl group, a bromomethyl group, a 2-chloroethyl group, a trifluoro- methyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholino- propyl group, an acetyloxymethyl group, a benzoyloxymethyl group, an N-cyclohexylcarbamoyloxyethyl group, an N-phenyl- carbamoyloxyethyl group, an acetylaminoethyl group, an N-methylbenzoylaminopropyl group, a 2-oxoethyl group, a 2-oxopropyl group, a carboxypropyl group, a methoxycarbonyl- ethyl group, an allyloxycarbonylbutyl group, a chlorophenoxy- carbonylmethyl group, a carbamoylmethyl group, an N-methyl- carbamoylethyl group, an N,N-dipropylcarbamoylmethyl group, an N-(methoxyphenyl)carbamoylethyl group, an N-methyl-N- (sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphono- phenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, and a 3-butynyl group.

The specific examples of the aryl groups in these substituents are a condensed ring formed by 1 to 3 benzene rings and a condensed ring formed by a benzene ring and a 5-membered unsaturated ring are exemplified, and the specific examples include a phenyl group, a naphthyl group, an anthryl group, a phenanthryl group, an indenyl group, an acenaphthenyl group, and a fluorenyl group. Of these groups, a phenyl group and a naphthyl group are more preferred.

As the specific examples of the substituted aryl groups, those having a monovalent nonmetallic atomic group exclusive of a hydrogen atom on the ring-forming carbon atoms of the above aryl groups as the substituent are used. As the preferred examples of the substituted aryl groups, a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxy- phenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylamino- phenyl group, an N-methylbenzoylaminophenyl group, a carboxyphenyl group, a methoxycarbonylphenyl group, an allyloxy- carbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)- carbamoylphenyl group, an N-methyl-N-(sulfophenyl) carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propynylphenyl group, a 2-butynylphenyl group, and a 3-butynylphenyl group are exemplified.

As the heteroaryl groups, monocyclic or polycyclic aromatic rings containing at least one of nitrogen, oxygen

and sulfur atoms are used, preferably 5- or 6-membered aromatic substituents, e.g., furan, pyrrole and pyridine can be used. As the examples of the substituted heteroaryl groups, monovalent nonmetallic atomic groups can be used. As examples of heteroaryl groups, compounds having monovalent nonmetallic atomic groups excluding hydrogen as substituents on the ring forming atoms of the above mentioned heteroaryl groups are used. The particularly preferred examples of the heteroaryl groups include, e.g., thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthyridine, quinazoline, cinnoline, pteridine, carbazole, carboline, phenanthrine, acridine, perimidine, phenanthroline, phenarsazine, and furazane. These groups may further be benzo-condensed (for example, benzothiazole or benzoxazole) or may have a substituent.

As the examples of the alkenyl groups, a vinyl group, a 1-propenyl group, a 1-butenyl group, a cinnamyl group, and a 2-chloro-1-ethenyl group can be exemplified, and as the examples of the alkynyl groups, an ethynyl group, a 1-propynyl group, a 1-butynyl group and a trimethylsilylethynyl group can be exemplified.

As $G_1$ in the acyl group ($G_1CO$-), a hydrogen atom and the above alkyl groups and aryl groups can be exemplified.

Of these substituents, more preferred examples include a halogen atom (-F, -Br, -Cl, -I), an alkoxyl group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group, and an alkenyl group. In addition, $R^{11}$ to $R^{18}$ may be bonded to each other to form a ring.

These $R^{11}$ to $R^{18}$ described above are arbitrarily selected considering performances, e.g., sensitivity, photosensitive wavelength, stability, and from various viewpoints in practical use. For example, they are selected arbitrarily taking into consideration the points of the improvement of compatibility in a composition and the prevention of precipitation of crystals, the points of the solubility, dispersibility and precipitation with difficulty in a developing solution in performing development, and the economical points such as the prices of materials, simplicity of synthesis, and easiness of purification. From these aspects, as the especially preferred examples of $R^{11}$ to $R^{18}$, a hydrogen atom, a halogen atom (-F, -Br, -Cl, -I), a lower alkyl group having from 1 to 6 carbon atoms (a methyl group, an ethyl group, a propyl group, an isopropyl group, an allyl group, a 2-methylpropenyl group, etc.), and an alkylsubstituted aminoalkylene group (as the alkyl group, a straight chain or branched alkyl group having from 1 to 6 carbon atoms, and s cyclic alkyl group having from 5 to 7 carbon atoms are exemplified, and as the alkylene group, a mono-, di-, tri- methylene group having from 1 to 3 carbon atom is exemplified) can be exemplified.

In the next place, $-NR^{19}R^{20}$, $-SR^{21}$ and $-OR^{22}$ in formula (2) are explained. It is preferred that $-NR^{19}R^{20}$, $-SR^{21}$ and $-OR^{22}$ are positioned on any of $R^{11}$, $R^{13}$ and $R^{15}$ in formula (2), and they are directly bonded via an aromatic ring and a nitrogen, sulfur or oxygen atom. $R^{19}R^{20}$ bonded to a nitrogen atom, $R^{21}$ bonded to a sulfur atom and $R^{22}$ bonded to an oxygen atom represent a hydrogen atom or a monovalent nonmetallic atomic group, and as the specific examples thereof, the same groups as described in $R^{11}$ to $R^{18}$ in formula (2) are exemplified.

In formula (3), Y represents a nonmetallic atomic group to form a substituted or unsubstituted 5- or 6-membered ring together with $-C=N^+(R^{17})$-. Specifically, the structures containing nitrogen atom described in the substituted heteroaryl group in formula (2) are exemplified.

In formula (4), X represents $NR^9$, O, S or Se. $R^{23}$ and $R^{24}$ have the same meanings as $R^{11}$ to $R^{18}$ described in formula (2).

$Z^-$ represents a counter ion necessary for the neutralization of electric charge, provided that when the cationic moiety of the dye has an anionic substituent, $Z^-$ is not always necessary. Specifically, counter ions selected from the group consisting of a halogen ion, a perchlorate ion, a tetrafluoroborate ion, a hexafluorophosphate ion, and a sulfonate ion are exemplified. A halogen ion, a perchlorate ion, a hexafluorophosphate ion, and an arylsulfonate ion are preferred.

A sensitizing dye having a partial structure represented by formula (1) of the invention can be synthesized with referring to JP-A-2000-80297, Dyes Pigm., 24 (2), 93-8 (1994) (Gadjev, N., Deligeorgiev, T., Kanev, I., Tasseva, M., Sabnis, R.), Dyes Pigm., 17 (2), 153-62 (1991).

The preferred specific examples (D-1) to (D-52) of the compound having a partial structure represented by formula (1) are shown below, but the invention is not restricted to these compounds. With respect to the isomer concerning the double bond bonding an acid nucleus and a basic nucleus, the invention is not limited to either isomer.

D-01

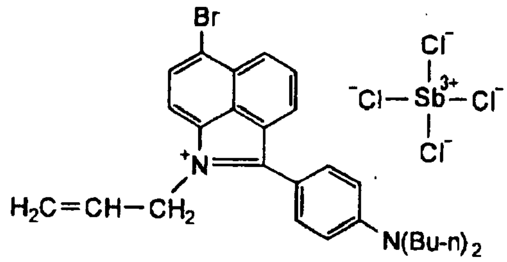

D-02

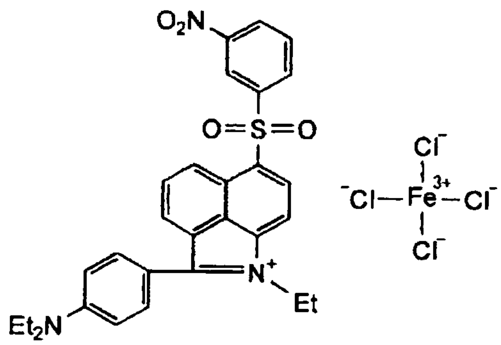

D-03

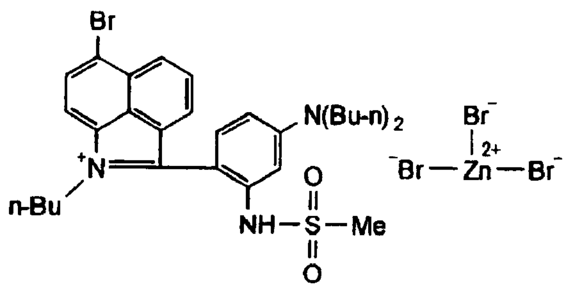

D-04

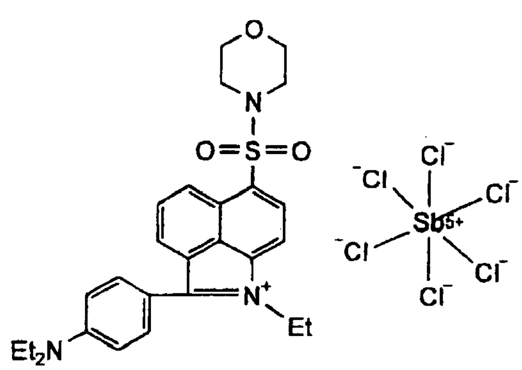

D-05

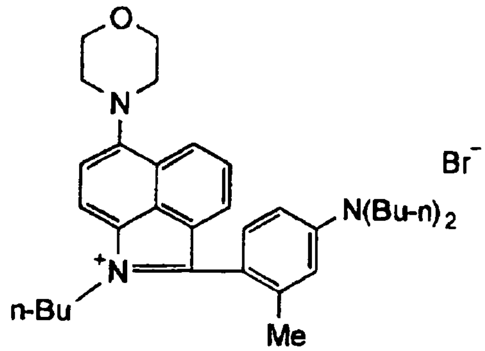

D-06

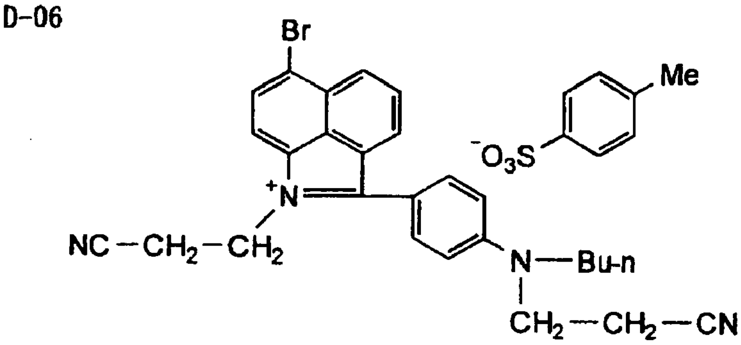

D-07

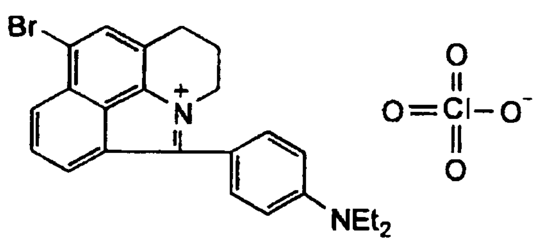

D-08

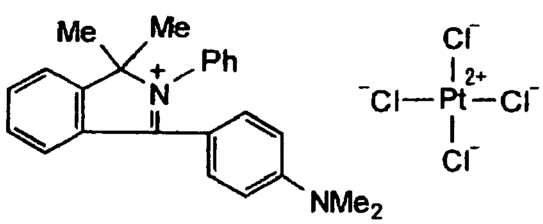

D-09

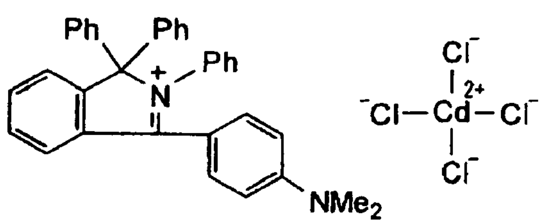

D-10

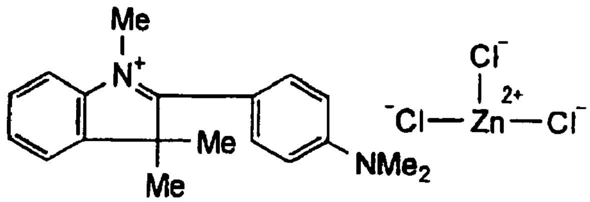

D-11

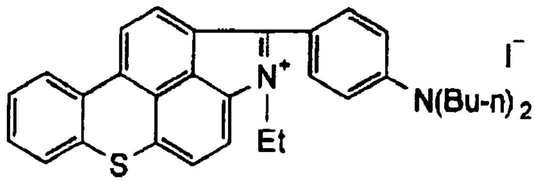

D-12

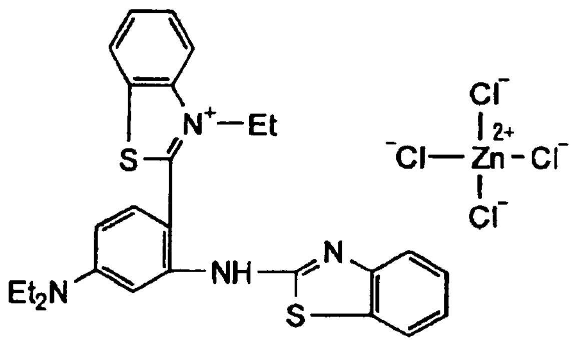

D-13

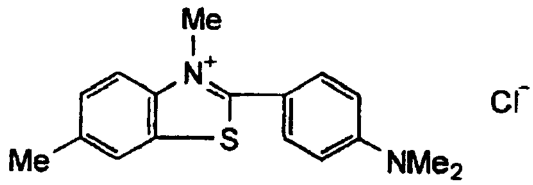

D-14

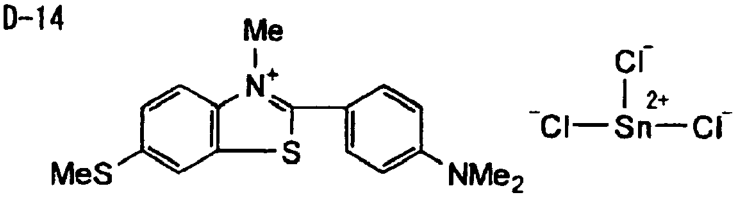

D-15

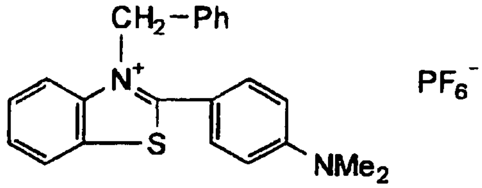

D-16

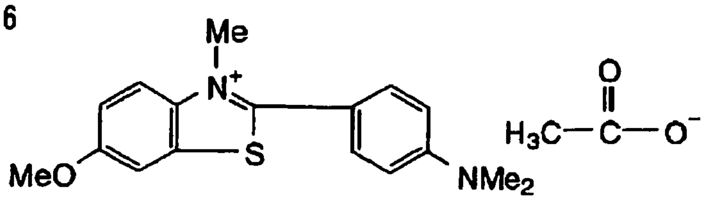

D-17

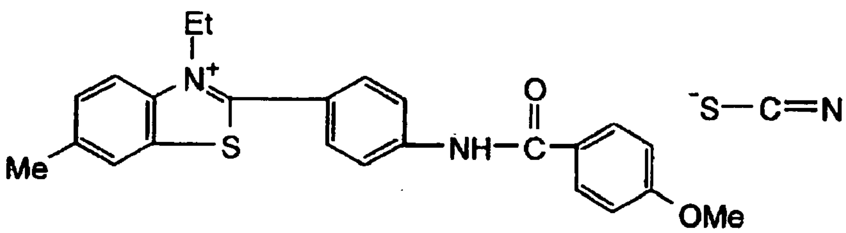

D-18

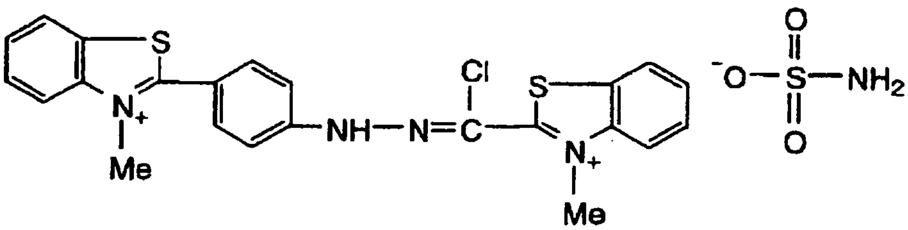

D-19

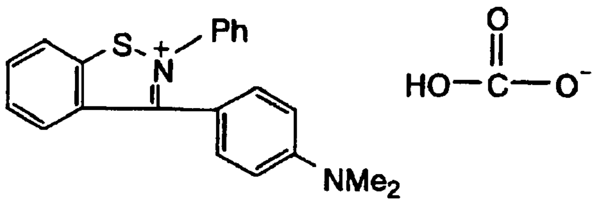

D-20

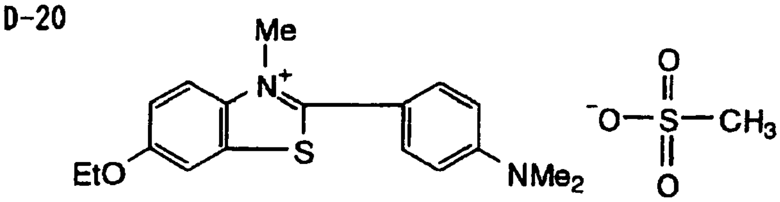

D-21

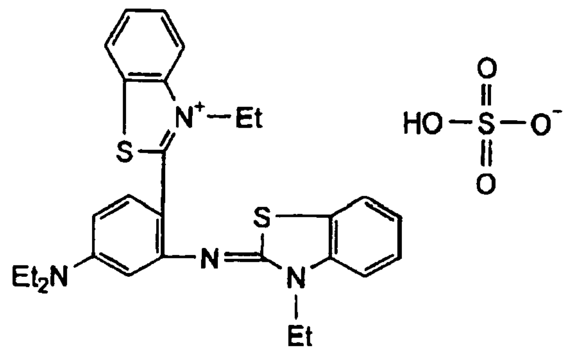

D-22

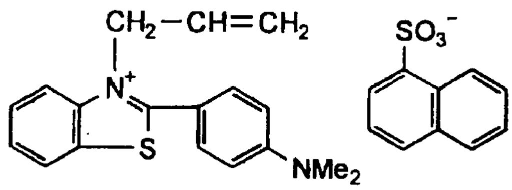

D-23

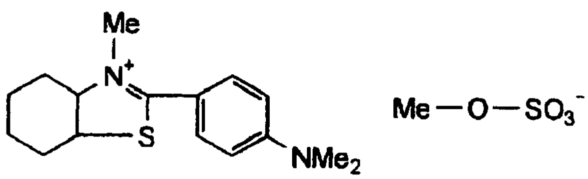

D-24

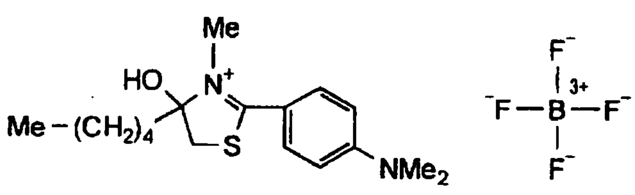

D-25

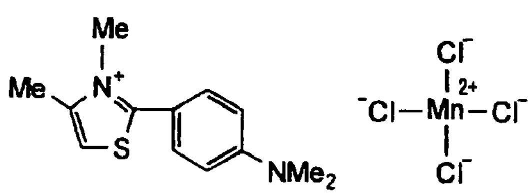

D-26

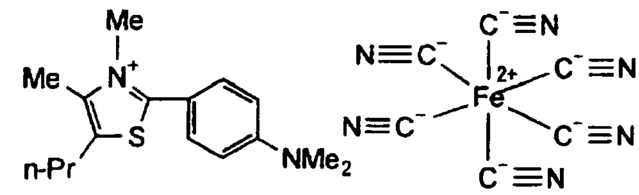

D-27

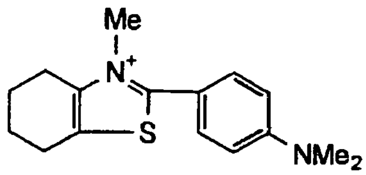

$BF_4^-$

D-28

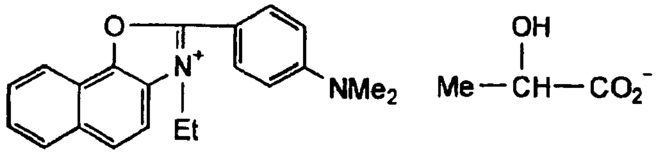

D-29

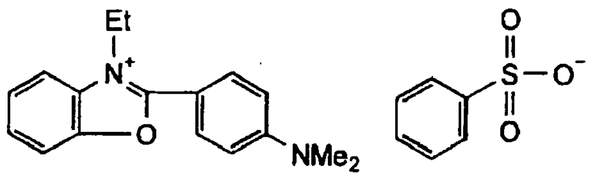

D-30

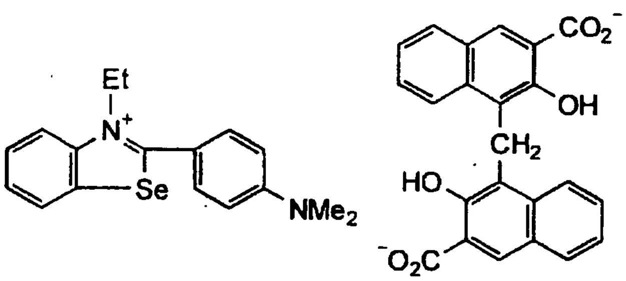

D-31

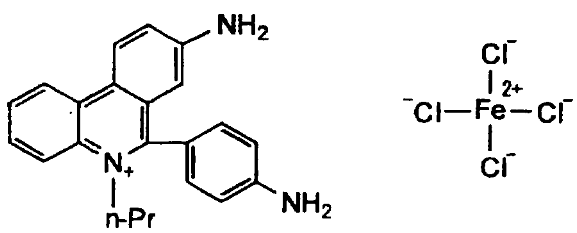

D-32

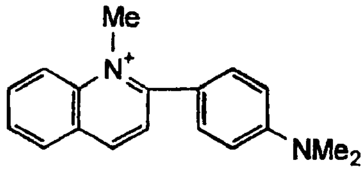
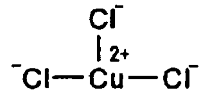

D-33

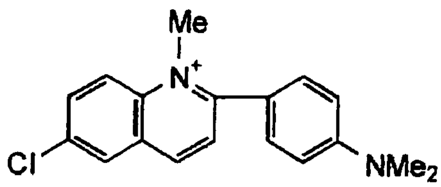
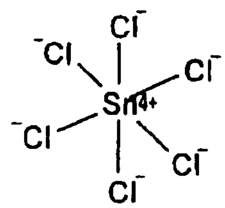

D-34

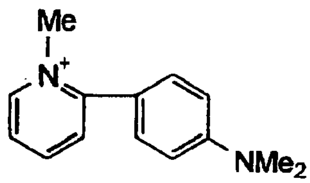

$OH^-$

D-35

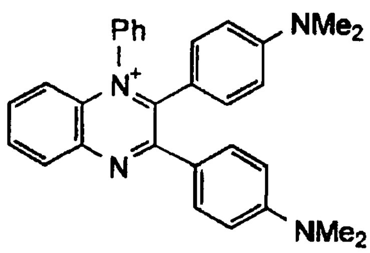
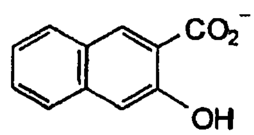

D-36

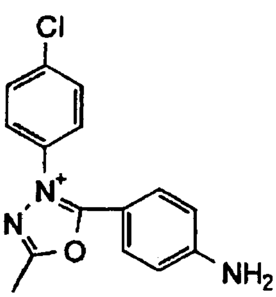
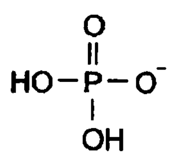

D-37

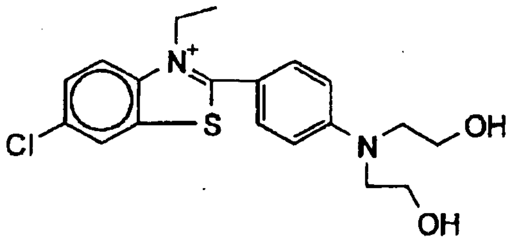

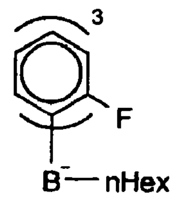

D-38

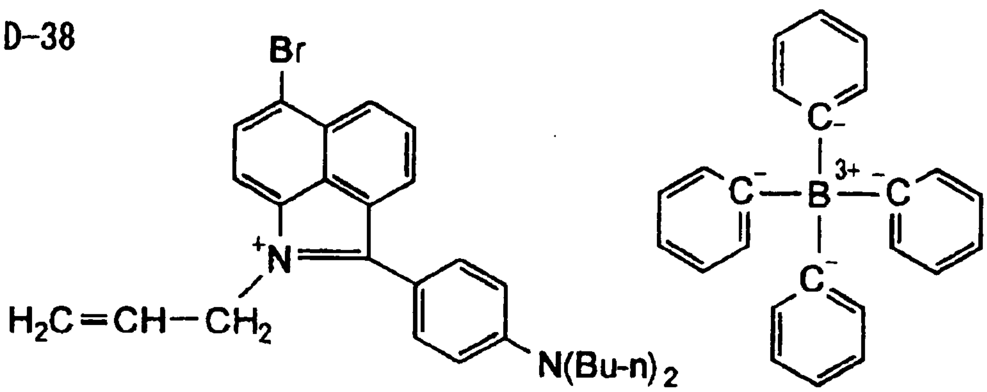

D-39

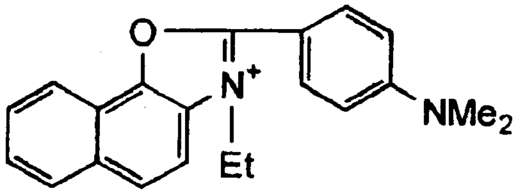

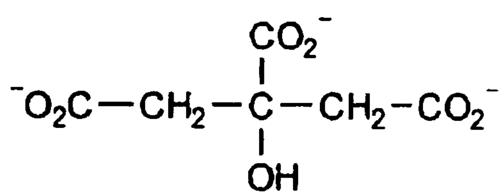

D-40

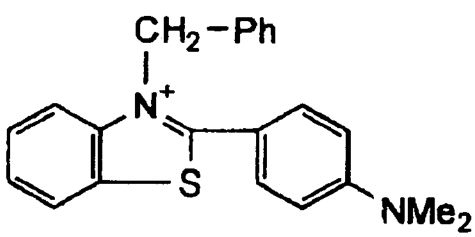

$I^-$

(D-41)
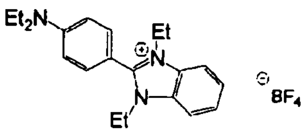

(D-42)
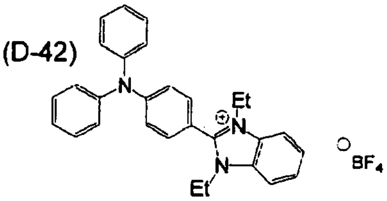

(D-43)
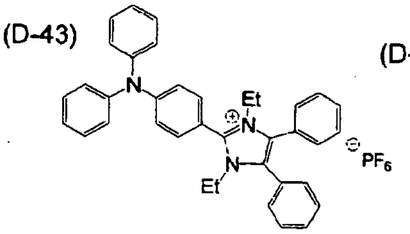

(D-44)
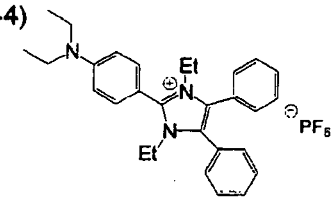

(D-45)
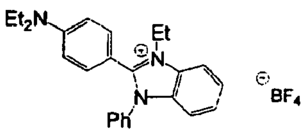

(D-46)
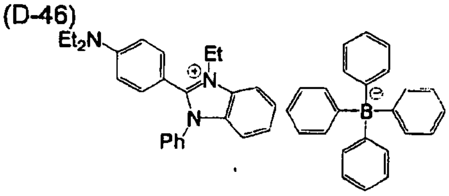

(D-47)
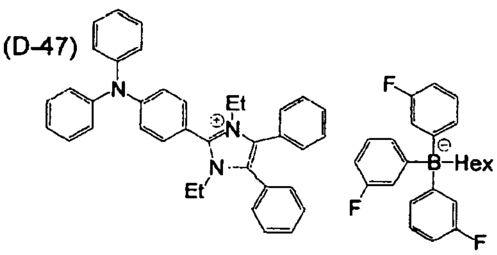

(D-48)
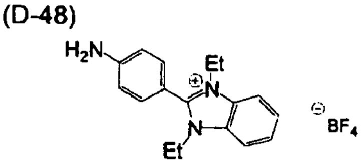

(D-49)
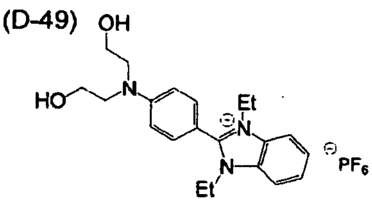

(D-50)
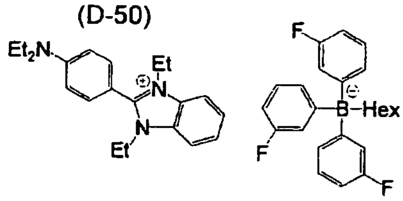

(D-51)
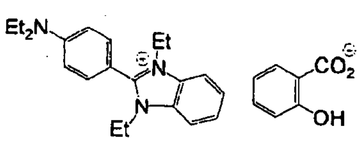

(D-52)
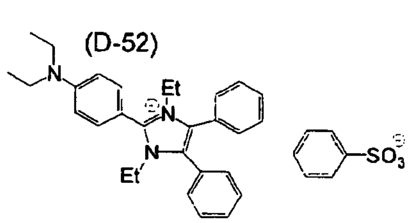

In the next place, sensitizing dye (A2) is described in detail below.

(A) Sensitizing dye

Sensitizing dye (A2) for use in the invention is a compound represented by the following structural formula (I).

Formula (I)

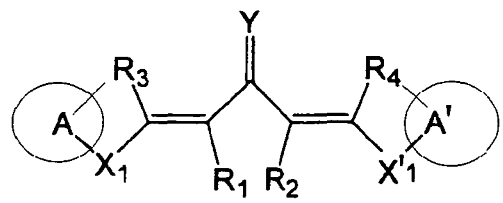

In formula (I), $X_1$ and $X_1$' each independently represents an oxygen atom, a sulfur atom, $-CR_5R_6$ or $-NR_7-$, and at least either one of $X_1$ and $X_1$' represents an oxygen atom, a sulfur atom or $-NR_7-$; $R_1$, $R_2$, $R_3$, $R_4$, $R_5$, $R_6$ and $R_7$ each independently represents a hydrogen atom or a monovalent nonmetallic atomic group; Y represents an oxygen atom, a sulfur atom, or $NR_8$; and A and A' each independently represents a substituted or unsubstituted aromatic ring or a heterocyclic ring; $R_3$ and $R_4$ each represents a nonmetallic atom or a nonmetallic atomic group that is bonded to any moiety of A and A' to form a cyclic structure, and $R_1$ to $R_8$ may be bonded to each other to form an aliphatic or aromatic ring.

The dye represented by formula (I) is preferably represented by the following formula (II).

Formula (II)

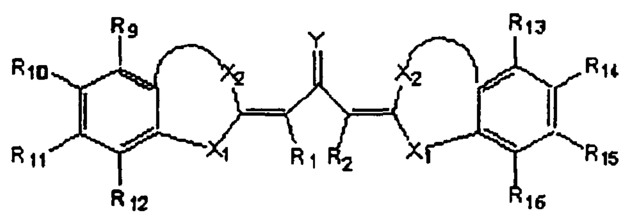

In formula (II), $X_1$ and $X_2$ each represents an oxygen atom, a sulfur atom, $-CR_5R_6$ or $-NR_7-$, and at least either one $X_1$ represents an oxygen atom, a sulfur atom, or $-NR_7-$; $R_1$, $R_2$, $R_9$ to $R_{16}$ each independently represents a hydrogen atom or a monovalent nonmetallic atomic group; Y represents an oxygen atom, a sulfur atom, or NRs; and $R_1$, $R_2$, $R_5$ to $R_{16}$ may be bonded to each other to form an aliphatic or aromatic ring.

The dye represented by formula (II) is more preferably represented by the following formula (III).

Formula (III)

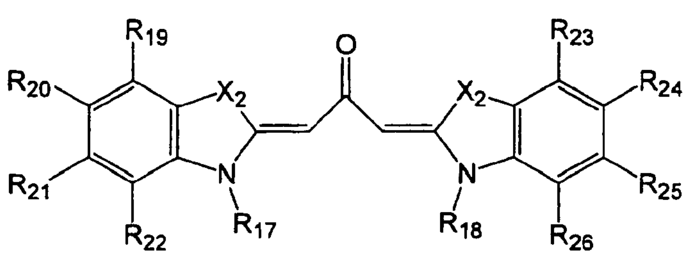

In formula (III), $X_2$ represents an oxygen atom, a sulfur atom, $-CR_5R_6$ or $-NR_7-$; $R_5$, $R_6$, $R_7$, $R_{17}$ to $R_{26}$ each independently represents a hydrogen atom or a monovalent nonmetallic atomic group; and $R_5$, $R_6$, $R_7$, $R_{17}$ to $R_{26}$ may be bonded to each other to form an aliphatic or aromatic ring.

A sensitizing dye represented by formula (III), where $X_2$ represents $-CR_5R_6$, and $R_5$ and $R_6$ each represents

an alkyl group, which is represented by the following formula (IV), is restrained in crystallizability, and so especially preferred.

Formula (IV)

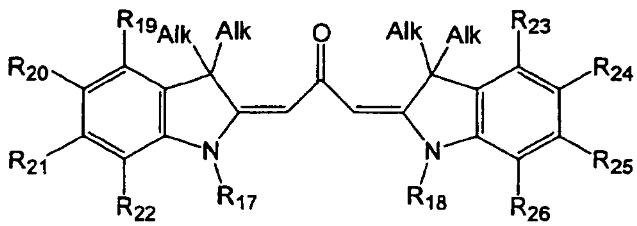

In formula (IV), Alk represents an alkyl group having from 1 to 10 carbon atoms, which may be branched; and $R_1$ to $R_{26}$ have the same meanings as those in formula (III).

Formulae (I) to (IV) are explained in detail. $R_1$ and $R_2$ each preferably represents a hydrogen atom or a substituted or unsubstituted alkyl group, and as the preferred examples of alkyl groups, straight chain, branched or cyclic alkyl groups having from 1 to 20 carbon atoms can be exemplified, and as the specific examples, e.g., a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group can be exemplified.

$R_3$ and $R_4$ each preferably represents an oxygen atom, a sulfur atom, $-CR_5R_6$ or $-NR_7-$, and bonded to the substituted or unsubstituted aromatic ring or heterocyclic ring represented by A by at least one bond.

$R_5$, $R_6$ and $R_7$ each preferably represents a substituted or unsubstituted alkyl group. As the examples of the preferred alkyl groups, straight chain, branched or cyclic alkyl groups having from 1 to 20 carbon atoms are exemplified, specifically, a methyl group, an ethyl group, a propyl group, a butyl group, a pentyl group and a hexyl group can be exemplified.

$R_9$ to $R_{16}$, $R_{19}$ to $R_{26}$ each preferably represents a hydrogen atom, a substituted or unsubstituted alkyl group, an alkoxyl group, a halogen atom, a cyano group, an alkoxycarbonyl group, a substituted or unsubstituted aryl group, or a substituted or unsubstituted heteroaryl group.

The preferred examples of $R_9$ to $R_{16}$, $R_{19}$ to $R_{26}$ are specifically described below. As the preferred examples of the alkyl groups, straight chain, branched, or cyclic alkyl groups having from 1 to 20 carbon atoms are exemplified, and as the specific examples, e.g., a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group can be exemplified. Of these groups, straight chain alkyl groups having from 1 to 12 carbon atoms, branched alkyl groups having from 3 to 12 carbon atoms, and cyclic alkyl groups having from 5 to 10 carbon atoms are more preferred.

As the substituents of the substituted alkyl group, monovalent nonmetallic atomic groups exclusive of a hydrogen atom are used. The examples of preferred substituents include a halogen atom (-F, -Br, -Cl, -I), a hydroxyl group, an alkoxyl group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl- carbamoyloxy group, an N-alkyl-N-arylcarbamoyloxy group, an alkylsulfoxy group, an arylsulfoxy group, an acyloxy group, an acylthio group, an acylamino group, an N-alkylacylamino group, an N-arylacylamino group, a ureido group, an N'-alkyl- ureido group, an N',N'-dialkylureido group, an N'-arylureido group, an N',N'-diarylureido group, an N'-alkyl-N'-aryl- ureido group, an N-alkylureido group, an N-arylureido group, an N'-alkyl-N-alkylureido group, an N'-alkyl-N-arylureido group, an N',N'-dialkyl-N-alkylureido group, an N',N'- dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'- aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N- aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-aryl- carbamoyl group, an alkylsulfinyl group, an arylsulfinyl group, an alkylsulfonyl group, an arylsulfonyl group, a sulfo group ($-SO_3H$) and a conjugate base group thereof (hereinafter referred to as a sulfonato group), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and a conjugate base group thereof (hereinafter referred to as a phosphonato group), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and a conjugate base group thereof (hereinafter referred to as an alkylphosphonato group), a monoarylphosphono group ($-PO_3H(aryl)$) and a conjugate base group thereof (hereinafter referred to as an arylphosphonato group), a phosphonooxy group ($-OPO_3H_2$) and a conjugate base group thereof (hereinafter referred to as a phosphonatooxy group), a dialkylphosphonooxy group ($-OPO_3(alkyl)_2$), a diarylphosphono- oxy group ($-OPO_3(aryl)_2$), an alkylarylphosphonooxy group ($-OPO_3(alkyl)(aryl)$), a monoalkylphosphonooxy group ($-OPO_3H(alkyl)$) and a conjugate base group thereof (hereinafter referred to as an alkylphosphonatooxy group), a monoarylphosphonooxy group ($-OPO_3H(aryl)$) and a conjugate base group thereof (hereinafter referred to as an arylphosphonato- oxy group), a cyano group, a nitro group, an aryl group, a heteroaryl group, an alkenyl group, an alkynyl group, and a silyl group.

As the specific examples of the alkyl groups in these substituents, the above alkyl groups are exemplified, and these substituents may further be substituted.

The preferred examples of the alkoxyl groups represented by $R_9$ to $R_{16}$, $R_{19}$ to $R_{26}$ include a methoxy group and an ethoxy group. As the halogen atoms, -Cl and -Br are preferred, and -Cl is more preferred. As the alkoxycarbonyl group, a methoxy- carbonyl group and an ethoxycarbonyl group are preferred, and a methoxycarbonyl group is more preferred.

The examples of the preferred aryl groups represented by $R_9$ to $R_{16}$, $R_{19}$ to $R_{26}$ include a condensed ring formed by 1 to 3 benzene rings and a condensed ring formed by a benzene ring and a 5-membered unsaturated ring are exemplified, and the specific examples include a phenyl group, a naphthyl group, an anthryl group, a phenanthryl group, an indenyl group, an acenaphthenyl group, and a fluorenyl group. Of these groups, a phenyl group and a naphthyl group are more preferred.

The specific examples of the substituted aryl groups represented by $R_9$ to $R_{16}$, $R_{19}$ to $R_{26}$ include those having a monovalent nonmetallic atomic group (other than a hydrogen atom) on the ring-forming carbon atoms of the above aryl groups as the substituent are used. As the preferred examples of the substituents, the above alkyl groups, the above substituted alkyl groups, and the substituents of the substituted alkyl groups described above can be exemplified. The preferred specific examples of the substituted aryl groups include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthio- phenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyl- oxyphenyl group, an acetylaminophenyl group, an N-methyl- benzoylaminophenyl group, a carboxyphenyl group, a methoxy- carbonylphenyl group, an allyloxycarbonylphenyl group, a chlorophenoxycarbonylphenyl group, a carbamoylphenyl group, an N-methylcarbamoylphenyl group, an N,N-dipropylcarbamoyl- phenyl group, an N-(methoxyphenyl)carbamoylphenyl group, an N-methyl-N-(sulfophenyl) carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N- (phosphonophenyl)sulfamoylphenyl group, a phosphonophenyl group, a phosphonatophenyl group, a diethylphosphonophenyl group, a diphenylphosphonophenyl group, a methylphosphono- phenyl group, a methylphosphonatophenyl group, a tolylphosphonophenyl group, a tolylphosphonatophenyl group, an allyl group, a 1-propenylmethylphenyl group, a 2-butenylphenyl group, a 2-methylallylphenyl group, a 2-methyl- propenylphenyl group, a 2-propynylphenyl group, a 2-butynylphenyl group, and a 3-butynylphenyl group are exemplified.

As the heteroaryl groups, the groups derived from the monocyclic or polycyclic aromatic rings containing at least one of nitrogen, oxygen and sulfur atoms are used, and the examples of especially preferred heteroaryl rings in the heteroaryl groups include, e.g., thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthyridine, quinazoline, cinnoline, pteridine, carbazole, carboline, phenanthrine, acridine, perimidine, phenanthroline, phthalazine, phenarsazine, phenoxazine, furazane, and phenoxazine. These groups may further be benzo-condensed or may have a substituent.

$R_{17}$ and $R_{18}$ each preferably represents a substituted or unsubstituted alkyl group, and the preferred examples thereof are the same as these described in the alkyl groups represented by $R_1$ and $R_2$.

A in formula (I) is explained below. A represents an aromatic ring or a heterocyclic ring which may have a substituent, and as the specific examples of the substituents, the same examples described in the explanation of $R_9$ to $R_{16}$, $R_{19}$ to $R_{26}$ in formula (II) or (III) can be exemplified.

A preferably represents an alkoxyl group, a thioalkyl group, an amino group, or an aryl group having a halogen atom or a cyano group, and A more preferably represents an aryl group having a halogen atom. As the especially preferred aryl groups having a halogen atom, a monochloroaryl group and a dichloro- aryl group are exemplified, specifically a chlorophenyl group and a dichlorophenyl group are exemplified.

The preferred specific examples of the sensitizing dyes represented by formula (I) in the invention (exemplified compounds D-101 1 to D-121) are shown below, but the invention is not limited thereto.

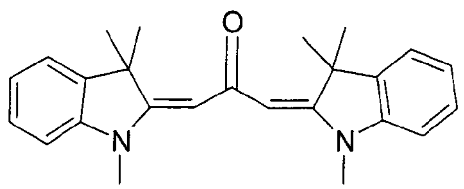

D-101

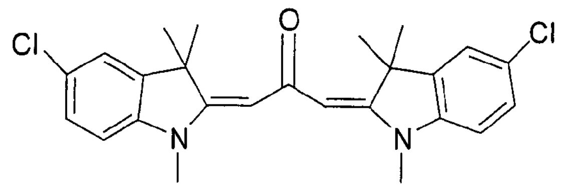

D-102

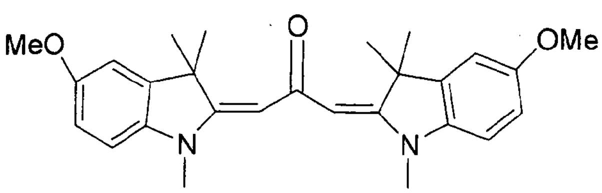

D-103

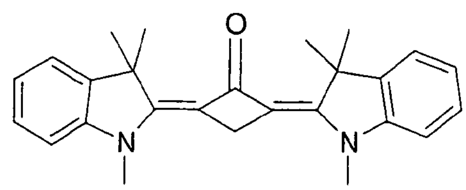

D-104

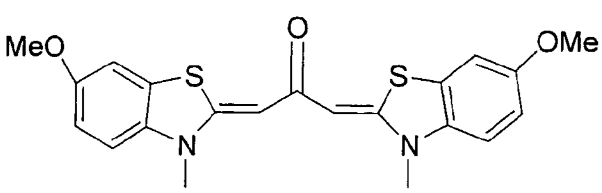

D-105

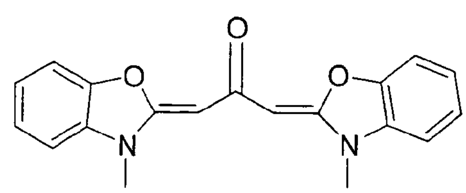

D-107

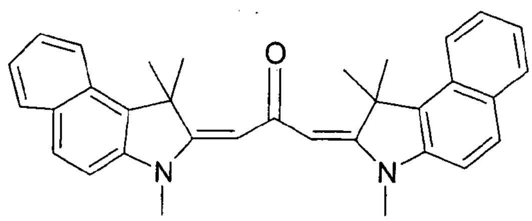

D-108

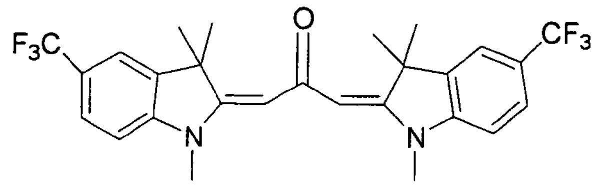

D-109

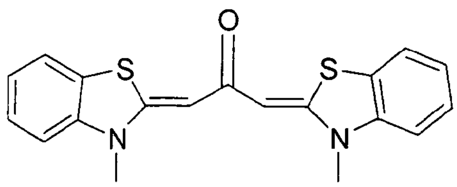

D-110

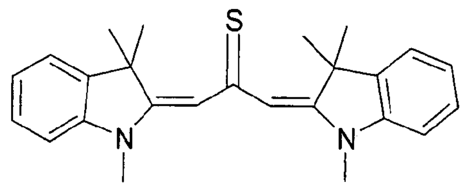

D-111

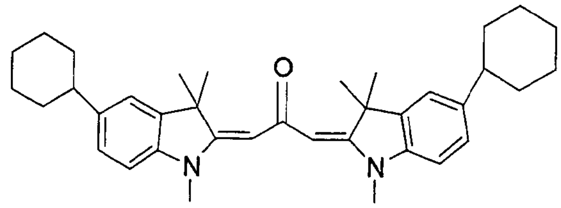

D-112

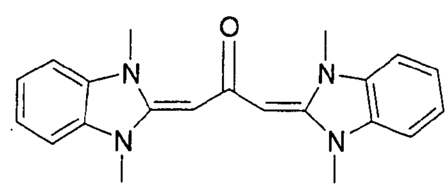

D-113

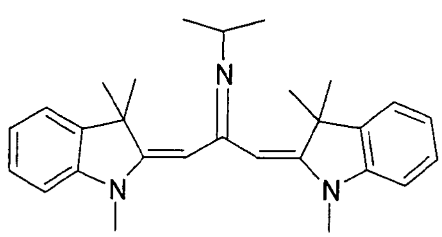

D-114

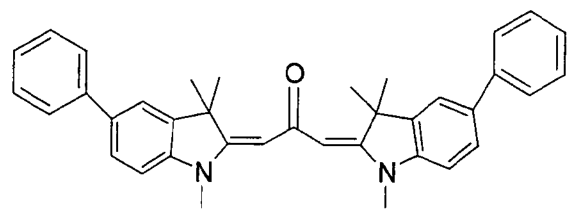

D-115

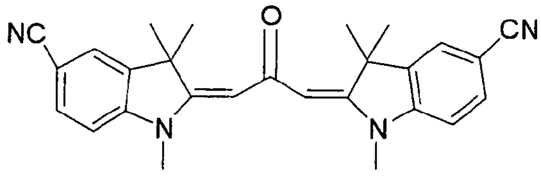

D-116

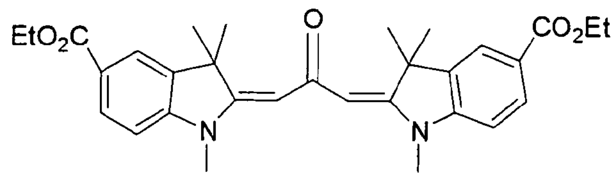

D-117

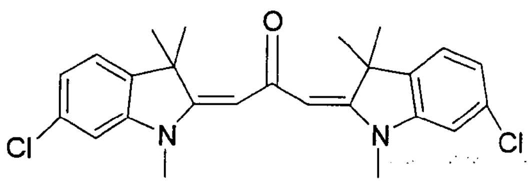

D-118

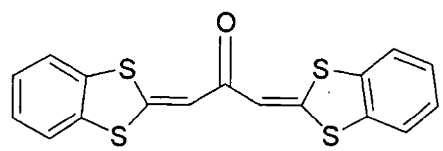

D-119

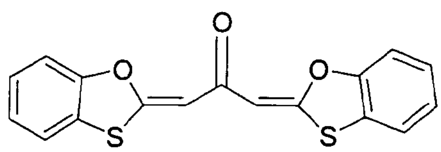

D-120

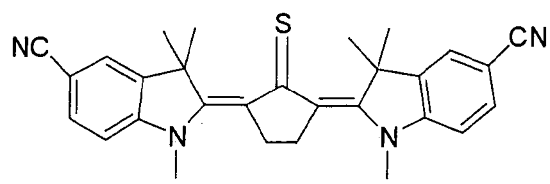

D-121

The sensitizing dye represented by formula (I) can be synthesized according to well-known methods. As the specific synthesis example, the synthesizing method of compound D-101 1 is described below.

Synthesis of Compound D-101

2-Methylene-1,3,3-trimethylindolenine (17.3 g) was blended with 40 ml of toluene at room temperature, and then 8.3 ml of pyridine was added thereto, and the reaction mixture was stirred at room temperature for 20 minutes. Subsequently, 5 g of triphosgene was dissolved in 20 ml of toluene and the solution was slowly dripped to the reaction mixture while cooling with ice. After dripping, the temperature of the reaction solution was raised to room temperature and followed by stirring for 1 hour.

A saturated solution of sodium hydrogencarbonate was dropwise added to the reaction solution stirred at room temperature for 1 hour until defoaming stopped to quench the triphosgene. After that, 200 ml of water was added thereto, and the organic layer comprising ethyl acetate-toluene extracted with ethyl acetate was washed with a sodium chloride aqueous solution, subsequently with water. After washing, the organic phase was concentrated to obtain a dark purple solid substance. The obtained liquid was reslurried with methanol and further recrystallized with acetone, whereby 2 g of the objective compound D-101 was obtained.

The sensitizing dyes in the invention may further be subjected to various chemical modifications for the purpose of improving the characteristics of a photosensitive layer. For example, the strength of an exposed film can be increased and unnecessary precipitation of a dye from the film after exposure can be prevented by bonding the sensitizing dye with an addition polymerizable compound structure (e.g., an acryloyl group and a methacryloyl group) by means of covalent bonding, ionic bonding, or hydrogen bonding.

Further, photosensitivity can be conspicuously increased with the state of an initiation system in low concentration by bonding a sensitizing dye with a partial structure having a radical generating property in the later- described initiating compound (e.g., reduction decomposition parts such as alkyl halide, onium, peroxide, biimidazole, etc., and oxidation cleavage parts such as borate, amine, trimethylsilylmethyl, carboxymethyl, carbonyl, imine, etc.).

When the photosensitive composition according to the invention is used as the photosensitive layer of a lithographic printing plate precursor which is a preferred way of use, the introduction of a hydrophilic part (an acid radical or a polar group such as a carboxyl group and an ester thereof, a sulfonic acid group and an ester thereof, and an ethylene oxide group, etc.) is effective for the purpose of improving the processing aptitude to an alkali developing solution or an aqueous developing solution. In particular, an ester type hydrophilic group is excellent in compatibility due to its comparatively hydrophobic structure in a photosensitive layer, and generates an acid radical by hydrolysis in a developing solution, so that hydrophilicity increases.

In addition, substituents can be arbitrarily introduced for the purpose of the improvement of compatibility and the prevention of crystal precipitation in a photosensitive layer. For example, in a certain kind of photosensitive system, unsaturated bonds of an aryl group and an allyl group are sometimes extremely effective for the improvement of compatibility and, further, crystal precipitation can be markedly inhibited by the introduction of steric hindrance between π-flat surface of a dye by a method of introducing a branched alkyl structure, etc. Further, by the introduction of a phosphonic acid group, an epoxy group and a trialkoxysilyl group, etc., adhesion of metals and metallic oxides to organic substances can be improved. In addition, if necessary, a polymerizing method of a sensitizing dye can also be used.

In the invention, it is sufficient to use at least one kind of specific sensitizing dye (A), so far as it goes, the details of usage, e.g., what a structure of dye is used as to chemically modified sensitizing dyes, whether dyes are used alone or in combination of two or more, and what an amount is added, can be arbitrarily selected according to the design of performance of the final purpose of a photosensitive material, e.g., a lithographic printing plate precursor. For example, the compatibility with a photosensitive layer can be increased by the combined use of two or more sensitizing dyes.

In the selection of sensitizing dye, the molar extinction coefficient at the emission wavelength of the light source to be used is an important factor, in addition to photosensitivity. If a dye having a large molar extinction coefficient is used, the addition amount of the dye can be relatively reduced, which is economical and is also advantageous from the point of view of the physical properties of the photosensitive layer.

In the invention, in addition to specific sensitizing dye (A), general purpose sensitizing dyes can also be used so long as the effect of the invention is not hindered.

Since the photosensitivity, the resolution and the physical properties of exposed film of a photosensitive layer are largely influenced by the absorbance at a light source wavelength, the addition amount of sensitizing dyes is arbitrarily selected taking these factors into consideration. For example, sensitivity decreases in the low region of absorbance of 0.1 or less. Further, resolution decreases by the influence of halation. However, such low absorbance is sometimes rather effective for the purpose of increasing hardness of a thick film of 5 μm or more. Almost all the light is absorbed on the surface of a photosensitive layer in a high region of absorbance of 3 or more, hence, curing is hindered at more inside of the film and, when the photosensitive composition is used as a printing plate, the film strength and adhesion strength to a substrate become insufficient.

For example, when the photosensitive composition is used as the photosensitive layer of a lithographic printing plate precursor having a comparatively thin film thickness, it is preferred to set up the addition amount of a sensitizing dye such that the absorbance of the photosensitive layer becomes from 0.1 to 1.5, preferably from 0.25 to 1. Since the absorbance is determined by the addition amount of the sensitizing dye and the photosensitive layer thickness, a desired absorbance can be obtained by the control of both conditions. The absorbance of a photosensitive layer can be measured by ordinary methods. As measuring methods, a method of forming, on a transparent or white support, a photosensitive layer having a necessary dry coating weight as a lithographic printing plate determined in the arbitrary range, and measuring the absorbance with a transmission type optical densitometer, and a method of forming a photosensitive layer on a reflective support such as aluminum, and measuring the reflection density are exemplified.

When the photosensitive composition of the invention is used as the photosensitive layer of a lithographic printing plate precursor, the addition amount of the sensitizing dye is generally from 0.05 to 30 mass parts in 100 mass parts of all the solids content of the photosensitive composition, preferably from 0.1 to 20 mass parts, and more preferably from 0.2 to 10 mass parts. (In this specification, mass ratio is equal to weight ratio.)

The second essential component in the photosensitive composition of the invention, initiating compound (B), is described.

(B) Initiating compound

The initiating compound in the invention is a compound that causes chemical change through interaction with the electronic excitation state caused by the light absorption of a sensitizing dye and generates radicals, acids or bases. Hereinafter, the thus-generated radicals, acids or bases are merely referred to as active species. When these compounds are not present or only initiating compound alone is used, practicably sufficient sensitivity cannot be obtained, but it is

possible to take the sensitizing dye and the initiating compound as one mode of combined use, and use them as a single compound by an appropriate chemical method (e.g., coupling of the sensitizing dye and the initiating compound by chemical bonding, etc.). Such a technical concept is disclosed, e.g., in Japanese Patent 2720195.

It is thought that many of these initiating compounds generally generate active species through the following initial chemical processes (1) to (3). That is, the processes of (1) the reduction decomposition of the initiating compound on the basis of the electron transfer reaction from the electronic excitation state of the sensitizing dye to the initiating compound, (2) the oxidation decomposition of the initiating compound on the basis of the electron transfer from the initiating compound to the electronic excitation state of the sensitizing dye, and (3) the decomposition from the electronic excitation state of the initiating compound on the basis of the energy transfer from the electronic excitation state of the sensitizing dye to the initiating compound. There are cases where it is vague that to what process individual compound belongs, but a great characteristic of the sensitizing dyes in the invention is that they exhibit high sensitizing effect, whatever activating compound they may be combined with.

Initiating compounds well known in the industry can be used with no limitation. Specifically, many of such initiating compounds are described, e.g., in Bruce M. Monroe et al., Chemical Revue, Vol. 93, p. 435 (1993); R.S. Davidson, Journal of Photochemistry and Biology A: Chemistry, Vol. 73, p. 81 (1993); J.P. Faussier, Photoinitiated Polymerization - Theory and Applications, Rapra Review, Vol. 9, Report, Rapra Technology (1998); and M. Tsunooka et al., Prog. Polym. Sci., 21, 1 (1996). Further, as other compounds having the above functions (1) and (2), compounds causing oxidative or reductive bonding cleavage are known and described, e.g., in F.D. Saeva, Topics in Current Chemistry, 156, 59 (1990); GG Maslak, Topics in Current Chemistry, 168, 1 (1993); H.B. Shuster et al., JACS, 112, 6329 (1990); and I.D.F. Eaton et al., JACS, 102, 3298 (1980).

Regarding the specific examples of preferred initiating compounds, the initiating compounds are classified into (a) those that cause bonding cleavage by reduction and generate active species, (b) those that cause bonding cleavage by oxidation and generate active species, and (c) others. That to what group each compound belongs is not based on a popular view in considerable cases, and the invention is not restricted to the description of these reaction mechanisms.

(a) Those that cause bonding cleavage by reduction and generate active species:

Compounds having a carbon-halogen bond: It is considered that the carbon-halogen bond is reductively cleaved to generate an active species (as described in, for example, Polymer Preprints, Jpn., 41(3), 542 (1992)). A radical or an acid can be generated as the active species. Specific examples of the compound which can be suitably used include halomethyl-s-triazines; and besides, halomethyl oxadiazoles which can be easily synthesized by those skilled in the art by a synthesis method as described in M.P. Hutt, E.F. Elslager and L.M. Merbel, Journal of Heterocyclic Chemistry, 7, 511 (1970); and compounds described in each of German Patents Nos. 2,641,100, 3,333,450, 3,021,590 and 3,021,599.

Compounds having a nitrogen-nitrogen bond or a nitrogen-containing hetero ring-nitrogen-containing hetero ring bond: Bond cleavage is reductively caused (as described in, for example, J. Pys. Chem., 96, 207 (1992)). Specifically, hexaaryl biimidazoles can be suitably used. The active species as generated is a lophine radical. When used jointly with a hydrogen-providing material as the need arises, it starts a radical chain reaction, and besides, image formation using an oxidation reaction by a lophine radical is known (as described in J. Imaging Sci., 30, 215 (1986)).

Compounds having an oxygen-oxygen bond: It is considered that the oxygen-oxygen bond is reductively cleaved to generate an active radical (as described in, for example, Polym. Adv. Technol., 1, 287 (1990)). Specifically, for example, organic peroxides are suitably used. A radical can be generated as the active species.

Onium compounds: It is considered that a carbon-hetero bond or an oxygen-nitrogen bond is reductively cleaved to generate an active species (as described in, for example, J. Photopolym. Sci. Technol., 3, 149 (1990)). Specific examples of the onium compound which can be suitably used include iodonium salts as described in European Patent No. 104,143, U.S. Patent No. 4,837,124, JP-A-2-150848, and JP-A-2-96514; sulfonium salts as described in European Patents Nos. 370,693, 233,567, 297,443, 297,442, 279,210 and 422,570 and U.S. Patents Nos. 3,902,144, 4,933,377, 4,760,013, 4,734,444 and 2,833,827; diazonium salts (for example, optionally substituted benzenediazonium); diazonium salt resins (for example, a formaldehyde resin of diazodiphenylamine); N-alkoxypyridinium salts (for example, ones described in U.S. Patent No. 4,743,528, JP-A-63-138345, JP-A-63-142345, JP-A-63-142346, and JP-B-46-42363, and specifically 1-methoxy-4-phenylpyridinium tetrafluoroborate, etc.); and compounds as described in JP-B-52-147277, JP-B-52-14278, and JP-B-52-14279. A radical or an acid is generated as the active species.

Active esters: Nitrobenzyl esters of a sulfonic acid or a carboxylic acid, esters of a sulfonic acid or a carboxylic acid and an N-hydroxy compound (for example, N-hydroxyphthalimide and oximes), sulfonic acid esters of pyrogallol, naphthoquinonediazide-4-sulfonic acid esters, and the like can be reductively cleaved. A radical or an acid can be generated as the active species. Specific examples of sulfonic acid esters include nitrobenzyl ester compounds as described in European Patents Nos. 0,290,750, 046,083, 156,153, 271,851 and 0,388,343, U.S. Patents Nos. 3,901,710 and 4,181,531, JP-A-60-198538, and JP-A-53-133022; iminosulfonate compounds as described in European Patents

Nos. 0,199,672, 84,515, 199,672, 044,115 and 0,101,122, U.S. Patents Nos. 4,618,564, 4,371,605 and 4,431,774, JP-A-64-18143, JP-A-2-245756, and JP-A-4-365048; and compounds as described in JP-B-62-6223, JP-B-63-14340, and JP-A-59-174831. Furthermore, there are enumerated the following compounds.

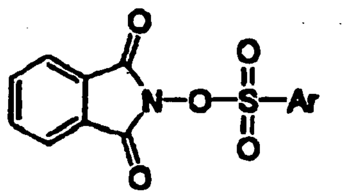
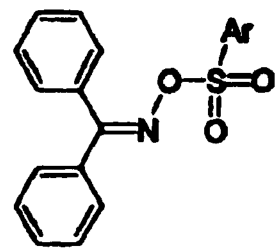
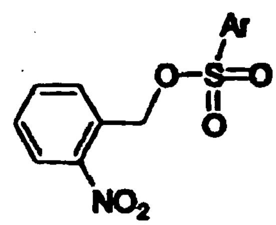

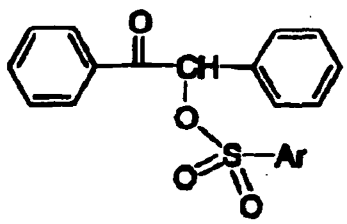
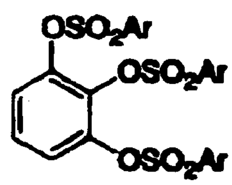
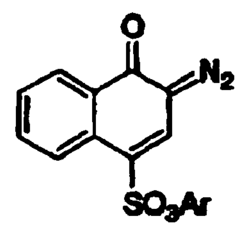

In the formulae, Ar represents an optionally substituted aromatic group or aliphatic group.
It is also possible to generate a base as the active species, and for example, the following compound groups are known.
Ferrocene and iron-allene complexes: An active radical can be reductively generated. Specific examples are disclosed in JP-A-1-304453 and JP-A-1-152109.

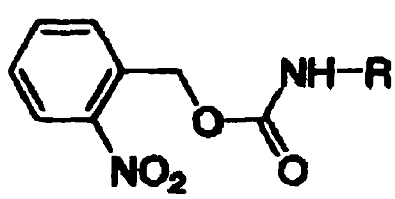
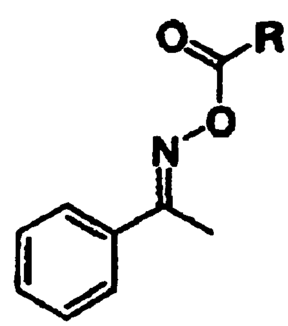

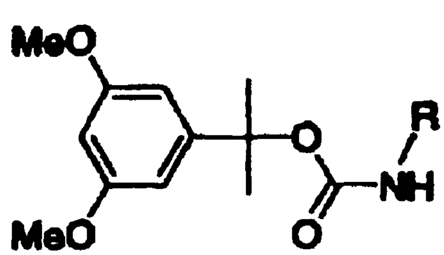

$[CO(III)(NH_3)_5Br](ClO_4)_2$

In the formulae, R represents an optionally substituted aliphatic group or aromatic group.

Disulfones: An S-S bond cleavage can be reductively caused to generate an acid. For example, diphenyldisulfones as described in JP-A-61-166544 are known.

(b) Those that cause bonding cleavage by oxidation and generate active species:

Alkylate complexes: It is considered that a carbon-hetero bond is oxidatively cleaved to generate an active radical (as described in, for example, J. Am. Chem. Soc., 112, 6329 (1990)). Specifically, for example, triarylalkyl borates are suitably used.
Alkylamine compounds: It is considered that a C-X bond on the carbon adjacent to nitrogen is cleaved due to oxidation to generate an active radical (as described in, for example, J. Am. Chem. Soc., 116, 4211 (1994)). X is suitably a hydrogen atom, a carboxyl group, a trimethylsilyl group, a benzyl group, etc. Specific examples of the alkylamine compound include ethanolamines, N-phenylglycines, and N-trimethylsilylmethylanilines.
Sulfur-containing and tin-containing compounds: Ones resulting from substitution of the nitrogen atom of the foregoing amine with a sulfur atom or a tin atom can generate an active radical due to a similar action. It is also known that a compound having an S-S bond causes sensitization due to S-S cleavage.
α-Substituted methylcarbonyl compounds: An active radical can be generated due to bond cleavage between carbonyl and α-carbon upon oxidation. Ones resulting from conversion of the carbonyl into oxime ether exhibit a similar action. Specific examples of the compound include 2-alkyl-1-[4-(alkylthio)phenyl]-2-morpholinopropanone-1 compounds and oxime ethers obtained by reacting such a compound with a hydroxylamine and then etherifying the N-OH.
Sulfinic acid salts: An active radical can be reductively generated. Specific examples thereof include sodium arylsulfinates.

(c) Others:

While the sensitization mechanism is not elucidated yet, there are a number of compounds capable of functioning as the initiating compound. Specific examples thereof include organometallic compounds such as tinanocenes and ferrocene, aromatic ketones, acyl phosphines, and bisacyl phosphines. A radical or an acid can be generated as the active species.
Among the initiating compounds which are used in the invention, preferred compound groups which are especially excellent in sensitivity and stability will be specifically enumerated below.

(1) Halomethyltriazines:

There is enumerated a compound represented by the following formula [II]. This compound is especially excellent in the radical generating or acid generating ability.

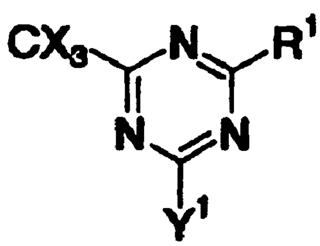

[II]

In the formula [II], X represents a halogen atom. Y' represents $-C(X)_3$, $-NH_2$, $-NHR^{1'}$, $NR^{1'}_2$, or $-OR^{1'}$. Here, $R^{1'}$ represents an alkyl group, a substituted alkyl group, an aryl group, or a substituted aryl group. $R^1$ represents $-C(X)_3$, an alkyl group, a substituted alkyl group, an aryl group, a substituted aryl group, or a substituted alkenyl group.
Specific examples of such a compound include compounds as described in, for example, Wakabayashi, et al., Bull. Chem. Soc. Japan, 42, 2924 (1969), such as 2-phenyl-4, 6-bis(trichloromethyl)-S-triazine, 2-(p-chlorophenyl)-4,6-bis(trichloromethyl)-S-triazine, 2-(p-tolyl)-4,6-bis(trichloromethyl)-S-triazine, 2-(p-methoxyphenyl)-4,6-bis(trichloromethyl)-S-triazine, 2-(2',4'-dichlorophenyl)-4,6-bis(trichloromethyl)-S-triazine, 2,4,6-tris(trichloromethyl)-S-triazine, 2-methyl-4,6-bis(trichloromethyl)-S-triazine, 2-n-nonyl-4,6-bis(trichloromethyl)-S-triazine, and 2-(α,α,β-trichloroethyl)-4,6-bis(trichloromethyl)-S-triazine. Besides, there can be enumerated compounds as described in U.K. Patent No. 1,388,492, such as 2-styryl-4,6-bis(trichloromethyl)-S-triazine, 2-(p-methylstyryl)-4,6-bis(trichloromethyl)-S-triazine, 2-(p-methoxystyryl)-4,6-bis(trichloromethyl)-S-triazine, and 2-(p-methoxystyryl)-4-amino-6-trichloromethyl-S-triazine; compounds as

described in JP-A-53-133428, such as 2-(4-methoxy-naphtho-1-yl)-4,6-bis-trichloromethyl-S-triazine, 2-(4-ethoxy-naphtho-1-yl)-4,6-bis-trichloromethyl-S-triazine, 2-[4-(2-ethoxyethyl)-naphtho-1-yl]-4,6-bis-trichloromethyl-S-triazine, 2-(4,7-dimethoxy-naphtho-1-yl)-4,6-bis-trichloromethyl-S-triazine, and 2-(acenaphtho-5-yl)-4,6-bis-trichloromethyl-S-triazine; and compounds as described in German Patent No. 3,337,024, such as the following compounds.

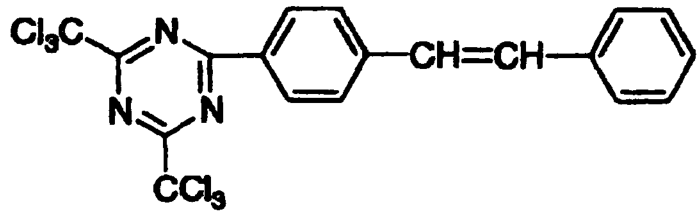

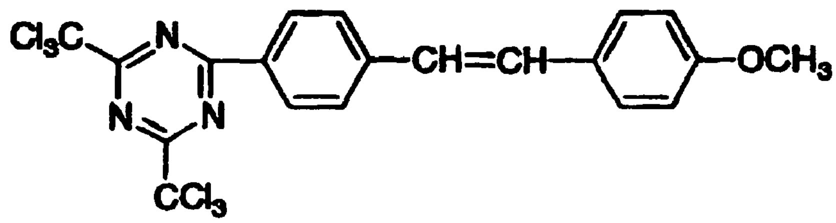

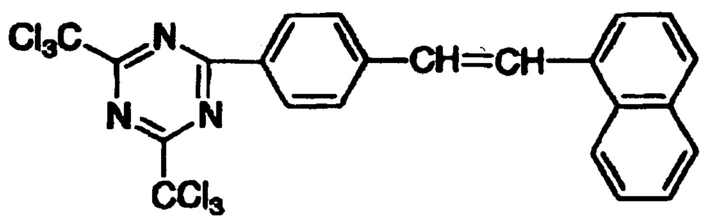

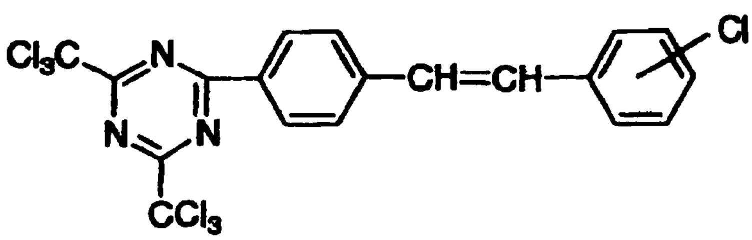

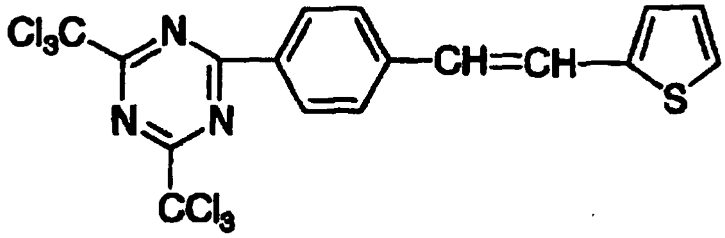

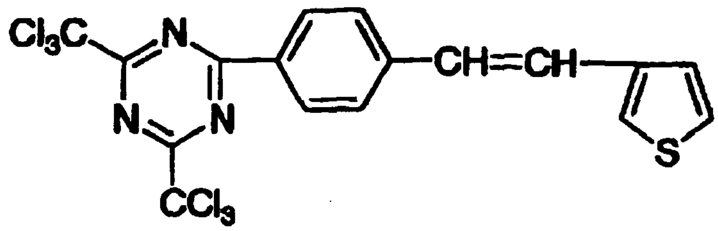

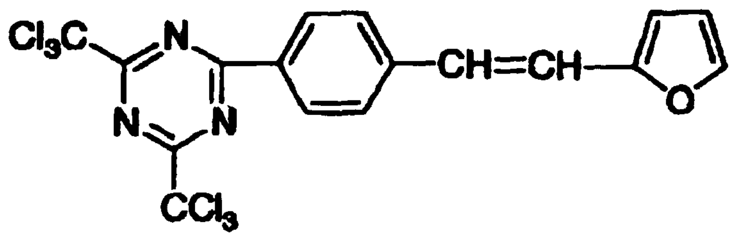

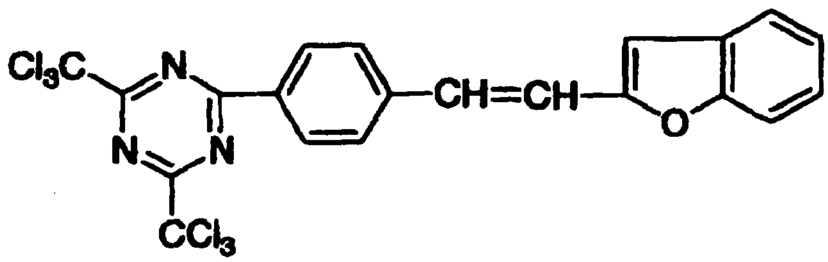

Furthermore, there can be enumerated compounds as described in F.C. Schaefer, et al., J. Org. Chem., 29, 1527 (1964), such as 2-methyl-4,6-bis(tribromomethyl)-S-triazine, 2,4,6-tris(tribromomethyl)-S-triazine, 2,4,6-tris(dibromomethyl)-S-triazine, 2-amino-4-methyl-6-tribromomethyl-S-triazine, and 2-methoxy-4-methyl-6-trichloromethyl-S-triazine.

Moreover, there can be enumerated compounds as described in JP-A-62-58241, such as the following compounds.

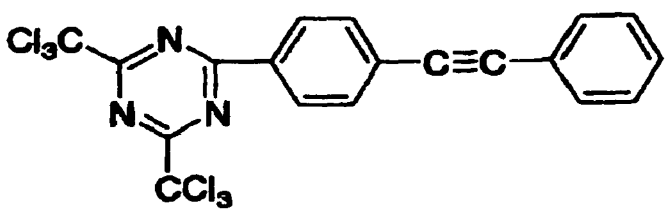

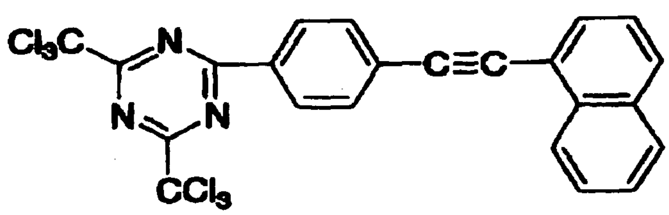

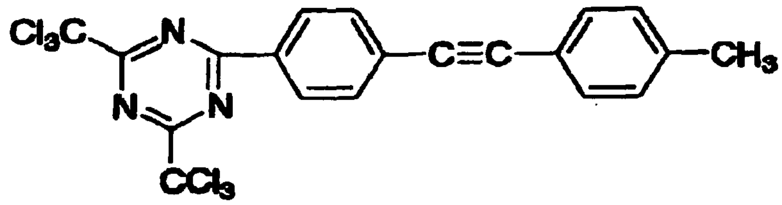

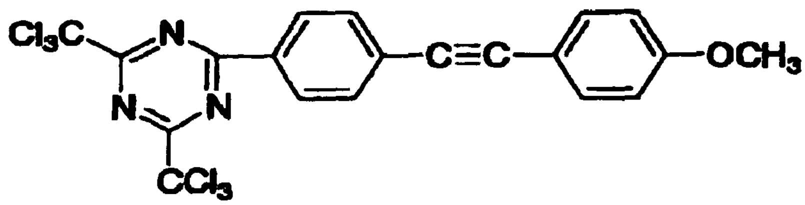

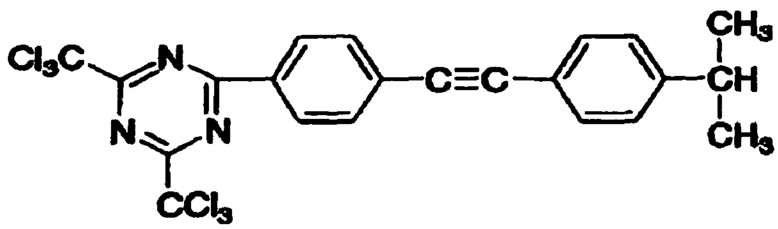

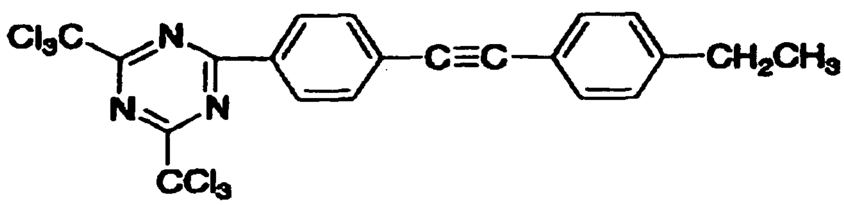

Moreover, there can be enumerated compounds as described in JP-A-5-281728, such as the following compounds.

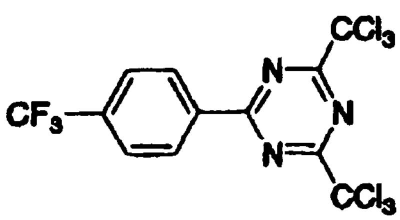

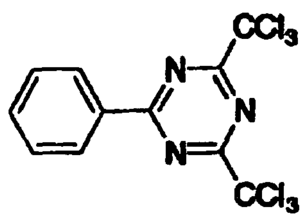

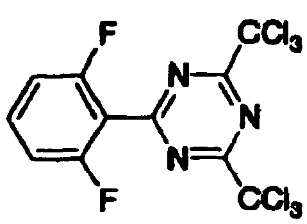

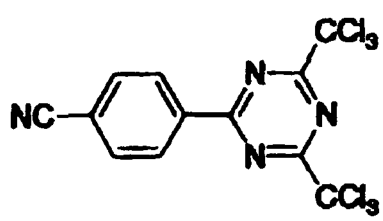

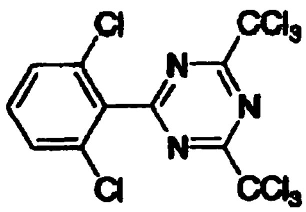

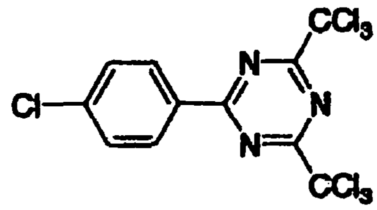

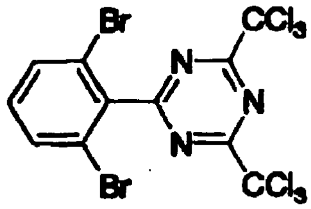

(2) Borate salt compounds:

A borate salt represented by the following formula [III] is excellent in radical generating ability.

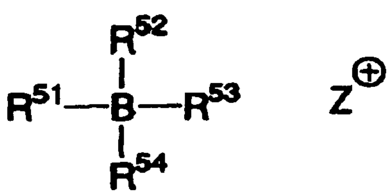

[III]

In the formula [III], $R^{51}$, $R^{52}$, $R^{53}$, and $R^{54}$ may be the same or different and each represents a substituted or unsubstituted alkyl group, a substituted or unsubstituted aryl group, a substituted or unsubstituted alkenyl group, a substituted or unsubstituted alkynyl group, or a substituted or unsubstituted heterocyclic group; and two or more groups of $R^{51}$, $R^{52}$, $R^{53}$ and $R^{54}$ may be taken together to form a cyclic structure, provided that at least one of $R^{51}$, $R^{52}$, $R^{53}$ and $R^{54}$ is a substituted or unsubstituted alkyl group. $Z^+$ represents an alkali metal cation or a quaternary ammonium cation.

The alkyl group represented by the foregoing $R^{51}$ to $R^{54}$ includes linear, branched or cyclic alkyl groups and preferably has from 1 to 18 carbon atoms. Specific examples thereof include methyl, ethyl, propyl, isopropyl, butyl, pentyl, hexyl, octyl, stearyl, cyclobutyl, cyclopentyl, and cyclohexyl. Furthermore, the substituted alkyl group includes the foregoing alkyl groups which, however, have, as a substituent, a halogen atom (for example, -Cl and -Br), a cyano group, a nitro group, an aryl group (preferably a phenyl group), a hydroxyl group, a group represented by the following formula:

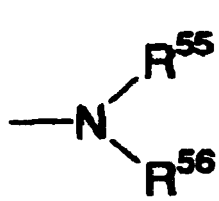

(wherein $R^{55}$ and $R^{56}$ each independently represents a hydrogen atom, an alkyl group having from 1 to 14 carbon atoms, or an aryl group), $-COOR^{57}$ (wherein $R^{57}$ represents a hydrogen atom, an alkyl group having from 1 to 14 carbon atoms, or an aryl group), or $-COOR^{58}$ or $-OR^{58}$ (wherein $R^{58}$ represents an alkyl group having from 1 to 14 carbon atoms or an aryl group).

The aryl group represented by the foregoing $R^{51}$ to $R^{54}$ includes monocyclic to tricyclic aryl groups such as a phenyl group and a naphthyl group; and the substituted aryl group includes the foregoing aryl groups which, however,

have, as a substituent, any one of the substituents as in the foregoing substituted alkyl group or an alkyl group having from 1 to 14 carbon atoms.

The alkenyl group represented by the foregoing $R^{51}$ to $R^{54}$ includes linear, branched or cyclic alkenyl groups having from 2 to 18 carbon atoms; and examples of the substituent of the substituted alkenyl group include the same substituents as enumerated as the substituent of the foregoing substituted alkyl group.

The alkynyl group represented by the foregoing $R^{51}$ to $R^{54}$ includes linear or branched alkynyl groups having from 2 to 28 carbon atoms; and examples of the substituent of the substituted alkynyl group include the same substituents as enumerated as the substituent of the foregoing substituted alkyl group.

Furthermore, examples of the heterocyclic group represented by the foregoing $R^{51}$ to $R^{54}$ include five or more membered rings containing at least one of N, S and O. Of these, 5-membered to 7-membered heterocyclic groups are preferable. The heterocyclic ring may contain a fused ring. The heterocyclic group may further have, as a substituent, the same substituent as enumerated as the substituent of the foregoing substituted aryl group.

Specific examples of the compound represented by the formula [III] include compounds as described in U.S. Patents Nos. 3,567,453 and 4,343,891 and European Patents Nos. 109,772 and 109,773 and the following compounds.

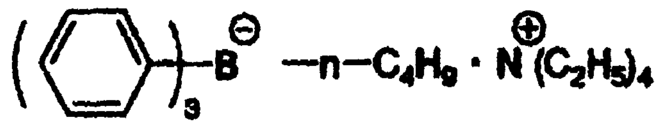

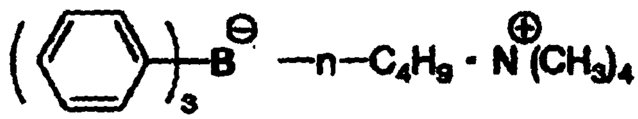

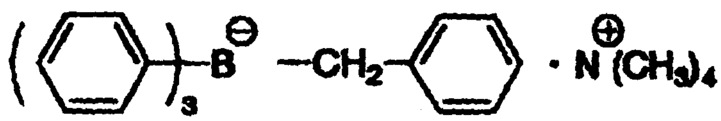

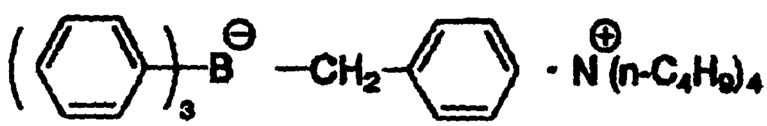

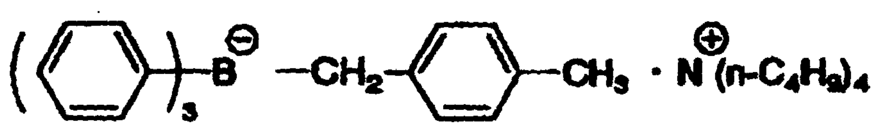

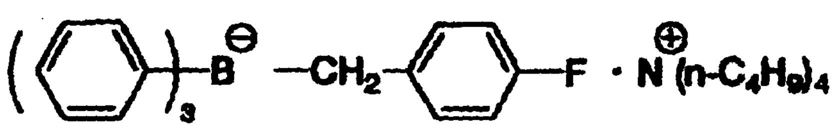

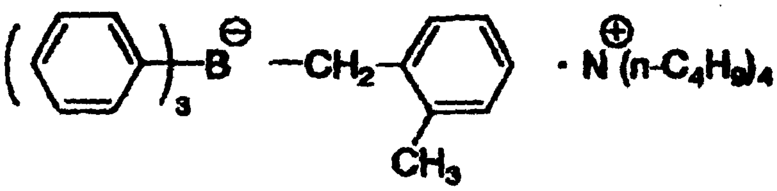

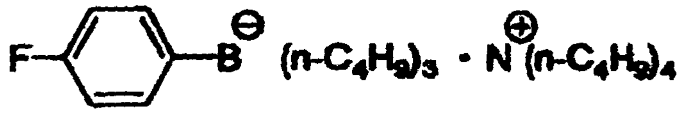

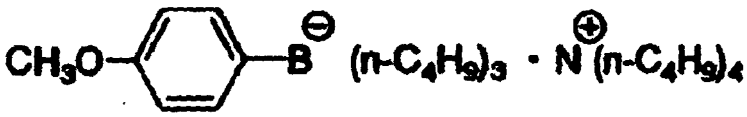

(3) Hexaaryl biimidazoles:

Hexaaryl biimidazoles can generate a radical having excellent stability and high sensitivity. Specific examples thereof include 2,2'-bis(o-chlorophenyl)-4,4', 5, 5'-tetraphenyl biimidazole, 2,2'-bis(o-bromophenyl)-4,4',5,5'-tetraphenyl biimidazole, 2,2'-bis(o,p-dichlorophenyl)-4,4',5,5'-tetraphenyl biimidazole, 2,2'-bis(o-chlorophenyl)-4,4',5,5'-tetra-(m-methoxyphenyl) biimidazole, 2,2'-bis(o,o'-dichlorophenyl)-4,4',5,5'-tetraphenyl biimidazole, 2,2'-bis(o-nitrophenyl)-4,4',5,5'-tetraphenyl biimidazole, 2,2'-bis(o-methylphenyl)-4,4',5,5'-tetraphenyl biimidazole, and 2,2'-bis(o-trifluoromethylphenyl)-4,4',5,5'-tetraphenyl biimidazole.

(4) Onium salt compounds:

Onium compounds of an element belonging to the group 15(5B), 16(6B) or 17(7B) of the periodic table, specifically, N, P, As, Sb, Bi, O, S, Se, Te, or I are an initiating compound having excellent sensitivity. In particular, iodonium salts and sulfonium salts, especially diaryl iodonium and triaryl sulfonium salt compounds are extremely excellent from the viewpoints of both sensitivity and storage stability. These compounds can generate an acid and/or a radical, and use conditions thereof can be properly chosen and employed depending upon the intended purpose. Specific examples thereof include the following compounds.

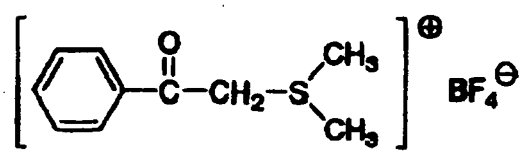

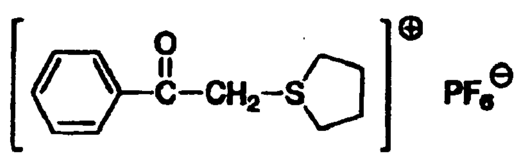

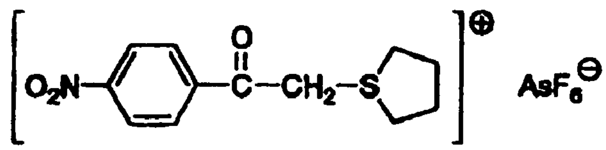

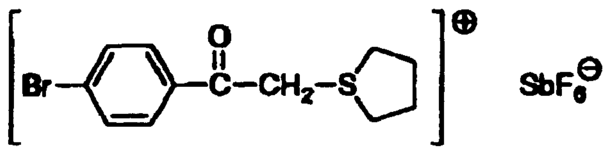

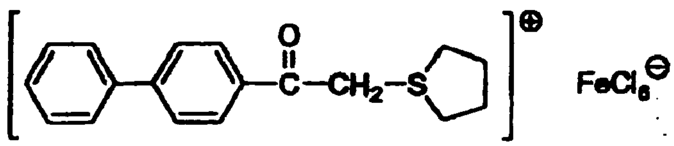

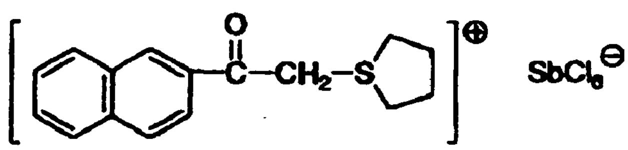

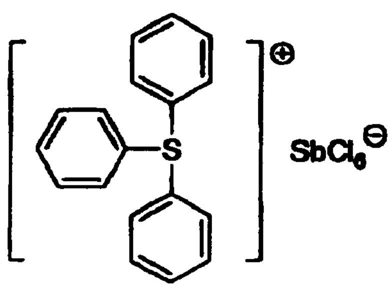

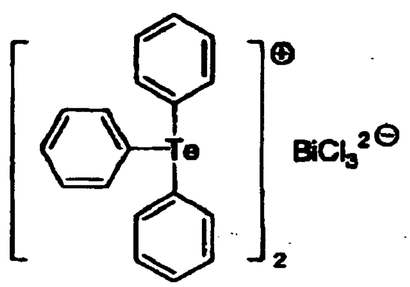

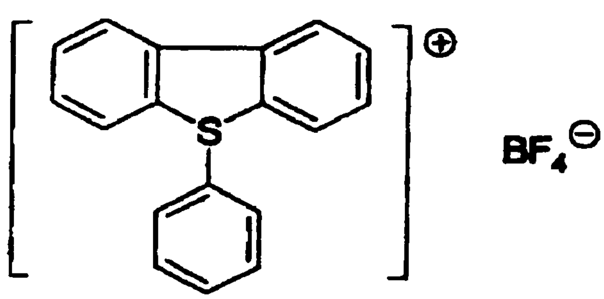

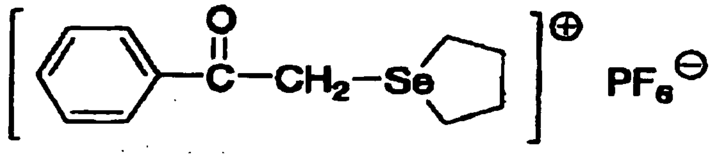

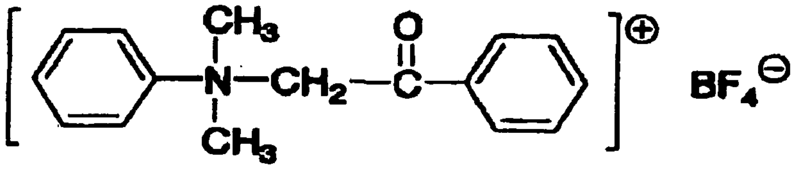

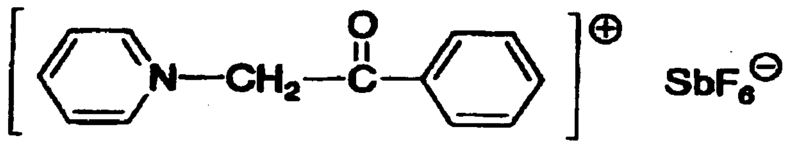

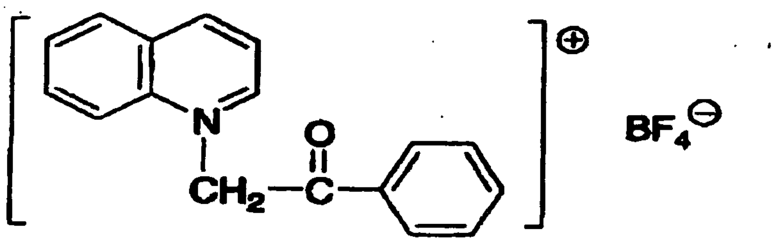

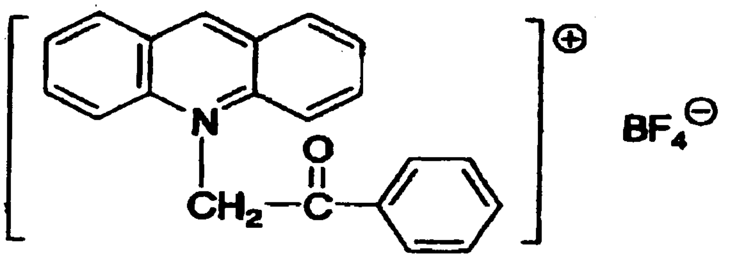

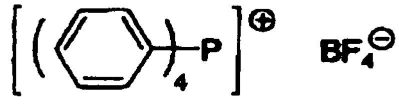

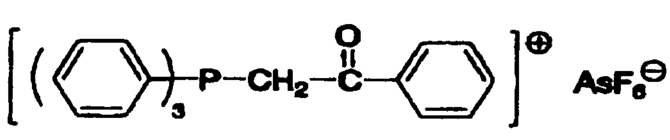

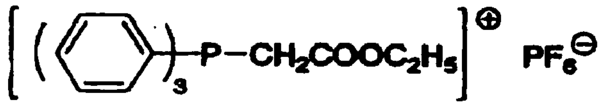

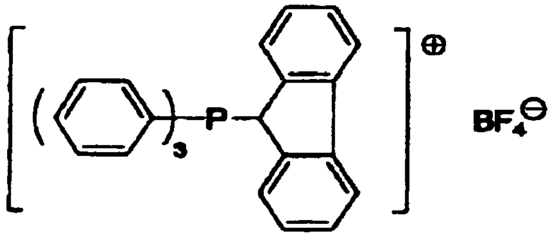

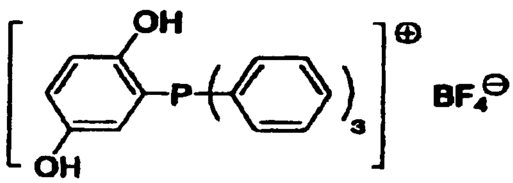

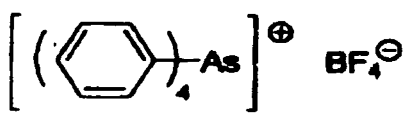

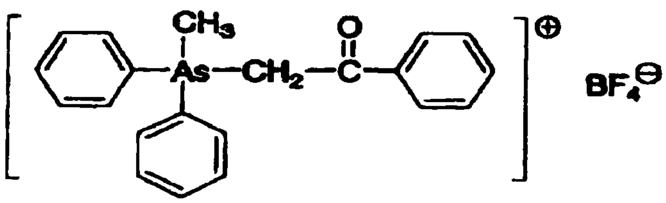

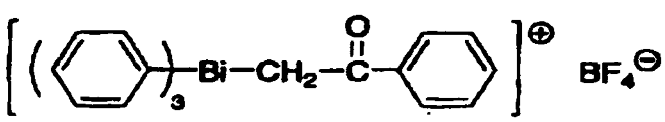

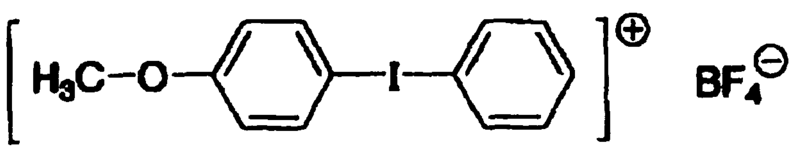

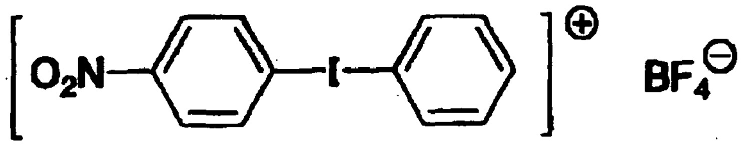

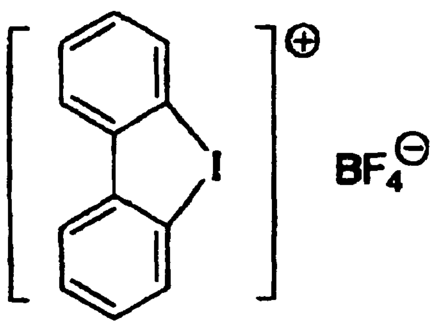

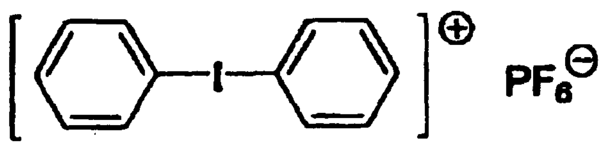

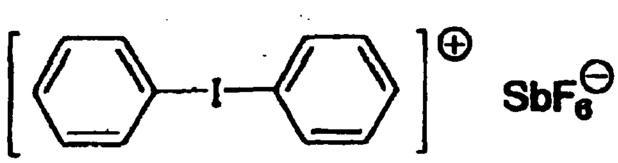

(5) Organic peroxides:

When an initiating compound of an organic peroxide type is used, it is possible to generate a radical as the active species with very high sensitivity.

The "organic peroxide" used in the invention includes almost all of organic compounds having at least one oxygen-oxygen bond in the molecule thereof. Examples thereof include methyl ethyl ketone peroxide, cyclohexanone peroxide, 3,3,5-trimethylcyclohexanone peroxide, methylcyclohexanone peroxide, acetylacetone peroxide, 1,1-bis(t-butylperoxy)-3,3,5-trimethylcyclohexane, 1,1-bis(t-butylperoxy)-cyclohexane, 2,2-bis(t-butylperoxy)butane, t-butyl hydroperoxide, cumene hydroperoxide, diisopropylbenzene hydroperoxide, p-methane hydroperoxide, 2,5-dimethylhexane-2,5-dihydroperoxide, 1,1,3,3-tetramethylbutyl hydroperoxide, di-t-butyl peroxide, t-butylcumyl peroxide, dicumyl peroxide, bis(t-butylperoxyisopropyl)benzene, 2,5-dimethyl-2,5-di(t-butylperoxy)hexane, 2,5-dimethyl-2,5-di(t-butylperoxy) hexyne-3, acetyl peroxide, isobutyryl peroxide, octanoyl peroxide, decanoyl peroxide, lauroyl peroxide, 3,5,5-trimethylhexanoyl peroxide, succinic acid peroxide, benzoyl peroxide, 2,4-dichlorobenzoyl peroxide, m-toluoyl peroxide, diisopropylperoxy dicarbonate, di-2-ethylhexylperoxy dicarbonate, di-2-ethoxyethylperoxy dicarbonate, dimethoxyisopropylperoxy carbonate, di(3-methyl-3-methoxybutyl)peroxy dicarbonate, t-butylperoxy acetate, t-butylperoxy pivalate, t-butylperoxy neodecanoate, t-butylperoxy octanoate, t-butylperoxy-3,5,5-trimethylhexanoate, t-butylperoxy laurate, t-butylperoxy benzoate, di-t-butylperoxy isophthalate, 2,5-dimethyl-2,5-di(benzoylperoxy)hexane, t-butyl permaleate, t-butylperoxyisopropyl carbonate, 3,3',4,4'-tetra(t-butylperoxycarbonyl)benzophenone, 3,3',4,4'-tetra-(t-amylperoxycarbonyl)benzophenone, 3,3',4,4'-tetra(t-hexylperoxycarbonyl)benzophenone, 3,3',4,4'-tetra(t-octylperoxycarbonyl)benzophenone, 3,3',4,4'-tetra(cumylperoxycarbonyl)benzophenone, 3,3',4,4'-tetra(p-isopropylcumylperoxycarbonyl)benzophenone, carbonyl di(t-butylperoxy dihydrogen diphthalate), and carbonyl di(t-hexylperoxy dihydrogen diphthalate).

Of these, peracid esters such as 3,3',4,4'-tetra(t-butylperoxycarbonyl)benzophenone, 3,3',4,4'-tetra(t-amylperoxycarbonyl)benzophenone, 3,3',4,4'-tetra(t-hexylperoxycarbonyl)benzophenone, 3,3',4,4'-tetra(t-octylperoxycarbonyl)benzophenone, 3,3',4,4'-tetra(cumylperoxycarbonyl)benzophenone, 3,3',4,4'-tetra(p-isopropylcumylperoxycarbonyl)benzophenone, and di-t-butylperoxy isophthalate are preferable.

As the preferred examples of the initiating compounds, a triazine compound and a hexaaryl- biimidazole compound are exemplified, and especially preferred initiating compound is a hexaarylbiimidazole compound.

Similarly to the foregoing sensitizing dyes, the initiating compounds can also be subjected to various chemical modifications for the purpose of the improvement of the characteristics of a photosensitive layer. For example, coupling with a sensitizing dye, with the parts of addition polymerizable unsaturated compounds and other initiating compounds, the introduction of a hydrophilic moiety, the improvement of compatibility, the introduction of a substituent for the prevention of crystal precipitation, the introduction of a substituent for the improvement of adhesion, and polymerization can be utilized.

Similarly to the foregoing sensitizing dyes, the usages of the initiating compounds can be arbitrarily determined according to the design of performance of the photosensitive material. For example, the compatibility with a photosensitive layer can be increased by the combined use of two or more.

The greater amount of the initiating compounds is generally advantageous in the point of sensitivity, and sufficient sensitivity can be obtained by the amount of preferably from 0.5 to 80 mass parts per 100 mass parts of the photosensitive layer components, and more preferably from 1 to 50 mass parts.

The photoinitiation systems comprising (A) a sensitizing dye and (B) an initiating compound are as described above, and in the combinations of a sensitizing dye and an initiating compound, a combination of a sensitizing dye represented by formula (4) and a hexaarylbiimidazole compound is preferred, and a combination of a sensitizing dye represented by formula (4) in which X is represented by $NR^9$ and a hexaarylbiimidazole compound is especially preferred.

(C) Polymerizable Compound

The third essential component (C) a polymerizable compound capable of reaction by at least any of a radical, an acid and a base in the photosensitive composition of the invention is a compound whose physical or chemical characteristics thereof change irreversibly due to an action of the active species as generated by photoreaction of the foregoing photoinitiation system, and thus curing reaction, coloration reaction or decoloration reaction etc. occur. As the polymerizable compound (C), arbitrary compounds having such properties can be used without particular limitations. For example, in many cases, the polymerizable compounds as enumerated in the foregoing initiation system have such properties themselves. The characteristics of the polymerizable compound (C) which change due to the radical or acid and/or base as generated from the photoinitiation system include, for example, changes in molecular physical properties (for example, absorption spectrum (color), chemical structure, and polarizability) and material physical properties (for example, solubility, strength, refractive index, fluidity, and stickiness).

For example, when an acid or a base is generated from the initiation system by using, as the polymerizable compound (C), a compound whose absorption spectrum changes due to pH such as a pH indicator, it is possible to change the hue only in the exposed area. Such a composition is useful as an image forming material. Similarly, in the case of using, as the polymerizable compound (C), a compound whose absorption spectrum changes due to oxidation and reduction or nucleic addition reaction, it is possible to cause oxidation, reduction, etc. due to a radical as generated from the initiation system, thereby forming an image. Such examples are disclosed in, for example, J. Am. Chem. Soc., 108, 128 (1986), J. Imaging. Sci., 30, 215 (1986), and Israel. J. Chem., 25, 264 (1986).

Furthermore, by using, as the polymerizable compound (C), a compound which can be subjected to addition polymerization or poly condensation and combining it with the initiation system, it is possible to form a photocurable resin or a negative working photopolymer. In addition, such a composition are useful for a negative working photosensitive layer of lithographic printing plate precursors.

As the polymerizable compound (C), there are used radical polymerizable compounds (for example, ethylenically unsaturated double bond-containing compounds), cationic polymerizable compounds (for example, epoxy compounds, vinyl ether compounds, and methylol compounds), and anionic polymerizable compounds (for example, epoxy compounds). Such examples are described in, for example, Conference of Photopolymer Science and Technology Ed., Photopolymer Handbook, published by Kogyo Chosakai Publishing Inc. (1989) and Kobunshi, 45, 786 (1996). Furthermore, compositions comprising a combination of a thiol compound as the polymerizable compound (C) with a photo radical generation system are well known.

It is also useful to use an acid decomposable compound as the polymerizable compound (C) and combine it with a photo acid generator. For example, materials in which a polymer whose side chain or principal chain is decomposed by an acid is used, thereby changing solubility, hydrophilicity, hydrophobicity, etc. by light are put into practical use widely as a photo decomposition type photosensitive resin or a positive working photopolymer. Specific examples thereof are described in, for example, ACS. Symp. Ser., 242, 11 (1984), JP-A-60-3625, U.S. Patents Nos. 5,102,771, 5,206,317 and 5,212,047, JP-A-4-26850, JP-A-3-192173, JP-A-60-10247, and JP-A-62-40450.

The addition polymerizable compound which is the polymerizable compound (C) which is especially excellent for the purpose for obtaining a high-density lithographic printing plate as one of the objects of the photosensitive composition of the invention will be described below in more detail.

(C-1) Addition polymerizable compound:

The addition polymerizable compound having at least one ethylenically unsaturated double bond which is preferable as the polymerizable compound (C) to be used in the invention is selected from compounds having at least one, and preferably two or more terminal ethylenically unsaturated double bonds. Such compound groups are broadly known in the subject industrial field and can be used in the invention without particular limitations. Such a compound has a chemical morphology such as monomers and prepolymers, namely dimers, trimers and oligomers, or mixtures thereof, and copolymers thereof. Examples of monomers and copolymers thereof include unsaturated carboxylic acids (for example, acrylic acid, methacrylic acid, itaconic acid, crotonic acid, isocrotonic acid, and maleic acid) and esters and amides thereof Above all, esters between an unsaturated carboxylic acid and an aliphatic polyhydric alcohol and amides between an unsaturated carboxylic acid and an aliphatic polyhydric amine compound are preferably used. Furthermore, addition reaction products between an unsaturated carboxylic acid ester or amide having a nucleic substituent (for example, a hydroxyl group, an amino group, and a mercapto group) and a monofunctional or polyfunctional isocyanate or epoxy and dehydration condensation reaction products between the foregoing unsaturated carboxylic acid ester or amide and a monofunctional or polyfunctional carboxylic acid are also suitably used. Further, addition reaction products between an unsaturated carboxylic acid ester or amide having an electrophilic substituent (for example, an isocyanate group and an epoxy group) and a monofunctional or polyfunctional alcohol, amine or thiol and substitution reaction products between an unsaturated carboxylic acid ester or amide having an eliminating substituent (for example, a halogen group and a tosyloxy group) and a monofunctional or polyfunctional alcohol, amine or thiol are also suitable. Furthermore, as another example, compound groups resulting from substitution of the foregoing unsaturated carboxylic acid with an unsaturated phosphonic acid, styrene, vinyl ether, etc. can be used.

With respect to specific examples of the monomer of the ester between an aliphatic polyhydric alcohol compound and an unsaturated carboxylic acid, examples of acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)pheny]dimethylmethane, and bis[p-(methacryloxyethoxy)phenyl]dimethylmethane.

Examples of itaconic esters include ethylene glycol diitaconate, propylene glycol diitaconate, 1,3-butanediol diitaconate, 1,4-butanediol diitaconate, tetraethylene glycol diitaconate, pentaerythritol diitaconate, and sorbitol tetraitaconate.

Examples of crotonic esters include ethylene glycol dicrotonate, tetramethylene glycol dicrotonate, pentaerythritol dicrotonate, and sorbitol tetradicrotonate.

Examples of isocrotonic esters include ethylene glycol diisocrotonate, pentaerythritol diisocrotonate, and sorbitol tetraisocrotonate.

Examples of maleic esters include ethylene glycol dimaleate, triethylene glycol dimaleate, pentaerythritol dimaleate, and sorbitol tetramaleate.

As examples of other esters, aliphatic alcohol based esters as described in JP-B-46-27926, JP-B-51-47334, and JP-A-57-196231; esters having an aromatic based skeleton as described in JP-A-59-5240, JP-A-59-5241, and JP-A-2-226149: and amino group-containing esters as described in JP-A-1-165613 are also suitably used.

Furthermore, the foregoing ester monomers can be used as a mixture.

Furthermore, specific examples of the monomer of the amide between an aliphatic polyhydric amine compound and an unsaturated carboxylic acid include methylene bis-acrylamide, methylene bis-methacrylamide, 1,6-hexamethylene bis-acrylamide, 1,6-hexamethylene bis-methacrylamide, diethylenetriamine trisacrylamide, xylylene bisacrylamdie, and xylylene bismethacrylamide.

As other examples of the preferred amide-based monomer, ones having a cyclohexylene structure as described in JP-B-54-21726 can be enumerated.

Furthermore, urethane based addition polymerizable compounds which are produced by using an addition reaction between an isocyanate and a hydroxyl group are also suitable. Specific examples thereof include vinyl urethane compounds containing two or more polymerizable vinyl groups in one molecule, which are obtainable by adding a hydroxyl group-containing vinyl monomer represented by the following formula (V) to a polyisocyanate compound containing two or more isocyanate groups in one molecule, as described in JP-B-48-41708.

$$CH_2=C(R)COOCH_2CH(R')OH \qquad (V)$$

In the formula, R and R' each independently represents H or $CH_3$.

Furthermore, urethane acrylates as described in JP-A-51-37193, JP-B-2-32293, and JP-B-2-16765; and urethane compounds having an ethylene oxide based skeleton as described in JP-B-58-49860, JP-B-56-17654, JP-B-62-39417, and JP-B-62-39418 are also suitable.

Moreover, it is possible to obtain a photosensitive composition having very excellent photosensitive speed by using an addition polymerizable compound having an amino structure or a sulfide structure in the molecule thereof as described in JP-A-63-277653, JP-A-63-260909, and JP-A-1-105238.

As other examples, there can be enumerated polyester acrylates and polyfunctional acrylates or methacrylates of an epoxy acrylate obtainable by reacting an epoxy resin with (meth)acrylic acid, as described in JP- A- 48-64183, JP-B-49-43191, and JP-B-52-30490. There can be also enumerated specific unsaturated compounds as described in JP-B-46-43946, JP-B-1-40337, and JP-B-1-40336; and vinyl phosphonic acid based compounds as described in JP-A-2-25493. In some case, there are suitably used structures containing a perfluoroalkyl group as described in JP- A-61-22048. Photocurable monomers and oligomers as introduced in Journal of the Adhesion Society of Japan, Vol. 20, No. 7, pages 300 to 308 (1984) can also be used.

With respect to these addition polymerizable compounds, details of the use method regarding what structure should be used, whether the addition polymerizable compound should be used singly or jointly, and what addition amount should be employed can be arbitrarily set up adaptive with the design of the ultimate performance of the lithographic printing plate precursor. For example, the addition polymerizable compound is chosen from the following viewpoints. With respect to the photosensitive speed, a structure having a high content of an unsaturated group per molecule is preferable, and in many cases, bifunctional or polyfunctional compounds are preferable. For the purpose of increasing the strength of an image area, namely a cured film, trifunctional or polyfunctional compounds are preferable. Furthermore, a method for regulating both the photosensitivity and the strength by jointly using compounds having a different functionality and a different polymerizable group (for example, acrylic esters, methacrylic esters, styrene based compounds, and vinyl ether based compounds) is effective. There may be the case where while a compound having a high molecular weight or a compound having high hydrophobicity is excellent in the photosensitive speed and film strength, it is not preferable in view of the development speed and deposition in a developing solution. Furthermore, a method for choosing and using the addition polymerizable compound is an important factor with respect to compatibility and dispersibility with other components in the photosensitive layer (for example, a binder polymer, an initiator, and a colorant). For example, the compatibility is possibly enhanced by using a low-purity compound or by jointly using two or more kinds of compounds. Moreover, for the purpose of enhancing adhesion to a support, an overcoat layer, etc., a specific structure may be selected. With respect to the blending ratio of the addition polymerizable compound in the photosensitive layer, it is advantageous in view of the sensitivity that the blending ratio is high. However, when the blending ratio is too high, there are possibly caused problems such as occurrence of undesired phase separation, problems in the production step due to tackiness of the photosensitive layer (for example, transfer of photographic material components and production failure derived from the tackiness), and deposition from the developing solution. From these viewpoints, in many cases, the blending ratio of the addition polymerizable compound is from 5 to 80 % by mass, and preferably from 25 to 75 % by mass based on the whole of components of the composition. These addition polymerizable compounds may be used singly or in admixture of two or more kinds thereof. Besides, with respect to the use method of the addition polymerizable compound, adequate structure, blending and addition amount can be arbitrarily chosen from the viewpoints of a degree of polymerization hindrance against oxygen, a resolution, fogging properties, a change of refractive index, surface tackiness, etc. According to circumstances, a layer construction and a coating method such as undercoating and top coating may be employed.

When compounds other than addition polymerizable compound (C-1) are used as polymerizable compound (C), the optimal addition amount can be optionally selected according to the objective characteristic change or the compound to be used, but the amount is generally preferably from 10 to 80 mass% or so in all the solids content of the composition when a compound whose absorption spectrum changes by oxidation reduction and nucleophilic addition reaction.

(D) Binder Polymer

When the photosensitive composition in the invention is applied to the photosensitive layer of a lithographic printing plate precursor, which is a preferred embodiment of the invention, it is preferred for the photosensitive composition to further contain a binder polymer.

As the binder polymer, linear organic high molecular polymers are preferably used. Any compound can be used as such "linear organic high molecular polymers", but water or weak alkali water-soluble or swelling linear organic high molecular polymers capable of water development or weak alkali water development are preferably selected. Linear organic high molecular polymers are selected and used not only as a film-forming agent of the composition but according to the purpose as a water developer, a weak alkali water developer or an organic solvent developer. For example, when water- soluble organic high molecular polymers are used, water development becomes possible. As such linear organic high molecular polymers, addition polymers having a carboxylic acid group on the side chain, e.g., the polymers disclosed in JP-A-59-44615, JP-B-54-34327, JP-B-58-12577, JP-B-54-25957, JP-A-54-92723, JP-A-59-53836 and JP-A-59-71048, i.e., a methacrylic acid copolymer, an acrylic acid copolymer, an itaconic acid copolymer, a crotonic acid copolymer, a maleic acid copolymer, and a partially esterified maleic acid copolymer can be exemplified. Acidic cellulose derivatives having a carboxylic acid group on the side chain can also be used. Besides the above, the polymers obtained by adding a cyclic acid anhydride to an addition polymer having a hydroxyl group are also useful.

Of these, copolymers of [benzyl (meth)acrylate/(meth)acrylic acid/optionally other addition polymerizable vinyl monomer] and copolymers of [allyl (meth)-acrylate/(meth)acrylic acid/optionally other addition polymerizable vinyl monomer] are especially suitable because they are excellent in balance among the film strength, the sensitivity and the developability.

Furthermore, acid group-containing urethane based binder polymers as described in JP-B-7-120040, JP-B-7-120041, JP-B-7-120042, JP-B-8-12424, JP-A-63-287944, JP-A-63-287947, JP-A-1-271741, and Japanese Patent application No.10-116232 are advantageous in view of printing resistance and low-exposure aptitude because they are very excellent in strength.

Moreover, amide group-containing binders as described in JP-A-11-171907 are suitable because they have both excellent developability and film strength.

Additionally, polyvinylpyrrolidone, polyethylene oxide, and the like are useful as the water-soluble linear organic polymer. Furthermore, for the purpose of increasing the strength of the cured film, alcohol-soluble nylons, polyethers between 2,2-bis-(4-hydroxyphenyl)-propane and epichlorohydrin, and the like are also useful. Such a linear organic polymer can be mixed in an arbitrary amount in the entire composition. However, when the amount of the linear organic polymer exceeds 90 % by mass, there are not given preferred results from the standpoints of the strength of an image to be formed and the like. The amount is preferably from 30 to 85 % by mass. Furthermore, it is preferable that a mass ratio of the photopolymerizable ethylenically unsaturated double bond-containing compound to the linear organic polymer is in the range of from 1/9 to 7/3. In a preferred embodiment, a binder polymer which is substantially insoluble in water and soluble in alkalis is used. In this way, it is possible to use a developing solution free from an organic solvent which is not preferred from the environmental standpoint, or to limit the amount of an organic solvent to a very small level. In such a use method, an acid value of the binder polymer (the content of an acid per gram of the polymer as expressed in terms of the chemical equivalent number) and a molecular weight of the binder polymer are properly selected from the viewpoints of image strength and developability. The acid value is preferably in the range of from 0.4 to 3.0 meq/g; and the mass average molecular weight is preferably in the range of from 3,000 to 500,000. The acid value is more preferably in the range of from 0.6 to 2.0 meq/g; and the molecular weight is more preferably in the range of from 10,000 to 300,000.

(E) Other components

In the photosensitive composition of the invention, other components suitable for the application, production process, and the like can be further properly added. Preferred additives will be enumerated below.

(E-1) Cosensitizer:

By using a certain kind of an additive (hereinafter referred to as "cosensitizer"), it is possible to further enhance the sensitivity. While these action mechanisms thereof are not always elucidated yet, it may be considered that the majority thereof is based on the following chemical process. That is, it is assumed that a variety of intermediate active species (for example, radicals, peroxides, oxidizing agents, and reducing agents) as generated during the photoreaction which is started due to light absorption of the foregoing photoinitiation system and the subsequently occurred addition polymerization reaction react with the cosensitizer to generate a new active radical. The cosensitizer is roughly classified into (a) a compound capable of generating an active radical upon reduction, (b) a compound capable of generating an

active radical upon oxidation, and (c) a compound which is to react with a radical having low activity, whereby it is converted into a radical having higher activity or acts as a chain transfer agent. However, in many case, there is no commonly accepted theory on what class the individual compound belongs to.

(a) Compound capable of generating an active radical upon reduction:

Compounds having a carbon-halogen bond: It is considered that a carbon-halogen bond is reductively cleaved to generate an active radical. Specifically, for example, trihalomethyl-s-triazines and trihalomethyl oxadiazoles can be suitably used.

Compounds having a nitrogen-nitrogen bond: It is considered that a nitrogen-nitrogen bond is reductively cleaved to generate an active radical. Specifically, for example, hexaaryl biimidazoles are suitably used.

Compounds having an oxygen-oxygen bond: It is considered that an oxygen-oxygen bond is reductively cleaved to generate an active radical. Specifically, for example, organic peroxides are suitably used.

Onium compounds: It is considered that a nitrogen-hetero bond or an oxygen-nitrogen bond is reductively cleaved to generate an active radical. Specifically, for example, diaryl iodonium salts, triaryl sulfonium salts, and N-alkoxypyridium (azinium) salts are suitably used.

Ferrocene and iron-allene complexes: An active radical can be reductively generated.

(b) Compound capable of generating an active radical upon oxidation:

Alkylate complexes: It is considered that a carbon-hetero bond is oxidatively cleaved to generate an active radical. Specifically, for example, triarylalkyl borates are suitably used.

Alkylamine compounds: It is considered that a C-X bond on the carbon adjacent to nitrogen is cleaved due to oxidation to generate an active radical. X is suitably a hydrogen atom, a carboxyl group, a trimethylsilyl group, a benzyl group, etc. Specific examples of the alkylamine compound include ethanolamines, N-phenylglycines, and N-trimethylsilylmethylanilines.

Sulfur-containing and tin-containing compounds: Ones resulting from substitution of the nitrogen atom of the foregoing amine with a sulfur atom or a tin atom can generate an active radical due to a similar action. It is also known that a compound having an S-S bond causes sensitization due to S-S cleavage.

α-Substituted methylcarbonyl compounds: An active radical can be generated due to bond cleavage between carbonyl and α-carbon upon oxidation. Ones resulting from conversion of the carbonyl into oxime ether exhibit a similar action. Specific examples of the compound include 2-alkyl-1-[4-(alkylthio)phenyl]-2-morpholinopropanone-1 compounds and oxime ethers obtained by reacting such a compound with a hydroxylamine and then etherifying the N-OH.

Sulfinic acid salts: An active radical can be reductively generated. Specific examples thereof include sodium arylsulfinates.

(c) Compound which is to react with a radical, whereby it is converted into a radical having higher activity or acts as a chain transfer agent:

For example, compound groups having SH, PH, SiH, or GeH in the molecule thereof are used. These compounds can generate a radical by providing a radical species having low activity with hydrogen, or can generate a radical upon oxidation and then proton elimination. Specifically, there are enumerated 2-mercaptobenzthiazoles, 2-mercaptobenzoxazoles and 2-mercaptobenzimidazoles etc.

A number of more specific examples of the cosensitizer are described as additives for the purpose of enhancing the sensitivity in, for example, JP-A-9-236913. A part of such specific examples will be given below, but it should not be construed that the invention is limited thereto. Incidentally, -TMS represents a trimethylsilyl group.

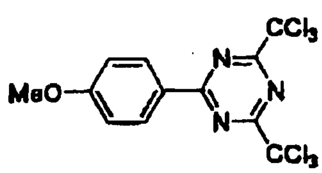 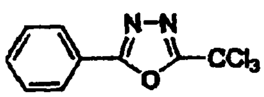 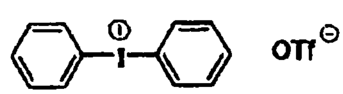

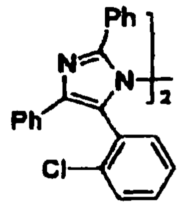
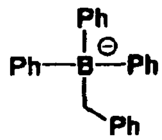
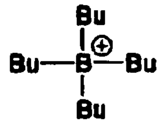
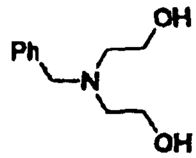

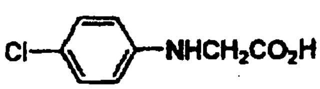
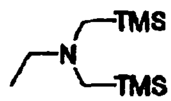
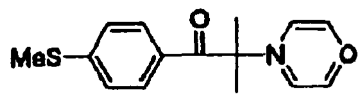

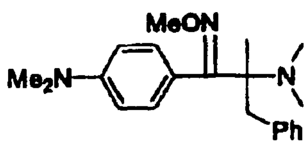
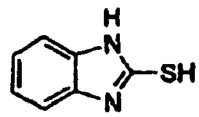

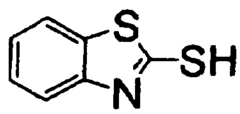

Likewise the preceding sensitizing dye, with respect to the cosensitizer, it is also possible to carry out various chemical modifications for the purpose of further improving characteristics of the photosensitive layer. For example, there can be applied methods such as coupling with the sensitizing dye and the initiating compound and an addition polymerizable unsaturated compound and other part, introduction of a hydrophilic site, enhancement of compatibility, introduction of a substituent for the purpose of suppressing the deposition of crystal, introduction of a substituent for the purpose of enhancing adhesion, and polymerization.

The cosensitizer can be used singly or in combination of two or more kinds thereof. An amount of the cosensitizer to be used is in the range of from 0.05 to 100 parts by mass, preferably from 1 to 80 parts by mass, and more preferably from 3 to 50 parts based on 100 parts by mass of the polymerizable compound.

(E-2) Polymerization inhibitor:

In the invention, in addition to the foregoing basic components, it is desired to add a small amount of a thermal polymerization inhibitor during the production or storage of the photosensitive composition for the purpose of preventing unnecessary thermal polymerization of the polymerizable compound from occurring. Examples of a suitable thermal polymerization inhibitor include hydroquinone, p-methoxyphenol, di-t-butyl-p-cresol, pyrogallol, t-butyl chatecol, benzoquinone, 4,4'-thiobis(3-methyl-6-t-butylphenol), 2,2'-methylenebis(4-methyl-6-t-butylphenol), and N-nitrosophenylhydroxylamine cerous salt. An amount of the thermal polymerization inhibitor to be added is preferably from about 0.01 % by mass to about 5 % by mass based on the weight of the entire composition. Furthermore, if desired, for the purpose of preventing polymerization hindrance due to oxygen, a higher fatty acid derivative such as behenic acid and behenic amide may be added, thereby unevenly distributing it on the surface of the photosensitive layer during a drying step to be carried out after coating to the support in case of lithographic printing plate precursors. An amount of the higher fatty acid derivative to be added is preferably from about 0.5 % by mass to about 10 % by mass of the entire composition.

(E-3) Colorant, etc.

When the photosensitive composition of the invention is used as the photosensitive layer of a lithographic printing plate precursor, a dye or a pigment may be added thereto for the purpose of coloring the photosensitive layer. The so- called plate-inspection property, e.g., visibility as the printing plate after plate making, and the aptitude to an image densitometer can be improved due to the addition of colorants. Since many of dyes are liable to reduce the sensitivity of a photosensitive layer, the use of pigments is especially preferred as the colorant. The specific examples of the colorants include, e.g., pigments such as phthalocyanine pigments, azo pigments, carbon black and titanium oxide, and dyes such as Ethyl Violet, Crystal Violet, azo dyes, anthraquinone dyes and cyanine dyes. The addition amount of dyes and pigments is preferably from about 0.5 mass% to about 5 mass% based on the entire composition.

(E-4) Other Additives

When the photosensitive composition of the invention is used in a lithographic printing plate precursor, the photosensitive composition may further contain well-known additives such as inorganic fillers for improving the physical properties of the cured film, in addition, plasticizers, sensitizing agents capable of improving the ink adhering property of the photosensitive layer surface.

Examples of the plasticizer include dioctyl phthalate, didodecyl phthalate, triethylene glycol dicaprylate, dimethyl glycol phthalate, tricresyl phosphate, dioctyl adipate, dibutyl sebacate, and triacetyl glycerin. When a binder is used, it can be added in an amount of not more than 10 % by mass based on the total weight of the polymerizable compound and the binder.

Furthermore, in order to strength heating and exposure effects after the development for the purpose of enhancing the film strength (printing resistance), it is also possible to add UV initiators, thermal crosslinking agents, and the like.

Besides, it is possible to add an additive or provide an interlayer for the purpose of enhancing the adhesion of the photosensitive layer to the support or increasing development eliminating properties of an unexposed photosensitive layer. For example, by adding or undercoating a compound having a relatively strong mutual action with a substrate, such as compounds having a diazonium structure and phosphonic compounds, it is possible to enhance the adhesion or increase the printing resistance. On the other hand, by adding or undercoating a hydrophilic polymer such as polyacrylic acid and polysulfonic acid, it is possible to enhance developability of an non-image area or enhance staining resistance.

In coating the photosensitive composition of the invention on a support to produce lithographic printing plate precursors, it is dissolved in a variety of organic solvents and then provided for use. Examples of the solvent which is used herein include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxyethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate, and ethyl lactate. These solvents can be used singly or in admixture. A concentration of solids in the coating solution is suitably from 2 to 50 % by mass.

The coating amount of the photosensitive layer on the support possibly influences mainly sensitivity of the photosensitive layer, developability, and strength and printing resistance of the exposed film. It is desired that the coating amount is adequately chosen depending upon the application. When the coating amount is too low, the printing resistance becomes insufficient. On the other hand, when it is too high, not only the sensitivity is lowered and it takes a long period of time for the exposure, but also it takes a longer period of time for the development treatment, and therefore, such is not preferable. For a lithographic printing plate for scan exposure which is the preferred embodiment of the invention, the coating amount is suitably in the range of from about 0.1 g/m2 to about 10 $g/m^2$ in terms of the weight after drying. The coating amount is more preferably from 0.5 to 5 $g/m^2$.

When the photosensitive composition of the invention is used as the photosensitive layer of lithographic printing plate precursors, from the viewpoints of sensitivity and preservation stability, the initiation system combining a compound represented by any of formulae (1) to (4) as the sensitizing dye, and a hexaarylbiimidazole compound as the initiating compound is preferred, and the embodiment comprising the above initiation system composed of these compounds and addition polymerizable compound (C-1) is especially preferred.

Support:

For providing a lithographic printing plate precursor using the photosensitive composition of the invention, it is

preferred to provide a photosensitive layer on a hydrophilic surface support. Conventionally well-known hydrophilic supports used for a lithographic printing plate precursor can be used without any limitation. The supports to use are preferably plate-like supports having dimensional stability. For example, paper, paper laminated with plastics (e.g., polyethylene, polypropylene, polystyrene, etc.), a metal plate (e.g., aluminum, zinc, copper, etc.), a plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.) are exemplified. These may be mono-component sheets of resin films and metal plates, or may be laminates of two or more components, e.g., paper or plastic films laminated or deposited with the above metals, or may be laminates of different kinds of plastic films. The surfaces of these supports may be chemically or physically treated by well-known methods for providing hydrophilicity or the improvement of strength, if necessary.

In particular, as the preferred support, there are enumerated papers, polyester films, and aluminum plates. Of these, aluminum plates which have good dimensional stability, are relatively cheap and can provide a surface having excellent hydrophilicity and strength by a surface treatment as the need arises are especially preferable. Furthermore, a composite sheet having an aluminum sheet coupled on a polyethylene terephthalate film as described in JP- B-48-18327 is also preferable.

Examples of the preferred aluminum plate include pure aluminum plates and alloy plates containing aluminum as the major component and a slight amount of foreign elements. Plastic films having aluminum laminated or vapor deposited thereon are also employable. Examples of foreign elements which are contained in aluminum alloys include silicon, iron, manganese, copper, magnesium, chromium, zinc, bismuth, nickel, and titanium. The content of foreign elements in the alloy is at most 10 % by mass. While the aluminum which is especially suitable in the invention is pure aluminum, since it is difficult to produce completely pure aluminum according to the smelting technology, a slight amount of foreign elements may be contained. With respect to the aluminum plate which is applied in the invention in this way, its composition is not specified, and aluminum plates made of a raw material which has hitherto been publicly known and used can be properly utilized. The aluminum plate which is used in the invention is from about 0.1 mm to 0.6 mm, preferably from 0.15 mm to 0.4 mm, and especially preferably from 0.2 mm to 0.3 mm.

Moreover, in the case of a support having a surface of a metal, particularly aluminum, it is preferable that the support is subjected to a surface treatment such as a roughing (sand blasting) treatment, a dipping treatment in an aqueous solution of sodium silicate, potassium fluorozirconate, a phosphate, etc., and an anodic oxidation treatment.

Prior to roughing of the aluminum plate, if desired, degreasing treatment with for example surfactants, organic solvents or alkali solutions is conducted to remove the surface rolling oil.

The roughing treatment of the surface of the aluminum plate is carried out by a variety of methods. For example, the roughing treatment is carried out by a method for mechanically roughing the surface, a method for electrochemically dissolving and roughing the surface, or a method for selectively chemically dissolving the surface. As the mechanical method, there can be employed known methods such as a ball polishing method, a brush polishing method, a blast polishing method, and a buff polishing method. As the electrochemical roughing method, there is enumerated a method in which roughing is carried out in an electrolyic solution of hydrochloric acid, nitric acid, etc. by an alternating current or a direct current. A combination of both of these methods as disclosed in JP-A-54-63902 can also be utilized.

The thus surface-roughened aluminum plates can be subjected to anodizing treatment for increasing the water retentivity of the surface and abrasion resistance through alkali etching treatment and neutralization treatment, according to necessity.

As the electrolytes used in the anodizing treatment of an aluminum plate, various electrolytes can be used for forming a porous oxide film, generally sulfuric acid, phosphoric acid, oxalic acid, chromic acid, and mixed acids thereof are used. The concentration of electrolytes can be arbitrarily determined by the kinds of electrolytes.

Further, an aluminum plate subjected to immersion treatment in an aqueous sodium silicate solution after roughening treatment is preferably used. As disclosed in JP-B-47-5125, an aluminum plate immersion-treated in an aqueous solution of alkali metal silicate after anodizing treatment is preferably used. Anodizing treatment is carried out by turning on electricity with the aluminum plate as the anode in an electrolytic solution comprising alone or combination of two or more of an aqueous solution or nonaqueous solution of an inorganic acid such as phosphoric acid, chromic acid, sulfuric acid, boric acid, etc., or an organic acid such as oxalic acid, sulfamic acid, etc., or salts of these.

Silicate electrodeposition as disclosed in U.S. Patent 3,658,662 is also effective. Supports subjected to electrolytic graining as disclosed in JP-B-46-27481, JP-A-52-58602, and JP-A-52-30503, and surface treatment of combining the above anodizing treatment and sodium silicate treatment are also useful. Further, the technique disclosed in JP-A-56-28893 comprising performing mechanical surface roughening, chemical etching, electrolytic graining, anodizing treatment and sodium silicate treatment in order is also preferably used in the invention.

The support undercoated with water-soluble resins, e.g., polymers and copolymers having a polyvinyl phosphonic acid group, a sulfonic acid group on the side chain, polyacrylic acid, water-soluble metal salts (e.g., zinc borate), a yellow dye, amine salt, etc., after being subjected to the above treatments is also preferably used in the invention.

The support subjected to sol-gel treatment by which a functional group capable of causing addition polymerization by radicals is imparted by covalent bonding as disclosed in JP-A-7-159983 is also preferably used in the invention.

As other preferred examples, an arbitrary support having provided thereon a waterproof hydrophilic layer as a surface layer is exemplified. As such surface layers, e.g., a layer comprising an inorganic pigment and a binder disclosed in U.S. Patent 3,055,295 and JP-A-56-13168, a hydrophilic swelling layer disclosed in JP-A-9-80744, and a sol-gel film comprising titanium oxide, polyvinyl alcohol, and silicic acids disclosed in JP-A-8-507727 can be exemplified.

Such hydrophilizing treatment is performed not only for hydrophilizing the surface of a support but also for preventing harmful reaction of the photosensitive composition provided on the support and for improving adhesion property of the photosensitive layer.

Intermediate layer:

In the lithographic printing plate precursor in the invention, an intermediate layer may be provided for the purpose of improving the adhesion of a photosensitive layer and a support, and soiling resistance. As the specific examples of such intermediate layers, those disclosed in the following patents can be exemplified: JP-B-50-7481, JP-A-54-72104, JP-A-59-101651, JP-A-60-149491, JP-A-60- 232998, JP-A-3-56177, JP-A-4-282637, JP-A-5-16558, JP-A-5- 246171, JP-A-7-159983, JP-A-7-314937, JP-A-8-202025, JP-A-8- 320551, JP-A-9-34104, JP-A-9-236911, JP-A-9-269593, JP-A-10- 69092, JP-A-10-115931, JP-A-10-161317, JP-A-10-260536, JP-A-10-282682, JP-A-11-84674, JP-A-10-69092, JP-A-10-115931, JP-A-11-38635, JP-A-11-38629, JP-A-10-282645, JP-A-10-301262, JP-A-11-24277, JP-A-11-109641, JP-A-10-319600, JP-A-11-84674, JP-A-11-327152, JP-A-2000-10292, JP-A-2000-235254, JP-A-2000-352824, JP-A-2001-175001 and JP-A-2001-209170. Protective layer:

When the photosensitive composition of the invention is used in a lithographic printing plate precursor for scanning exposure, if necessary, a protective layer can be provided on a photosensitive layer containing a polymerizable compound. Exposure of such a lithographic printing plate precursor is in general performed in the air. The protective layer prevents oxygen in the air and low molecular compounds such as basic substances which hinder image-forming reaction caused by exposure in the photosensitive layer from mixing in the photosensitive layer and makes the exposure in the air possible. Accordingly, as the characteristics which are required of the protective layer, the protective layer preferably has low permeability of a low molecular compound such as oxygen, does not substantially hinder the transmission of light for exposure, has excellent adhesion with the photosensitive layer, and can be easily removed after exposure during development process.

Such contrivances have so far been tried and disclosed in detail in U. S. Patent 3,458,311 and JP-A-55-49729. As the materials for the protective layer, it is preferred to use water-soluble high molecular compounds comparatively excellent in crystallizability, specifically, water-soluble polymers, e.g., polyvinyl alcohol, polyvinyl pyrrolidone, acidic celluloses, gelatin, gum arabic, polyacrylic acid are known. Of these compounds, when polyvinyl alcohol is used as a main component, the best results can be obtained in fundamental characteristics such as exclusion of oxygen and removal of the protective layer by development. The polyvinyl alcohols for use in the protective layer may be partially substituted with ester, ether and acetal so long as they contain unsubstituted vinyl alcohol units for obtaining necessary oxygen-cutting off property and water solubility. Also, the part of the polyvinyl alcohols may have other copolymer components. Mixtures obtained by substituting polyvinyl alcohol with 15 to 50 mass% of polyvinyl pyrrolidone is especially preferred for preservation stability.

As the specific examples of polyvinyl alcohols, those having hydrolyzing rate of 71 to 100% and molecular weight of from 300 to 2,400 can be exemplified. Specifically, the examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (manufactured by Kuraray Co., Ltd.).

The components of the protective layer (the selection of PVA and the use of additives) and the coating amount are selected taking into consideration fogging characteristic, adhesion and scratch resistance besides the oxygen-excluding property and the removal by development. In general, the higher the hydrolyzing rate of the PVA used (the higher the content of the unsubstituted vinyl alcohol units in the protective layer) and the thicker the layer thickness, the higher becomes the oxygen excluding-property, thus advantageous in the sensitivity. However, too high an oxygen excluding-property results in generation of unnecessary polymerization reaction during manufacture and live storage, or generation of unnecessary fog and fattening of image lines at image exposure. The adhesion with the image area and scratch resistance are extremely important in treating a printing plate, i.e., when a hydrophilic layer comprising water-soluble polymers is laminated on a lipophilic layer, peeling off of the film due to insufficient adhesion is liable to occur, and the peeled part causes such a defect as film hardening failure by polymerization hindrance due to oxygen.

Various countermeasures have been proposed for improving the adhesion between the photosensitive layer and the protective layer. For example, sufficient adhesion property can be obtained by mixing from 20 to 60 mass% of

an acryl-based emulsion or a water-insoluble vinyl pyrrolidone/vinyl acetate copolymer to a hydrophilic polymer mainly comprising polyvinyl alcohol and laminating the resulting product on a polymer layer. Any of well-known techniques can be applied to the protective layer of the invention. The coating methods of these protective layers are disclosed in detail, e.g., in U.S. Patent 3,458,311 and JP-A-55-49729.

Another function can further be imparted to the protective layer. For instance, by adding colorants (water-soluble dyes, etc.) excellent in permeability to the light for exposure (e.g., from 760 to 1,200 nm in the case of infrared lasers), and capable of efficiently absorbing the light not concerning exposure, safelight aptitude can be further increased without causing the reduction of the sensitivity.

When a lithographic printing plate is made from a lithographic printing plate precursor comprising the photosensitive composition of the invention, an image is obtained in general by the later-described exposure process (image exposure), and then by removing the unexposed area of the photosensitive layer by a developing solution. As the preferred developing solutions for use in making the lithographic printing plate precursor of the photosensitive composition, the developing solution disclosed in JP-B-57- 7427 can be exemplified, e.g., aqueous solutions of inorganic alkali agents such as sodium silicate, potassium silicate, sodium hydroxide, potassium hydroxide, lithium hydroxide, tertiary sodium phosphate, secondary sodium phosphate, tertiary ammonium phosphate, secondary ammonium phosphate, sodium metasilicate, sodium bicarbonate, and aqueous ammonia, and organic alkali agents such as monoethanolamine and diethanolamine are preferably used. These inorganic or organic alkali agents are added so that the concentration of the alkali solution becomes from 0.1 to 10 mass%, preferably from 0.5 to 5 mass%.

The alkaline aqueous solution can contain, if necessary, a surfactant and an organic solvent, e.g., benzyl alcohol, 2-phenoxyethanol, 2-butoxyethanol, etc., in a small amount. For example, the compounds disclosed in U.S. Patents 3,375,171 and 3,615,480 can be exemplified.

Further, the developing solutions as disclosed in JP-A-50-26601, JP-A-58-54341, JP-B-56-39464 and JP-B-56- 42860 are also preferably sued.

As especially preferred developing solution, the developing solution containing a nonionic compound, having pH of from 11.5 to 12.8, and an electrical conductivity of from 3 to 30 mS/cm as disclosed in JP-A-2002-202616 can be exemplified.

In the plate-making process of a lithographic printing plate precursor of the invention, if necessary, the plate may be heated all over the surface before exposure, during exposure and from exposure to development. The image-forming reaction in the photosensitive layer is accelerated by heating, which leads to the improvement of sensitivity and press life and the stabilization of sensitivity. Further, for the purpose of improving the image strength and press life, it is effective for the image after development to be subjected to whole image post-heating or whole image exposure. It is preferred that the heating before development is generally performed on moderate condition of 150°C or lower. If the temperature is too high, there is a possibility that undesired curing reaction occurs in the non-image area. On the other hand, heating after development can be performed on very severe condition, i.e., generally from 200 to 500°C. Lower temperature does not result in sufficient image strengthening effect, while higher temperature leads to the degradation of a support and thermal decomposition of an image area.

A lithographic printing plate precursor for scanning exposure can be exposed by well-known methods with no limitation. Preferred wavelengths of a light source are from 350 nm to 450 nm, specifically an InGan series semiconductor laser is preferably used. Exposure machinery may be any of an internal drum type, an external drum type, or a flat bed type. The photosensitive layer components of the invention can be made soluble in neutral water and weak alkaline water by using highly soluble components, and the lithographic printing plate precursor having such constitution can take a system of on-press exposure-development after being loaded onto a press.

As available laser light sources of from 350 nm to 450 nm, the following can be used.

As gas lasers: Ar ion laser (364 nm, 351 nm, 10 mW to 1 W), Kr ion laser (356 nm, 351 nm, 10 mW to 1 W), He-Cd laser (441 nm, 325 nm, 1 mW to 100 mW); As solid state lasers: a combination of 2 times of Nd/YAG ($YVO_4$) and SHG crystals (355 nm, 5 mW to 1 W), a combination of Cr/LiSAF and SHG crystals (430 nm, 10 mW); as semiconductor lasers: $KNbO_3$ ring resonator (430 nm, 30 mW), a combination of waveguide type wavelength converting element and AlGaAs, InGaAs semiconductor (380 nm to 450 nm, 5 mW to 100 mW), a combination of waveguide type wavelength converting element and AlGaInP, AlGaAs semiconductor (300 nm to 350 nm, 5 mW to 100 mW), AlGaInN (350 nm to 450 nm, 5 mW to 30 mW), and as other pulse lasers: $N_2$ laser (337 nm, pulse 0.1 to 10 mJ), XeF (351 nm, pulse 10 to 250 mJ).

Of these, AlGaInN semiconductor laser (commercially available InGaN series semiconductor laser, 400 to 410 nm, 5 to 30 mW) is particularly preferred in view of the wavelength characteristics and the cost.

As the exposure apparatuses of scanning exposure type lithographic printing plate precursor, exposure machinery may be an internal drum type, an external drum type, or a flat bed type, and as the light sources, all the light sources other than pulse lasers among the above light sources can be used. In practice the following exposure apparatuses are particularly preferred from the relationship between the sensitivity of the photosensitive material and the plate- making time.

- An exposure apparatus of single beam using one gas laser or solid state laser by internal drum type,
- An exposure apparatus of multi-beam (10 beams or more) using many semiconductor lasers by flat bed type,
- An exposure apparatus of multi-beam (10 beams or more) using many semiconductor lasers by external drum type.

In the above-described direct imaging lithographic printing plate precursors by laser beams, the following equation (eq 1) comes to existence among the sensitivity of the photosensitive material X ($J/cm^2$), the exposure area of the photosensitive material S ($cm^2$), the power of one laser light source q (W), the number of laser beams n, and the total exposure time t (s):

$$X \cdot S = n \cdot q \cdot t \qquad \text{(eq 1)}$$

i) In the case of internal drum type (single beam):

The following equation (eq 2) comes to existence among the laser revolution number f (radian/s), the sub-scanning length of the photosensitive material Lx (cm), the resolving power Z (dot/cm), and the total exposure time t (s):

$$f \cdot Z \cdot t = Lx \qquad \text{(eq 2)}$$

ii) In the case of external drum type (multi-beam):

The following equation (eq 3) comes to existence among the drum revolution number F (radian/s), the sub-scanning length of the photosensitive material Lx (cm), the resolving power Z (dot/cm), the total exposure time t (s), and the beam number (n):

$$F \cdot Z \cdot n \cdot t = Lx \qquad \text{(eq 3)}$$

iii) In the case of flat bed type (multi-beam):

The following equation (eq 4) comes to existence among the polygonal mirror revolution number H (radian/s), the sub-scanning length of the photosensitive material Lx (cm), the resolving power Z (dot/cm), the total exposure time t (s), and the beam number (n):

$$H \cdot Z \cdot n \cdot t = Lx \qquad \text{(eq 4)}$$

By substituting the resolving power required of the practical printing plate (2,560 dpi), the plate size (A1/B1, sub-scanning length 421 inches), the exposure condition of about 20 sheets/hour, and the photosensitive characteristics of the photosensitive composition of the present invention (photosensitive wavelength, sensitivity: about 0.1 $mJ/cm^2$) for the above equation, it can be understood that the combination of the lithographic printing plate precursor using the photosensitive composition according to the present invention with a multi-beam exposure system using the laser of the semiconductor laser is particularly preferred. Further, taking the operational property and the cost into consideration, the combination of external drum type and an exposure apparatus of a semiconductor laser multi-beam is most preferred.

As other exposure rays for the photosensitive composition according to the invention, a mercury lamp, a chemical lamp, a carbon arc lamp, a xenon lamp, a metal halide lamp of ultra-high pressure, high pressure, intermediate pressure and low pressure, and various visible and ultraviolet laser lamps, a fluorescent lamp, a tungsten lamp and sunlight can be used.

Besides the photosensitive layer of a lithographic printing plate for scanning exposure, the photosensitive composition according to the present invention can be widely used in the field of photo-curable resins with no particular limitation, e.g., when the composition is applied, according to necessity, to a liquid photosensitive composition combined with a cationic polymerizable compound, a high speed optical fabrication material can be obtained. Further, the photosensitive composition can be used as a material for hologram by making use of the refractive index variation with photopolymerization. The composition can also be applied to a variety of transfer materials (a stripping off photographic material, a toner developing material) by making use of the surface adhesion variation. It also can be used in photo-curing of microcapsules. It can further be applied to the manufacture of electronic materials such as photoresist, and the photo-curable resin materials of inks, coatings and adhesives.

EXAMPLE

The invention will be described with reference to Examples, but the invention is not limited thereto.

EXAMPLES 1 TO 16 AND COMPARATIVE EXAMPLES 1 TO 7

Preparation of support:

An aluminum plate having a thickness of 0.3 mm was immersed in a 10 mass% aqueous sodium hydroxide solution at 60˚C for 25 seconds to effect etching, then washed with flowing water, washed with a 20 mass% aqueous nitric acid solution for neutralization and then washed with water. The plate was subjected to electrolytic surface roughening treatment in a 1 mass% aqueous nitric acid solution with applying alternating waveform electric current of sine wave at anode current of 300 coulomb/$dm^2$. Subsequently, the plate was immersed in a 1 mass% aqueous sodium hydroxide solution at 40˚C for 5 seconds, then immersed in a 30 mass% aqueous sulfuric acid solution and desmutting-treated at 60˚C for 40 seconds. Thereafter, the plate was subjected to anodizing treatment for 2 minutes in a 20 mass% aqueous sulfuric acid solution at the electric density of 2 A/$cm^2$ so that the thickness of the anodic oxide film reached 2.7 g/$m^2$. On measurement, the surface roughness was 0.3 μm (Ra indication by JIS B0601).

The sol-gel reaction solution shown below was coated on the back surface of the thus-treated plate by means of a bar coater, the coated plate was dried at 100˚C for 1 minute. Thus, a support having a back coat layer having a dry coating amount of 70 mg/$m^2$ was obtained.

| Sol-gel reaction solution | |
|---|---|
| Tetraethyl silicate | 50 mass parts |
| Water | 20 mass parts |
| Methanol | 15 mass parts |
| Phosphoric acid | 0.05 mass parts |

The above components were mixed and stirred, heat generation started after about 5 minutes. After the reaction was continued for 60 minutes, the following solution was added to the reaction solution, thereby a back coat layer coating solution was obtained.

| | |
|---|---|
| Pyrogallol-formaldehyde condensation resin (molecular weight: 2,000) | 4 mass parts |
| Dimethyl phthalate | 5 mass parts |
| Fluorine surfactant (N-butylperfluorooctanesulfonamide ethyl acrylate/polyoxyethylene acrylate copolymer, molecular weight: 20,000) | 0.7 mass parts |
| Methanol Silica Sol (manufactured by Nissan Chemical Industries, Ltd., methanol: 30 mass%) | 50 mass parts |
| Methanol | 800 mass parts |

Preparation of photosensitive layer

The following photosensitive composition was coated on the thus-treated aluminum plate in a dry coating amount shown in Table 1 below, and the coated plate was dried at 80˚C for 2 minutes, thus a photosensitive layer was formed.

| | |
|---|---|
| Photosensitive composition: | |
| Addition polymerizable compound (M-1) containing a urethane bond shown below | 1.6 g |

(M-1)

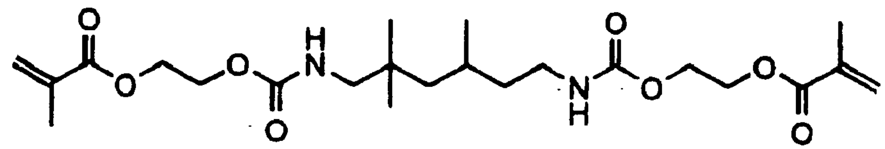

| | |
|---|---|
| Allyl methacrylate/methacrylic acid/ N-isopropylacrylamide copolymer (copolymerization molar ratio: 70/14/16) | 1.9 g |
| Photopolymerization initiation system (the compound used and the amount are shown in Table 1) | |
| Sensitizing dye | X g |
| Initiating compound | Y g |
| Cosensitizer | Z g |
| Fluorine-containing nonionic surfactant (F-780F) | 0.03 g |
| Thermal polymerization inhibitor (N-nitrosophenylhydroxylamine aluminum salt) | 0.01 g |
| Pigment dispersion | 2.0 g |
| The composition of pigment dispersion: | |
| Pigment Blue 15:6 | 15 mass parts |
| Allyl methacrylate/methacrylic acid copolymer (copolymerization molar ratio: 83/17) | 10 mass parts |
| Cyclohexanone | 15 mass parts |
| Methoxypropyl acetate | 20 mass parts |
| Propylene glycol monomethyl ether | 40 mass parts |
| Methyl ethyl ketone | 20 g |
| Propylene glycol monomethyl ether | 20 g |

Preparation of protective layer:

A3 mass% aqueous solution of polyvinyl alcohol (saponification degree: 98 mol%, polymerization degree: 550) was coated on the photosensitive layer in a dry coating weight of 2 g/m$^2$, and the coated layer was dried at 100°C for 2 minutes to form a protective layer, whereby a lithographic printing plate precursor was obtained. Evaluation of photosensitivity and safelight aptitude

A step guide (a gray scale guide showing discontinuous variation of transmitted optical density at ΔD of 0.15, manufactured by Fuji Photo Film Co., Ltd.) was brought into contact with the above-obtained lithographic printing plate precursor closely, and exposure was performed with a xenon lamp through an optical filter so as to reach the already known exposure energy. For the purpose of estimating the exposure aptitude to short wavelength semiconductor laser, exposure was performed with monochromatic light of 400 nm using Kenko-BP-40 as the optical filter.

Thereafter, the lithographic printing plate precursor was subjected to development by immersing in the developing solution having the following composition at 25°C for 10 seconds. The exposure energy was found from the highest stage where the image was completely removed, and the sensitivity was computed from the exposure energy (unit: mJ/cm$^2$). The lower the value, the higher is the sensitivity. The results obtained are shown in Table 1.

Developing solution:

An aqueous solution having pH 12.0 comprising the following composition

| | |
|---|---|
| Potassium hydroxide | 0.2 g |
| 1K Potassium silicate | 2.4 g |
| ($SiO_2/K_2O$ = 1.9) | |
| The following compound | 5.0 g |
| Ethylenediaminetetraacetic acid/4Na salt | 0.1 g |
| Water | 92.3 g |

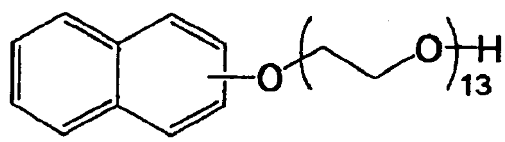

For the evaluation of safelight aptitude, the obtained lithographic printing plate precursor was exposed to a yellow lamp (500 nm or less was cut) for 30 minutes before exposure, and then underwent exposure and development in the same manner as above. The photosensitive material that generated fog was graded × (not having safelight aptitude), and the material that did not generate fog was graded o (having safelight aptitude). The results obtained are shown in Table 1 with the sensitivity evaluation.

TABLE 1

| Example No. | Photoinitiation System | | | Coating Amount (mg/m$^2$) | Clear Sensitivity | Yellow Lamp Safelight Aptitude |
|---|---|---|---|---|---|---|
| | Sensitizing Dye (X g) | Initiating Compound (Y g) | Cosensitizer (Z g) | | | |
| Example 1 | D-41 (0.20) | A-2 (0.35) | None | 1.35 | 0.60 | o |
| Example 2 | D-41 (0.20) | A-3 (0.20) | C-1 (1.55) | 1.40 | 0.30 | o |
| Example 3 | D-41 (0.15) | A-4 (0.30) | C-3 (1.45) | 1.30 | 0.45 | o |
| Example 4 | D-41 (0.20) | A-5 (0.25) | C-2 (1.45) | 1.40 | 0.50 | o |
| Example 5 | D-41 (0.15) | A-6 (0.30) | C-1 (1.50) | 1.20 | 0.40 | o |
| Example 6 | D-41 (0.20) | A-3 (0.20) | None | 1.40 | 0.50 | o |

(continued)

| Example No. | Photoinitiation System | | | Coating Amount ($mg/m^2$) | Clear Sensitivity | Yellow Lamp Safelight Aptitude |
|---|---|---|---|---|---|---|
| | Sensitizing Dye (X g) | Initiating Compound (Y g) | Cosensitizer (Z g) | | | |
| Example 7 | D-13 (0.20) | A-3 (0.20) | C-1 (1.55) | 1.35 | 0.45 | o |
| Example 8 | D-29 (0.20) | A-3 (0.20) | C-1 (1.55) | 1.40 | 0.45 | o |
| Example 9 | D-08 (0.15) | A-3 (0.25) | C-1 (1.65) | 1.45 | 0.55 | o |
| Example 10 | D-51 (0.10) | A-4 (0.30) | None | 1.25 | 0.60 | o |
| Example 11 | D-05 (0.25) | A-6 (0.35) | None | 1.30 | 0.60 | o |
| Example 12 | D-45 (0.20) | A-2 (0.20) | C-2 (1.60) | 1.35 | 0.45 | o |
| Example 13 | D-50 (0.20) | A-3 (0.15) | None | 1.35 | 0.35 | o |
| Example 14 | D-42 (0.20) | A-3 (0.20) | C-1 (1.55) | 1.40 | 0.25 | o |
| Example 15 | D-44 (0.20) | A-3 (0.35) | C-1 (1.50) | 1.25 | 0.30 | o |
| Example 16 | D-47 (0.20) | A-2 (0.30) | C-2 (1.55) | 1.40 | 0.40 | o |
| Comparative Example 1 | None | A-3 (0.20) | C-1 (1.55) | 1.40 | Image could not form. | - |
| Comparative Example 2 | D-41 (0.20) | None | C-1 (1.55) | 1.40 | Image could not form. | - |
| Comparative Example 3 | DR-1 (0.20) | A-3 (0.20) | C-1 (1.55) | 1.40 | 2.0 | × |
| Comparative Example 4 | D-41 (0.20) | A-1 (0.20) | C-1 (1.55) | 1.40 | 0.30 | × |

In Table 1, the structures of the sensitizing dyes used in the photopolymerization initiation system are the same as the above-exemplified compounds. The structures of the initiating compounds (A-1) to (A-6) and cosensitizers (C-1) to (C-3) are shown below. Sensitizing dye (DR-1) shown below used in Comparative Example is a dye compound that is out of the scope of the invention.

A-1

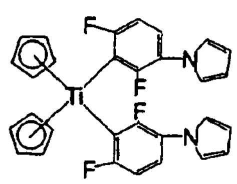

A-2

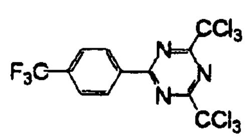

A-3

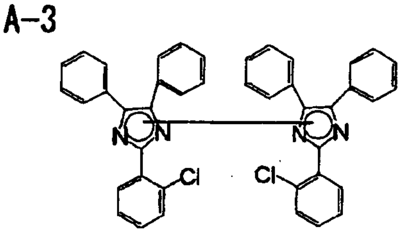

A-4

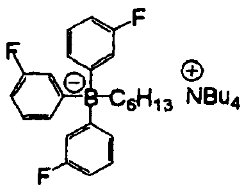

A-5

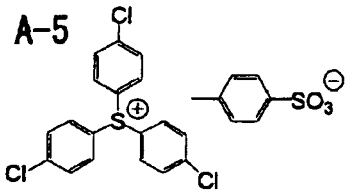

A-6

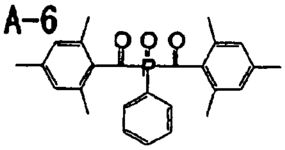

C-1

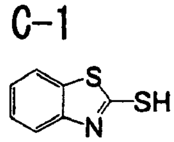

C-2

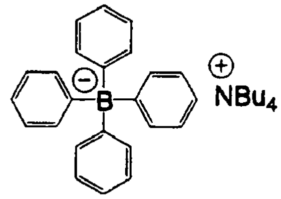

C-3

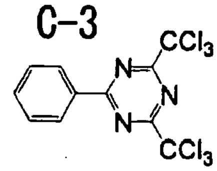

DR-1

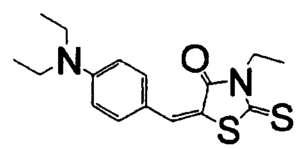

As is apparent from the results in Table 1, all the lithographic printing plate precursors in which the photosensitive compositions of the invention was used in the photosensitive layer were high sensitivity and image could be formed, so that these photoinitiation systems showed sufficiently practicable sensitivity. On the other hand, Comparative Examples 1 and 2 in which only sensitizing dye or only initiating compound was used could not form an image. The lithographic printing plate precursor in Comparative Example 3 in which the combination of the initiating compound and well known sensitizing dye out of the scope of the invention was used could not show sufficiently practicable sensitivity. It can be seen from the results in Examples 1 to 16 that the photosensitive compositions of the invention can be used in a wide range of usage not depending upon the sensitizing mechanisms.

EXAMPLES 17 TO 24 AND COMPARATIVE EXAMPLE 5

Each lithographic printing plate precursor was manufactured by forming an intermediate layer, a photosensitive layer and a protective layer by the following procedures on the support used in Example 1.

Preparation of intermediate layer:

Intermediate layer coating solution having the following composition was prepared, and the coating solution was coated on a support with a wheeler on the condition of 180 rpm so that the coating amount of phenylphosphonic acid became 20 mg/m$^2$, and the coated layer was dried at 80°C for 30 seconds, whereby an intermediate layer was formed.

Intermediate layer coating solution:

| | |
|---|---|
| Phenylphosphonic acid | from 0.07 g to 1.4 g |
| Methanol | 200 g |

Preparation of photosensitive layer:

The photosensitive composition having the composition shown below was prepared, and the coating solution

was coated on the support having the intermediate layer with a wheeler each in the coating amount as shown in Table 2 below, and the coated layer was dried at 100˚C for 1 minute, whereby a photosensitive layer was formed.

| | |
|---|---|
| Photosensitive composition : | |
| Addition polymerizable composition | 1.6 g |
| (compound shown in Table 2) | |
| Binder polymer | 2.0 g |
| (compound shown in Table 2) | |
| Sensitizing dye | 0.15 g |
| (compound shown in Table 2) | |
| Initiating compound | 0.2 g |
| (compound shown in Table 2) | |
| Cosensitizer | 0.3 g |
| (compound shown in Table 2) | |
| Coloring pigment dispersion | 2.0 g |
| The composition of pigment dispersion | |
| Pigment Blue 15:6 | 15 mass parts |
| Allyl methacrylate/methacrylic acid copolymer (copolymerization molar ratio: 83/17) | 10 mass parts |
| Cyclohexanone | 15 mass parts |
| Methoxypropyl acetate | 20 mass parts |
| Propylene glycol monomethyl ether | 40 mass parts |
| Thermal polymerization inhibitor | 0.01 g |
| (N-nitrosophenylhydroxylamine aluminum salt) | |
| Fluorine-containing surfactant | 0.02 g |
| (Megafac F-780F, manufactured by Dainippon Ink and Chemicals Inc.) | |
| Methyl ethyl ketone | 20.0 g |
| Propylene glycol monomethyl ether | 20.0 g |

Preparation of protective layer:

A 3 mass% aqueous solution of polyvinyl alcohol (saponification degree: 98 mol%, polymerization degree: 550) was coated on the photosensitive layer in a dry coating weight of 2 g/m$^2$, and the coated layer was dried at 100˚C for 2 minutes to form a protective layer, whereby a lithographic printing plate precursor was obtained. Exposure of lithographic printing plate precursor:

The thus-obtained lithographic printing plate precursor was subjected to solid image exposure, and half dot image exposure of from 1% to 99% every 1% on the condition of 175 lines/inch using 400 nm monochromatic light as a light source, and the exposure power was controlled so that the exposure energy density of the plate became 100 μJ/cm$^2$.

Development and plate-making:

Automatic processor LP-850 (manufactured by Fuji Photo Film Co., Ltd.) was charged with a developing solution (shown in Table 2) and Finisher FP-2W (manufactured by Fuji Photo Film Co., Ltd.), and the exposed printing plate precursor was subjected to development/plate-making on the condition of the temperature of the developing solution of 30˚C and development time of 18 seconds. Thus, a lithographic printing plate was obtained.

Test of press life:

R201 (manufactured by Roland Co., Ltd.) was used as a printing press, and GEOS-G (N) (manufactured by Dainippon Ink and Chemicals Inc.) was used as ink. Printed matters of solid image part were observed while continuing printing, and the number of sheets that the image began to blur was taken as the press life. The higher the value, the better is the press life.

Forced test of halftone dot press life:

R201 (manufactured by Roland Co., Ltd.) was used as a printing press and GEOS-G (N) (manufactured by Dainippon Ink and Chemicals Inc.) was used as ink. After 5,000 sheets were printed from the start of printing, PS plate cleaner CL-2 (manufactured by Fuji Photo Film Co., Ltd.) was applied to printing sponge and the halftone dot part was wiped to remove the ink on the printing plate. Thereafter, 10,000 sheets were printed and the presence of skipping of halftone dot on the printed matter was visually observed.

Test of soiling resistance:

R201 (manufactured by Roland Co., Ltd.) was used as a printing press and GEOS-G (S) (manufactured by Dainippon Ink and Chemicals Inc.) was used as ink. The obtained printed matter was observed, and the state of soiling of the non-image area (the unexposed area) was visually evaluated.
Addition polymerizable compound in Table 2:

M-1: Addition polymerizable compound having a urethane bond shown below.

(M-1)

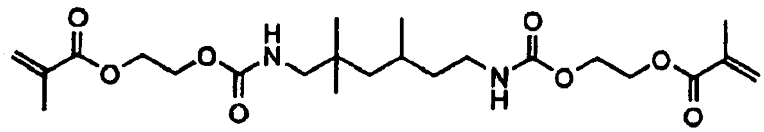

M-2: Pentaerythritol tetraacrylate (NK ester A-TMMT, manufactured by Shin-Nakamura Chemical Co., Ltd.)
M-3: Glycerol dimethacrylate-hexamethylene diisocyanate- urethane prepolymer (UA101H, manufactured by Kyoeisha Chemical Co., Ltd.)

Binder polymer in Table 2:

B-1: Allyl methacrylate/methacrylic acid/N-isopropyl- acrylamide copolymer (copolymerization molar ratio: 68/12/20)
Measured acid value obtained by NaOH titration: 1.12 meq/g
Mass average molecular weight obtained by GPC measurement: 100,000
U-1: Polyurethane resin of condensation polymerization product of the following diisocyanate and diol:

4,4'-diphenylmethane diisocyanate (MDI)
Hexamethylene diisocyanate (HMDI)
Polypropylene glycol (PPG1000, mass average molecular weight: 1,000)
2,2-Bis(hydroxymethyl)propionic acid (DMPA)
Glycerol monomethacrylate (Blenmer GLM, manufactured by Nippon Oils and Fats Co., Ltd.)

Copolymerization molar ratio (MDI/HMDI/PPG1000/DMPA/Blenmer GLM: 80/20/22/52/26)

Measured acid value obtained by KOH titration: 0.92 meq/g
Mass average molecular weight obtained by GPC measurement: 60,000

Developing solution in Table 2:

DV-1:

An aqueous solution having pH 10 and comprising the following composition

| | |
|---|---|
| Monoethanolamine | 0.1 mass part |
| Triethanolamine | 1.5 mass parts |
| Compound represented by the following formula 1 | 4.0 mass parts |
| Compound represented by the following formula 2 | 2.5 mass parts |

| | |
|---|---|
| Compound represented by the following formula 3 | 0.2 mass parts |
| Water | 91.7 mass parts |

DV-2:

An aqueous solution having pH 10 and comprising the following composition

| | |
|---|---|
| Sodium bicarbonate | 1.2 mass parts |
| Sodium carbonate | 0.8 mass parts |
| Compound represented by the following formula 1 | 3.0 mass parts |
| Compound represented by the following formula 2 | 2.0 mass parts |
| Compound represented by the following formula 3 | 0.2 mass parts |
| Water | 92.8 mass parts |

DV-3:

An aqueous solution having pH 3 and comprising the following composition

| | |
|---|---|
| 1K Potassium silicate | 3.0 mass parts |
| Potassium hydroxide | 1.5 mass parts |
| Compound represented by the following formula 3 | 0.2 mass parts |
| Water | 95.3 mass parts |

DV-4:

The developing solution having pH 12 used in Example 1

Formula 1

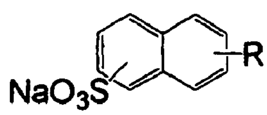

Formula 2

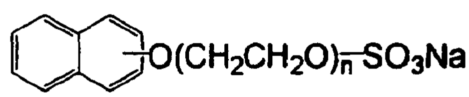

Formula 3

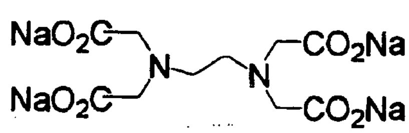

In the above formulae, R represents $C_4H_9$, and n is about 4 (an average value).

TABLE 2

| Example No. | Photosensitive Layer | | | | | | Composition of Developing Solution |
|---|---|---|---|---|---|---|---|
| | Addition Polymerizable Compound | Binder Polymer | Sensitizing Dye | Initiating Compound | Cosensitizer | Coating Amount (g/m$^2$) | |
| Ex. 17 | M-1 | B-1 | D-41 | A-3 | C-1 | 1.4 | DV-4 |
| Ex. 18 | M-1 | U-1 | D-46 | A-2 | C-2 | 1.4 | DV-1 |
| Ex. 19 | M-2 | B-1 | D-20 | A-3 | C-1 | 1.4 | DV-4 |
| Ex. 20 | M-3 | U-1 | D-49 | A-2 | C-2 | 1.3 | DV-4 |
| Ex. 21 | M-1 | B-1 | D-28 | A-4 | C-3 | 1.4 | DV-2 |
| Ex. 22 | M-2 | B-1 | D-52 | A-6 | C-1 | 1.3 | DV-3 |
| Ex. 23 | M-3 | U-1 | D-43 | A-3 | C-1 | 1.4 | DV-4 |
| Ex. 24 | M-1 | B-1 | D-46 | A-3 | C-1 | 1.4 | DV-4 |
| Comp.Ex. 5 | M-1 | B-1 | None | A-3 | C-1 | 1.4 | DV-4 |

| Example No. | Printing Performance | | | |
|---|---|---|---|---|
| | Addition Polymerizable Compound | Press Life of Image Area (sheets) | Press Life of Halftone Dot Area | Soiling Resistance of Non-image Area |
| Ex. 17 | M-1 | 55,000 | Good | Good |
| Ex. 18 | M-1 | 90,000 | Good | Good |
| Ex. 19 | M-2 | 60,000 | Good | Good |
| Ex. 20 | M-3 | 70,000 | Good | Good |
| Ex. 21 | M-1 | 60,500 | Good | Good |
| Ex. 22 | M-2 | 50,000 | Good | Good |
| Ex. 23 | M-3 | 75,000 | Good | Good |
| Ex. 24 | M-1 | 60,000 | Good | Good |
| Comp.Ex. 5 | M-1 | Image run occurred. | Image run occurred. | Good |

As is apparent from the results in Table 2, the lithographic printing plate precursors in Examples 17 to 24 using the photosensitive compositions of the invention in the photosensitive layers can provide excellent lithographic printing plates even on the plate-making condition of high sensitivity by scanning exposure, i.e., extremely low energy exposure condition. On the other hand, the lithographic printing plate precursor in Comparative Example 5 not using the sensitizing dye according to the invention cannot provide a practicable lithographic printing plate.

EXAMPLES 26 TO 43 AND COMPARATIVE EXAMPLES 6 TO 12

Preparation of photosensitive layer:

The following photosensitive composition was coated on the support used in Example 1 in a dry coating amount shown in Table 3 below, and the coated plate was dried at 80˚C for 2 minutes, thus a photosensitive layer was formed.

| | | |
|---|---|---|
| Photosensitive composition: | | |
| | The following polymerizable composition | 1.5g |
| | 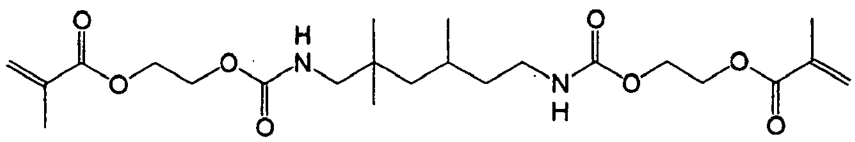 | |
| Binder polymer | | 2.0 g |
| | Allyl methacrylate/methacrylic acid/ N-isopropylacrylamide copolymer (copolymerization molar ratio: 67/13/20) | |
| Photopolymerization initiation system | | |
| | (shown in Table 3 below) | |
| | Sensitizing dye | X g |
| | Initiating compound | Y g |
| | Cosensitizer | Z g |
| Other components | | |
| Fluorine-containing surfactant | | 0.02 g |
| | (F-177P, manufactured by Dainippon Ink and Chemicals Inc.) | |
| Thermal polymerization inhibitor | | 0.01 g |
| | (N-nitrosophenylhydroxylamine aluminum salt) | |
| Pigment dispersion | | 2.0 g |
| | (The composition of pigment dispersion): | |
| | Pigment Blue 15:6 | 15 mass parts |
| | Allyl methacrylate/methacrylic acid copolymer (copolymerization molar ratio: 83/17) | 10 mass parts |
| | Cyclohexanone | 15 mass parts |
| | Methoxypropyl acetate | 20 mass parts |
| | Propylene glycol monomethyl ether | 40 mass parts |
| Solvent | | |
| | Methyl ethyl ketone | 20.0 g |
| | Propylene glycol monomethyl ether | 20.0 g |

Preparation of protective layer:

A 3 mass% aqueous solution of polyvinyl alcohol (saponification degree: 98 mol%, polymerization degree: 550) was coated on the photosensitive layer in a dry coating weight of 2 g/$m^2$, and the coated layer was dried at 100˚C for 2 minutes to form a protective layer, whereby a lithographic printing plate precursor was obtained. Evaluation of clear sensitivity:

A step guide (a gray scale guide showing discontinuous variation of transmitted optical density at ΔD of 0.15, manufactured by Fuji Photo Film Co., Ltd.) was brought into contact with the above-obtained lithographic printing plate precursor closely, and exposure was performed with a xenon lamp through an optical filter so as to reach the already known exposure energy.

Thereafter, the lithographic printing plate precursor was subjected to development by immersing in the developing solution used in Example 1 at 25˚C for 10 seconds. The exposure energy was found from the highest stage where the image was completely removed, and the sensitivity was computed from the exposure energy (unit: $mJ/cm^2$). The lower the value, the higher is the sensitivity. For the purpose of estimating the exposure aptitude to short wavelength semiconductor laser, exposure was performed with monochromatic light of 400 nm using Kenko-BP-40 as the optical filter. The results obtained are shown in Table 3 below.

Evaluation of preservation stability:

Preservation stability of the obtained lithographic printing plate precursor was evaluated by the comparison of the clear sensitivity on the following conditions (i) and (ii).

(i) Exposure and development immediately after preparation of lithographic printing plate precursor

(ii) Exposure and development after forced preservation of lithographic printing plate precursor on the conditions of 60˚C for 10 days

The clear sensitivity here is the same as the sensitivity in the above sensitivity evaluation. The difference of the sensitivity of (i) and the sensitivity of (ii), [(ii)-(i)], was defined as clear sensitivity. That the value is small means the variation in image formation sensitivity is small between the lithographic printing plate precursor without aging and the lithographic printing plate precursor after forced aging, so that it can be said that the preservation stability is high. The results obtained are shown in Table 3 below.

Evaluation of fog:

The results are shown in Table 3 together with the results of sensitivity evaluation.

For the evaluation of safelight aptitude, the obtained lithographic printing plate precursor was exposed to a yellow lamp (500 nm or less was cut) for 30 minutes before exposure, and then underwent exposure and development in the same manner as above. The photosensitive material that generated fog was graded × (not having safelight aptitude), and the material that did not generate fog was graded o (having safelight aptitude) by visual observation. The results obtained are shown in Table 3 below.

TABLE 3

| Example No. | Initiation System | | | Coating Amount ($mg/m^2$) | Clear Sensitivity (i) ($mg/m^2$) | Clear Sensitivity Difference ($mJ/cm^2$) | Fog due to Work under Yellow Lamp |
|---|---|---|---|---|---|---|---|
| | Sensitizing Dye (X g) | Initiating Compound (Y g) | Cosensitizer (Z g) | | | | |
| Example 26 | D101 (1.0) | T-1 (0.90) | R-1 (0.20) | 1.4 | 0.28 | 0.02 | 0 |
| Example 27 | D102 (1.2) | T-1 (0.12) | R-1 (0.20) | 1.5 | 0.20 | 0.01 | 0 |
| Example 28 | D103 (1.1) | T-1 (0.10) | R-1 (0.20) | 1.3 | 0.30 | 0.03 | 0 |
| Example 29 | D104 (1.5) | T-1 (0.95) | R-1 (0.20) | 1.3 | 0.25 | 0.02 | 0 |
| Example 30 | D107 (1.6) | T-1 (0.08) | R-1 (0.20) | 1.2 | 0.30 | 0.08 | 0 |
| Example 31 | D108 (1.0) | T-1 (0.11) | R-1 (0.20) | 1.5 | 0.35 | 0.04 | 0 |
| Example 32 | D110 (0.9) | T-1 (0. 12) | R-1 (0.20) | 1.5 | 0.33 | 0.10 | 0 |
| Example 33 | D111 (1.0) | T-1 (2.60) | R-1 (0.20) | 1.2 | 0.55 | 0.03 | 0 |
| Example 34 | D114 (1.2) | T-1 (0.08) | R-1 (0.20) | 1.0 | 0.30 | 0.03 | 0 |
| Example 35 | D119 (1.3) | T-1 (1.50) | R-1 (0.20) | 1.2 | 0.40 | 0.12 | 0 |

(continued)

| Example No. | Initiation System | | | Coating Amount (mg/m²) | Clear Sensitivity (i) (mg/m²) | Clear Sensitivity Difference (mJ/cm²) | Fog due to Work under Yellow Lamp |
|---|---|---|---|---|---|---|---|
| | Sensitizing Dye (X g) | Initiating Compound (Y g) | Cosensitizer (Z g) | | | | |
| Example 36 | D120 (1.4) | T-1(0.12) | R-1 (0.20) | 1.4 | 0.42 | 0.09 | 0 |
| Example 37 | D121 (1.0) | T-1 (0.20) | R-1 (0.20) | 1.5 | 0.32 | 0.02 | 0 |
| Example 38 | D101 (1.0) | T 2 (0.90) | R-2 (0.32) | 1.4 | 0.32 | 0.04 | Δ |
| Example 39 | D102 (1.2) | T-2 (0.12) | R-2 (0.32) | 1.5 | 0.25 | 0.02 | Δ |
| Example 40 | D121 (1.0) | T-4(0.50) | R-1 (0.20) | 1.5 | 0.43 | 0.02 | 0 |
| Example 41 | D101 (1.0) | T-5(0.80) | R-2 (0.32) | 1.4 | 0.40 | 0.04 | 0 |
| Example 42 | D102 (1.2) | T-6 (0.72) | R-2 (0.32) | 1.5 | 0.50 | 0.02 | Δ |
| Example 43 | D104 (1.5) | T-3(0.95) | R-2 (0.35) | 1.3 | 0.45 | 0.08 | 0 |
| Comparative Example 6 | D101 (1.0) | None | R-1 (0.20) | 1.2 | Image could not form. | - | - |
| Comparative Example 7 | None | T-1 (1.80) | R-1 (0.20) | 1.3 | Image could not form. | - | - |
| Comparative Example 8 | H1 (0.8) | T-2 (2.60) | R-2 (0.32) | 1.3 | 0.35 | 0.02 | × |
| Comparative Example 9 | H1 (0.8) | T-1 (0.08) | R-1 (0.20) | 1.5 | 0.52 | 0.07 | o |
| Comparative Example 10 | H2 (0.8) | T-1 (0.08) | R-1 (0.20) | 1.4 | 0.60 | 0.03 | o |
| Comparative Example 11 | H3 (1.0) | T+1 (0.10) | R-1 (0.20) | 1.4 | 0.45 | 0.05 | o |
| Comparative Example 12 | H1 (0.8) | T-3(0.95) | R-2 (0.35) | 1.3 | 0.62 | 0.20 | o |

In Table 3, the structures of the sensitizing dyes used in the photopolymerization initiation system are the same as the above-exemplified compounds. The structures of the sensitizing dyes (H-1) to (H-3), initiating compounds (T-1) to (T-6), and cosensitizers (R-1) and (R-2) are shown below. Sensitizing dyes (H-1) to (H-3) shown below used in comparative examples are dye compounds that are out of the scope of the invention.

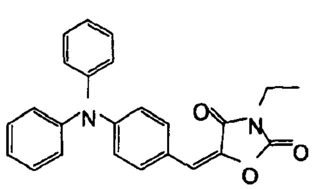

H-1

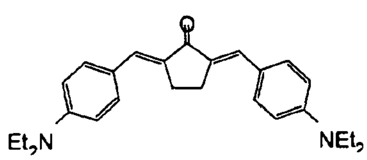

H-2

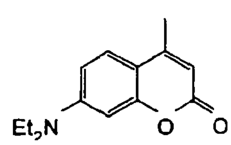

H-3

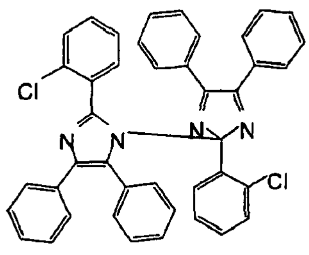

T-1

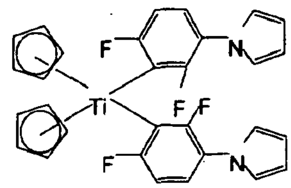

T-2

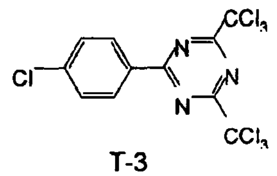

T-3

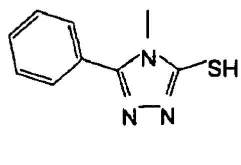

R-1

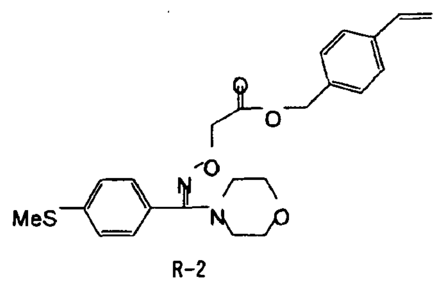

R-2

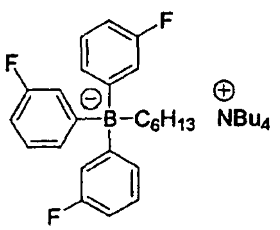

T-4

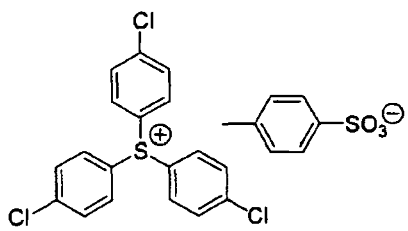

T-5

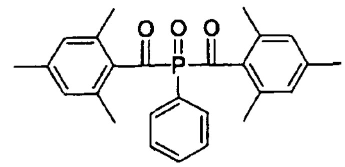

T-6

It can be clearly seen from the results in Table 3 that the lithographic printing plate precursors using the photosensitive compositions in the photosensitive layers have excellent sensitivity and they are excellent in preservation stability, for example, by the comparison of Examples 26 to 29 and Comparative Examples 6 to 12. With respect to preservation stability, it can be seen from the comparison of Example 26 with Examples 30 and 32 that when the sensitizing dye is a dye represented by formula (III) wherein $X_2$ represents dimethyl carbon (that is, a compound represented by formula (IV)), especially high preservation stability can be obtained. Thus, it was found that the structural factor of a sensitizing dye contributes to the preservation stability of the composition.

From the comparison of Example 26 with Example 38, it can also be understood that the combination of the sensitizing dye of the invention with a hexaarylbiimidazole initiating agent exhibits higher sensitivity than the combination with a titanocene initiating agent.

The photosensitive composition in the invention and a lithographic printing plate precursor using the photosensitive composition have sufficient sensitivity suitable for scanning exposure with a short wave semiconductor laser such as InGaN, and a lithographic printing plate precursor excellent in press life and soiling resistance can be obtained. Fogging under a yellow lamp of a lithographic printing plate precursor in the invention is remarkably improved, so that workability of handling a printing plate can be greatly bettered. Further, the photopolymerizable composition in the invention is not only excellent in sensitivity but also superior in preservation stability.

The entire disclosure of each and every foreign patent application from which the benefit of foreign priority has been claimed in the present application is incorporated herein by reference, as if fully set forth.

**Claims**

1. A photosensitive composition comprising:

(A) a sensitizing dye;
(B) an initiating compound capable of generating a radical, an acid or a base; and
(C) a polymerizable compound capable of reaction by at least one of a radical, an acid and a base,

wherein the sensitizing dye is a compound selected from a compound having a partial structure represented by formula (1) and a compound represented by formula (I):

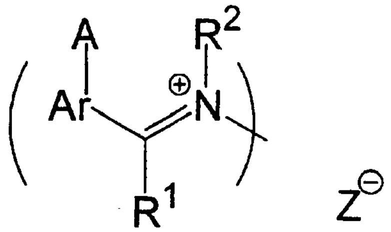

(1)

wherein Ar represents an aromatic ring;
A represents $-NR^3R^4$, $-SR^5$ or $-OR^6$;
$R^1$, $R^2$ and $R^3$ to $R^6$ each independently represents a hydrogen atom or a monovalent nonmetallic atomic group; and
$Z^-$ represents a counter ion necessary for neutralizing electric charge;

Formula (I)

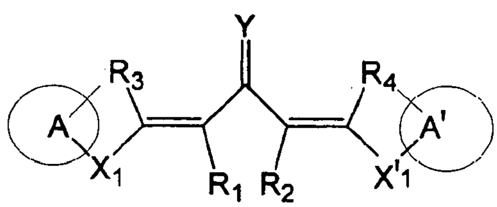

wherein $X_1$ and $X_1$' each independently represents an oxygen atom, a sulfur atom, $-CR_5R_6$ or $-NR_7$-, and at least one of $X_1$ and $X_1$' represents an oxygen atom, a sulfur atom or $-NR_7$-;
$R_1$, $R_2$, $R_3$, $R_4$, $R_5$, $R_6$ and $R_7$ each independently represents a hydrogen atom or a monovalent nonmetallic atomic group;
Y represents an oxygen atom, a sulfur atom or $NR_8$;
A and A' each independently represents an aromatic ring or a heterocyclic ring, which may have a substituent;
$R_3$ and $R_4$ each represents a nonmetallic atom or a nonmetallic atomic group that is bonded to any moiety of A and A' to form a cyclic structure; and
$R_1$ to $R_8$ may be bonded to each other to form an aliphatic or aromatic ring.

2. The photosensitive composition according to claim 1,
wherein the sensitizing dye is a compound having a partial structure represented by formula (1).

3. The photosensitive composition according to claim 1,
wherein the sensitizing dye is a compound represented by formula (I).

4. The photosensitive composition according to claim 1,
wherein the sensitizing dye is a compound represented by formula (2):

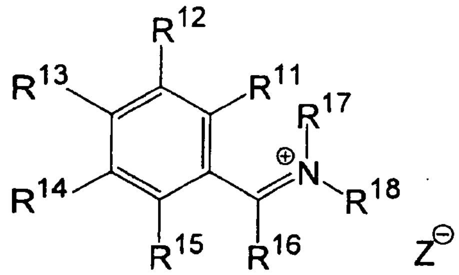

(2)

wherein $R^{11}$, $R^{12}$, $R^{13}$, $R^{14}$, $R^{15}$, $R^{16}$, $R^{17}$ and $R^{18}$ each independently represents a hydrogen atom or a monovalent nonmetallic atomic group, or may be bonded to each other to form a ring, provided that at least one of $R^{11}$, $R^{13}$ and $R^{15}$ represents $-NR^{19}R^{20}$, $-SR^{21}$ or $-OR^{22}$;
$R^{19}$, $R^{20}$, $R^{21}$ and $R^{22}$ each independently represents a hydrogen atom or a monovalent nonmetallic atomic group.

**5.** The photosensitive composition according to claim 1,
wherein the initiating compound capable of generating a radical, an acid or a base is a hexaarylbiimidazole compound.

**6.** The photosensitive composition according to claim 1,
wherein the polymerizable compound capable of reaction by at least one of a radical, an acid and a base is an addition polymerizable compound having an ethylenic unsaturated double bond.

**7.** A lithographic printing plate precursor comprising a photosensitive layer that comprises a photosensitive composition according to claim 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 9080750 A
- JP 10101719 A
- JP 2000258910 A
- JP 2002202598 A
- JP 2000080297 A
- JP 2720195 B
- DE 2641100
- DE 3333450
- DE 3021590
- DE 3021599
- EP 104143 A
- US 4837124 A
- JP 2150848 A
- JP 2096514 A
- EP 370693 A
- EP 233567 A
- EP 297443 A
- EP 297442 A
- EP 279210 A
- EP 422570 A
- US 3902144 A
- US 4933377 A
- US 4760013 A
- US 4734444 A
- US 2833827 A
- US 4743528 A
- JP 63138345 A
- JP 63142345 A
- JP 63142346 A
- JP 46042363 B
- JP 52147277 B
- JP 52014278 B
- JP 52014279 B
- EP 0290750 A
- EP 046083 A
- EP 156153 A
- EP 271851 A
- EP 0388343 A
- US 3901710 A
- US 4181531 A
- JP 60198538 A
- JP 53133022 A
- EP 0199672 A
- EP 84515 A
- EP 199672 A
- EP 044115 A
- EP 0101122 A
- US 4618564 A
- US 4371605 A
- US 4431774 A
- JP 6418143 A
- JP 2245756 A
- JP 4365048 A
- JP 62006223 B
- JP 63014340 B
- JP 59174831 A
- JP 1304453 A
- JP 1152109 A
- JP 61166544 A
- GB 1388492 A
- JP 53133428 A
- DE 3337024
- JP 62058241 A
- JP 5281728 A
- US 3567453 A
- US 4343891 A
- EP 109772 A
- EP 109773 A
- JP 60003625 A
- US 5102771 A
- US 5206317 A
- US 5212047 A
- JP 4026850 A
- JP 3192173 A
- JP 60010247 A
- JP 62040450 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B

- JP 46043946 B
- JP 1040337 B
- JP 1040336 B
- JP 2025493 A
- JP 61022048 A
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 10116232 A
- JP 11171907 A
- JP 9236913 A
- JP 48018327 B
- JP 54063902 A
- JP 47005125 B
- US 3658662 A
- JP 46027481 B
- JP 52058602 A
- JP 52030503 A
- JP 56028893 A
- JP 7159983 A
- US 3055295 A
- JP 56013168 A
- JP 9080744 A
- JP 8507727 A
- JP 50007481 B
- JP 54072104 A
- JP 59101651 A
- JP 60149491 A
- JP 60232998 A
- JP 3056177 A
- JP 4282637 A
- JP 5016558 A
- JP 5246171 A
- JP 7314937 A
- JP 8202025 A
- JP 8320551 A
- JP 9034104 A
- JP 9236911 A
- JP 9269593 A
- JP 10069092 A
- JP 10115931 A
- JP 10161317 A
- JP 10260536 A
- JP 10282682 A
- JP 11084674 A
- JP 11038635 A
- JP 11038629 A
- JP 10282645 A
- JP 10301262 A
- JP 11024277 A
- JP 11109641 A
- JP 10319600 A
- JP 11327152 A
- JP 2000010292 A
- JP 2000235254 A
- JP 2000352824 A
- JP 2001175001 A
- JP 2001209170 A
- US 3458311 A
- JP 55049729 A
- JP 57007427 B
- US 3375171 A
- US 3615480 A
- JP 50026601 A
- JP 58054341 A
- JP 56039464 B
- JP 56042860 B
- JP 2002202616 A

**Non-patent literature cited in the description**


- **MONROE et al.** *Chemical Revue,* 1993, vol. 93, 435
- **R.S. DAVIDSON.** *Journal of Photochemistry and Biology A: Chemistry,* 1993, vol. 73, 81
- **J.P. FAUSSIER.** Photoinitiated Polymerization - Theory and Applications, Rapra Review. *Report, Rapra Technology,* 1998, vol. 9
- **M. TSUNOOKA et al.** *Prog. Polym. Sci.,* 1996, vol. 21, 1
- *Dyes Pigm.,* 1994, vol. 24 (2), 93-8
- **GADJEV, N. ; DELIGEORGIEV, T. ; KANEV, I. ; TASSEVA, M. ; SABNIS, R.** *Dyes Pigm.,* 1991, vol. 17 (2), 153-62
- **BRUCE M. MONROE et al.** *Chemical Revue,* 1993, vol. 93, 435
- **F.D. SAEVA.** *Topics in Current Chemistry,* 1990, vol. 156, 59
- **GG MASLAK.** *Topics in Current Chemistry,* 1993, vol. 168, 1
- **H.B. SHUSTER et al.** *JACS,* 1990, vol. 112, 6329
- **I.D.F. EATON et al.** *JACS,* 1980, vol. 102, 3298
- *Polymer Preprints, Jpn.,* 1992, vol. 41 (3), 542
- **M.P. HUTT ; E.F. ELSLAGER ; L.M. MERBEL.** *Journal of Heterocyclic Chemistry,* 1970, vol. 7, 511

- *J. Pys. Chem.,* 1992, vol. 96, 207
- *J. Imaging Sci.,* 1986, vol. 30, 215
- *Polym. Adv. Technol.,* 1990, vol. 1, 287
- *J. Photopolym. Sci. Technol.,* 1990, vol. 3, 149
- *J. Am. Chem. Soc.,* 1990, vol. 112, 6329
- *J. Am. Chem. Soc.,* 1994, vol. 116, 4211
- **WAKABAYASHI et al.** *Bull. Chem. Soc. Japan,* 1969, vol. 42, 2924
- **F.C. SCHAEFER et al.** *J. Org. Chem.,* 1964, vol. 29, 1527
- *J. Am. Chem. Soc.,* 1986, vol. 108, 128
- *J. Imaging. Sci.,* 1986, vol. 30, 215
- *Israel. J. Chem.,* 1986, vol. 25, 264
- Conference of Photopolymer Science and Technology Ed. Photopolymer Handbook. Kogyo Chosakai Publishing Inc, 1989
- *Kobunshi,* 1996, vol. 45, 786
- *ACS. Symp. Ser.,* 1984, vol. 242, 11
- *Journal of the Adhesion Society of Japan,* 1984, vol. 20 (7), 300-308